# EUROPEAN PATENT APPLICATION

(11) **EP 4 709 116 A2**
(43) Date of publication of application: **11.03.2026**
(21) Application number: 26152740.2
(22) Date of filing: 31.08.2023
(51) Int. Cl.: H10K 59/131

(54) **DISPLAY DEVICE AND DISPLAY PANEL**

(30) Priority: 25.10.2022 KR 20220138474
(62) Divisional of application: 23194732.6
(71) Applicant: LG Display Co., Ltd., Seoul, 07336 (KR)
(72) Inventor: JANG, Hyunguk, 10845 Paju-si (KR); JUN, Sungwoo, 10845 Paju-si (KR)
(74) Representative: Cresswell, Ashley Frederick

(57) **Abstract**

The present disclosure provides a display device including: a first optical area included in a display area in which one or more images can be displayed and allowing light to be transmitted; a normal area included in the display area and located outside of the first optical area; a first optical bezel area included in the display area and located between the first optical area and the normal area; a first anode electrode of a first light emitting element disposed in the first optical area; a first pixel circuit disposed in the first optical bezel area; a first anode extension line electrically interconnecting the first anode electrode and the first pixel circuit; and at least one first compensation line connected in parallel with at least a portion of the first anode extension line.

## Description

### CROSS-REFERENCE TO RELATED APPLICATION

This application claims the priority benefit of Republic of Korea Patent Application No. 10-2022-0138474, filed on October 25, 2022 in the Korean Intellectual Property Office.

### BACKGROUND

### Technical Field

The present disclosure relates to electronic devices, and more particularly, to a display device and a display panel including one or more optical electronic devices not exposed on front surfaces thereof.

### Description of the Related Art

As display technology advances, display devices can provide increased functions, such as an image capture function, a sensing function, and the like, as well as an image display function. To provide these functions, a display device may need to include one or more optical electronic devices, such as a camera, a sensor for detecting an image, and the like.

In order to receive light transmitting through a front surface of a display device, it may be desirable for such an optical electronic device to be located in an area of the display device where incident light coming from the front surface can be increasingly received and detected. To achieve the foregoing, in a typical display device, an optical electronic device has been designed to be located in a front portion of the display device to allow a camera, a sensor, and/or the like as the optical electronic device to be increasingly exposed to incident light. In order to install an optical electronic device in a display device in this manner, a bezel area of the display device may be increased, or a notch or a hole may be needed to be formed in a display area of an associated display panel.

Therefore, as a display device needs an optical electronic device to receive or detect incident light, and perform an intended function, a size of the bezel in the front portion of the display device may be increased, or a substantial disadvantage may be encountered in designing the front portion of the display device.

In addition, in examples where a display device includes an optical electronic device, the quality of images may be unexpectedly decreased according to structures in which the optical electronic device is configured in the display device.

### SUMMARY

To address these issues, one or more embodiments of the present disclosure may provide a display panel and a display device that include a light transmission structure for enabling at least one optical electronic device to normally receive light (e.g., visible light, infrared light, ultraviolet light, or the like) while not being exposed in a front surface of the display device.

One or more embodiments of the present disclosure may provide a display panel and a display device that, in arranging light emitting elements and pixel circuits for driving the light emitting elements in an optical area, include an arrangement structure of capable of improving the transmittance of the optical area.

One or more embodiments of the present disclosure may provide a display panel and a display device that, in interconnecting between light emitting elements and pixel circuits for driving the light emitting elements in an optical area, include a connection structure of capable of improving the transmittance of the optical area.

One or more embodiments of the present disclosure may provide a display panel and a display device that are capable of compensating for a resistance difference between connection elements interconnecting pixel circuits and light emitting elements in order to improve image quality.

According to aspects of the present disclosure, a display device can be provided that includes: a first optical area included in a display area in which one or more images can be displayed and allowing light to be transmitted; a normal area included in the display area and located outside of the first optical area; a first optical bezel area included in the display area and located between the first optical area and the normal area; a first anode electrode of a first light emitting element disposed in the first optical area; a first pixel circuit disposed in the first optical bezel area; a first anode extension line electrically interconnecting the first anode electrode and the first pixel circuit; and at least one first compensation line connected in parallel with at least a portion of the first anode extension line.

One or more transistors may be disposed in the first optical bezel area, and a transistor may not be disposed in the first optical area.

At least a portion of the first anode extension line may be disposed in the first optical area, and the first anode extension line may include a first transparent line.

The first anode extension line may further include a second transparent line. The second transparent line may be located closer to the first anode electrode than the first transparent line.

The at least one first compensation line may include a metal line or may include a metal line and a semiconductor material line. The semiconductor material line may include a conductivity-enabled semiconductor material. For example, a semiconductor material may have conductivity through a conductive process such as an ion implantation process (also referred to as an impurity doping process). The semiconductor material having conductivity through the conduction process may be referred to as the semiconductor material having activated conductivity. The semiconductor material having activated conductivity may be differentiated from a normal metal conductive line in that it is made from a different material, e.g. a modified semiconductor material having undergone ion implantation as described herein.

The display device may further include a second anode electrode disposed in the first optical area, a second pixel circuit disposed in the first optical bezel area, and a second anode extension line electrically interconnecting the second anode electrode and the second pixel circuit.

The second anode extension line may have a shorter length than the first anode extension line.

The display device may further include at least one second compensation line connected in parallel with at least a portion of the second anode extension line. The at least one second compensation line may have a different resistance from the at least one first compensation line.

The display device may further include a third anode electrode disposed in the first optical bezel area, a third pixel circuit disposed in the first optical bezel area, and a third anode extension line electrically interconnecting the third anode electrode and the third pixel circuit. The third anode extension line may have a shorter length than the first anode extension line.

A compensation line may not be connected in parallel to the third anode extension line.

According to aspects of the present disclosure, a display panel can be provided that includes: a display area that includes an optical area allowing light to be transmitted and allows one or more images to be displayed; a first light emitting element disposed in the optical area (a first optical area or a second optical area different from the first optical area); a first pixel circuit disposed outside of the optical area; a first anode extension line electrically interconnecting the first light emitting element and the first pixel circuit; and at least one first compensation line connected with at least a portion of the first anode extension line.

In the display panel, a transistor may not be disposed in the optical area.

The at least a portion of the first anode extension line may be disposed in the first optical area, and the first anode extension line may include a first transparent line.

At least one first compensation line may include a metal line.

The at least one first compensation line may include a metal line and a semiconductor material line. The semiconductor material line may include a conductivity-enabled semiconductor material.

According to one or more embodiments of the present disclosure, a display panel and a display device may be provided that include a light transmission structure for enabling one or more optical electronic devices to normally receive light (e.g., visible light, infrared light, ultraviolet light, or the like) while not being exposed in a front surface of the display device.

According to one or more embodiments of the present disclosure, a display panel and a display device may be provided that include a structure of disposing light emitting elements in the optical area allowing light to be transmitted, but disposing pixel circuits for driving the light emitting elements of the optical area in an area outside of the optical area (e.g., an optical bezel area, a normal area), and thereby, are capable of increasingly improving transmittance of an optical area.

According to one or more embodiments of the present disclosure, a display panel and a display device may be provided that include a structure of interconnecting, using anode extension lines including a transparent material, light emitting elements disposed in an optical area allowing light to be transmitted and pixel circuits (e.g., transistors included in the pixel circuits) disposed in an area outside of the optical area (e.g., an optical bezel area, a normal area), and thereby, are capable of increasingly improving transmittance of an optical area.

According to one or more embodiments of the present disclosure, a display panel and a display device may be provided that include a structure of connecting a compensation line in parallel to an anode extension line having a large resistance, and thereby, are capable of reducing a difference in resistance between anode extension lines and improving quality of images.

According to one or more embodiments of the present disclosure, a display panel and a display device may be provided that include a cathode electrode with a plurality of cathode holes located in an optical area, and thereby, increasingly improve the transmittance of the optical area, and prevent an area or element adjacent to the cathode holes from being damaged or varied in the process of forming the cathode holes.

Additional features and aspects will be set forth in part in the description which follows and in part will become apparent from the description or may be learned by practice of the inventive concepts provided herein. Other features and aspects of the inventive concepts may be realized and attained by the structure particularly pointed out in, or derivable from, the written description, the claims hereof, and the appended drawings.

Other systems, methods, features and advantages will be, or will become, apparent to one with skill in the art upon examination of the following figures and detailed description. It is intended that all such additional systems, methods, features and advantages be included within this description, be within the scope of the present disclosure, and be protected by the appended claims. Nothing in this section should be taken as a limitation on those claims.
It is to be understood that both the foregoing general description and the following detailed description of the present disclosure are exemplary and explanatory and are intended to provide further explanation of the inventive concepts as claimed.

### BRIEF DESCRIPTION OF THE DRAWINGS

The accompanying drawings, which are included to provide a further understanding of the disclosure and are incorporated in and constitute a part of the disclosure, illustrate aspects of the disclosure and together with the description serve to explain principles of the disclosure. In the drawings:
FIGS. 1A, 1B, and 1C illustrate an example display device according to aspects of the present disclosure;
FIG. 2 illustrates an example system configuration of the display device according to aspects of the present disclosure;
FIG. 3 illustrates an example display panel according to aspects of the present disclosure;
FIG. 4 schematically illustrates an example first type of first optical area and an example normal area around the first type of first optical area in the display panel according to aspects of the present disclosure;
FIGS. 5 and 6 illustrate example light emitting elements and example pixel circuits for driving the light emitting elements, which are disposed in a normal area, a first optical bezel area, and a first optical area in the display panel according to aspects of the present disclosure;
FIG. 7 is an example plan view of the normal area, the first optical bezel area, and the first optical area included in the display panel according to aspects of the present disclosure;
FIGS. 8 and 9 are example cross-sectional views of the display panel according to aspects of the present disclosure, and more specifically, cross-sectional views of the first optical bezel area and the first optical area of the display panel;
FIG. 10 illustrates an example connection structure between light emitting elements and pixel circuits in the display panel according to aspects of the present disclosure;
FIG. 11 illustrates an example connection structure related to light emitting elements disposed in a first area of a first optical area of FIG. 10.
FIG. 12 illustrates an example connection structure related to light emitting elements disposed in a second area of the first optical area of FIG. 10.
FIG. 13 illustrates an example connection structure related to light emitting elements disposed in a third area of a first optical bezel area of FIG. 10.
FIG. 14 is an example diagram for explaining a resistance difference compensation structure for compensating for a difference in resistance between anode extension lines in the display panel according to aspects of the present disclosure;
FIG. 15 illustrates example resistance difference compensation structures for compensating for a difference in resistance between anode extension lines in the display panel according to aspects of the present disclosure;
FIG. 16 illustrates an example layer stack for a resistance difference compensation structure for compensating for a difference in resistance between anode extension lines in the display panel according to aspects of the present disclosure;
FIG. 17 is an example plan view for explaining a resistance difference compensation structure for compensating for a difference in resistance between anode extension lines in the display panel according to aspects of the present disclosure;
FIGS. 18A, 18B, 18C, and 18D are example cross-sectional views of the resistance difference compensation structure according to Case 1 of FIG. 15.
FIGS. 19A, 19B, 19C, and 19D are example other cross-sectional views of the resistance difference compensation structure according to Case 1 of FIG. 15.
FIGS. 20A and 20B are example cross-sectional views of the resistance difference compensation structure according to Case 2 of FIG. 15.
FIGS. 21A and 21B are example other cross-sectional views of the resistance difference compensation structure according to Case 2 of FIG. 15.
FIGS. 22A and 22B are example cross-sectional views of the resistance difference compensation structure according to Case 3 of FIG. 15.
FIGS. 23A and 23B are example other cross-sectional views of the resistance difference compensation structure according to Case 3 of FIG. 15.
FIG. 24 illustrates an example configuration in which various contact holes used in a resistance difference compensation structure for compensating for a difference in resistance between anode extension lines are overlapped in the display panel according to aspects of the present disclosure;
FIG. 25 schematically illustrates an example first type of second optical area and an example normal area around the first type of second optical area in the display panel according to aspects of the present disclosure;
FIG. 26 schematically illustrates an example second type of second optical area and an example normal area around the second type of second optical area in the display panel according to aspects of the present disclosure; and
FIG. 27 is an example plan view of the second type of second optical area in the display panel according to aspects of the present disclosure.

### DETAILED DESCRIPTION

Reference will now be made in detail to embodiments of the present disclosure, examples of which may be illustrated in the accompanying drawings. In the following description, structures, embodiments, implementations, methods and operations described herein are not limited to the specific example or examples set forth herein and may be changed as is known in the art, unless otherwise specified. Advantages and features of the present disclosure, and implementation methods thereof will be clarified through following example embodiments described with reference to the accompanying drawings. The present disclosure may, however, be embodied in different forms and should not be construed as limited to the example embodiments set forth herein. Rather, these example embodiments are provided so that this disclosure may be sufficiently thorough and complete to assist those skilled in the art to fully understand the scope of the present disclosure. Further, the protected scope of the present disclosure is defined by claims and their equivalents.

Shapes, sizes, ratios, angles, numbers, and the like, which are illustrated in the drawings to describe various example embodiments of the present disclosure are merely given by way of example. Therefore, the present disclosure is not limited to the illustrations in the drawings. Like reference numerals designate like elements throughout, unless otherwise specified. Names of the respective elements used in the following explanations are selected only for convenience of writing the specification and may thus be different from those used in actual products. In the following description, where the detailed description of the relevant known function or configuration may unnecessarily obscure aspects of the present disclosure, a detailed description of such known function or configuration may be omitted. Where the terms "comprise," "have," "include," "contain," "constitute," "make up of," "formed of," and the like are used, one or more other elements may be added unless the term, such as "only," is used. An element described in the singular form is intended to include a plurality of elements, and vice versa, unless the context clearly indicates otherwise.

In construing an element, the element is to be construed as including an error or tolerance range even where no explicit description of such an error or tolerance range is provided. Further, the term "may" fully encompasses all the meanings of the term "can."

Where positional relationships are described, for example, where the positional relationship between two parts is described using "on," "over," "under," "above," "below," "beside," "next," or the like, one or more other parts may be located between the two parts unless a more limiting term, such as "immediate(ly)," "direct(ly)," or "close(ly)" is used. For example, where an element or layer is disposed "on" another element or layer, a third element or layer may be interposed therebetween. Furthermore, the terms "left," "right," "top," "bottom, "downward," "upward," "upper," "lower," and the like refer to an arbitrary frame of reference.
For the expression that an element or layer "contacts," "overlaps," or the like with another element or layer, the element or layer can not only directly contact, overlap, or the like with another element or layer, but indirectly contact, overlap, or the like with another element or layer with one or more intervening elements or layers "disposed" or "interposed" between the elements or layers, unless otherwise specified.

Time relative terms, such as "after", "subsequent to", "next to", "before", or the like, used to describe a temporal relationship between events, operations, or the like are generally intended to include events, situations, cases, operations, or the like that do not occur consecutively unless the terms, such as "directly", "immediately", or the like, are used.
In describing a temporal relationship, when the temporal order is described as, for example, "after," "subsequent," "next," or "before," a case which is not continuous may be included unless a more limiting term, such as "just," "immediate(ly)," or "direct(ly)," is used.

Although the terms "first," "second," and the like may be used herein to describe various elements, these elements should not be interpreted to be limited by these terms. These terms are used only to distinguish one element from another. For example, a first element could be termed a second element, and, similarly, a second element could be termed a first element, without departing from the scope.

For the expression that an element or layer is "connected," "coupled," or "adhered" to another element or layer, the element or layer can not only be directly connected, coupled, or adhered to another element or layer, but also be indirectly connected, coupled, or adhered to another element or layer with one or more intervening elements or layers "disposed" or "interposed" between the elements or layers, unless otherwise specified.

Hereinafter, various example embodiments of the present disclosure will be described in detail with reference to the accompanying drawings. In addition, for convenience of description, a scale in which each of elements is illustrated in the accompanying drawings may differ from an actual scale. Thus, the illustrated elements are not limited to the specific scale in which they are illustrated in the drawings. In describing example embodiments of the present disclosure, equated or corresponding elements or configurations as embodiment previously described will not be repeatedly discussed. Discussions on example embodiments of the present disclosure are provided below.

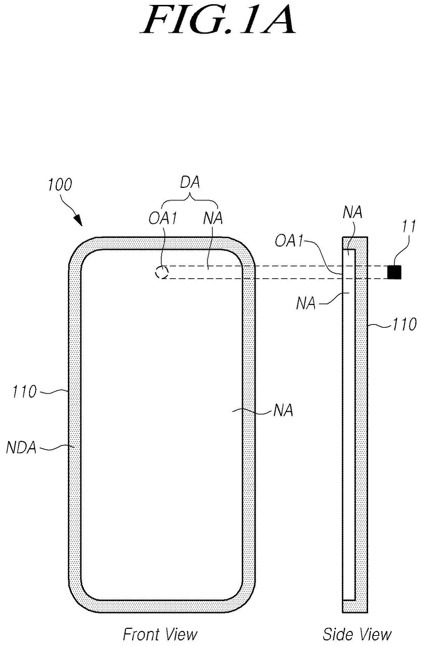

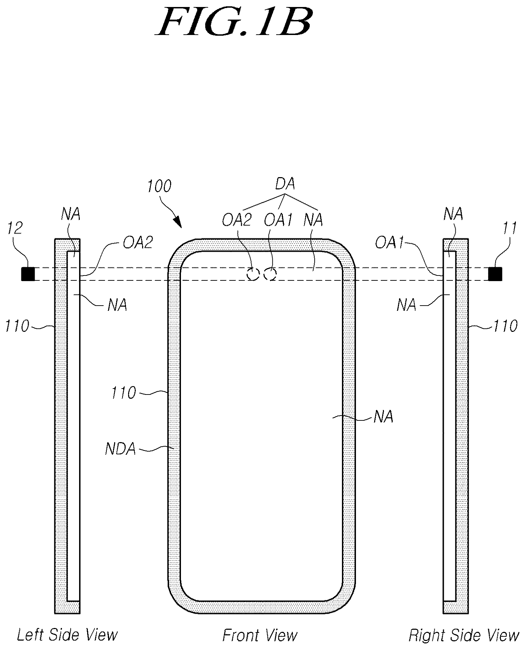

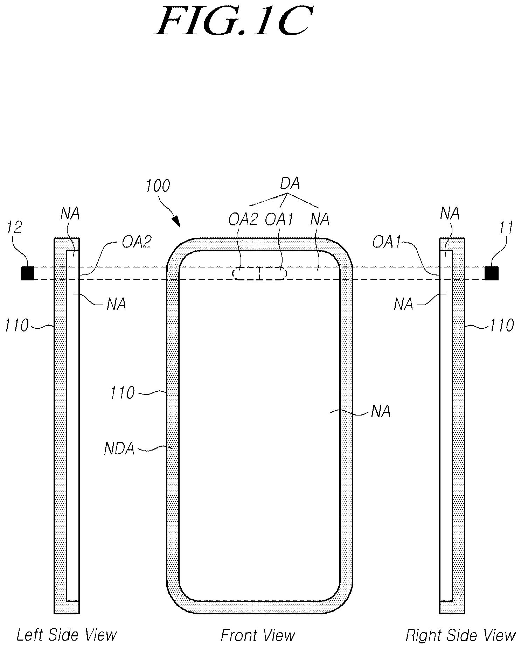

FIGS. 1A, 1B, and 1C illustrate an example display device according to aspects of the present disclosure.

Referring to FIGS. 1A, 1B, and 1C, in one or more embodiments, a display device 100 according to aspects of the present disclosure may include a display panel 110 for displaying one or more images, and one or more optical electronic devices (11 and/or 12). Herein, an optical electronic device may be referred to as a light detector, a light receiver, or a light sensing device. An optical electronic device may include one or more of a camera, a camera lens, a sensor, a sensor for detecting images, or the like.

The display panel 110 may include a display area DA in which one or more images can be displayed and a non-display area NDA in which an image is not displayed.

A plurality of subpixels may be arranged in the display area DA, and several types of signal lines for driving the plurality of subpixels may be arranged therein.

The non-display area NDA may refer to an area outside of the display area DA. Several types of signal lines may be arranged in the non-display area NDA, and several types of driving circuits may be connected thereto. At least a portion of the non-display area NDA may be bent to be invisible from the front surface of the display device 100 or may be covered by a case or housing (not shown) of the display device 100. The non-display area NDA may be also referred to as a bezel or a bezel area.

Referring to FIGS. 1A, 1B, and 1C, in one or more embodiments, in the display device 100 according to aspects of the present disclosure, one or more optical electronic devices (11 and/or 12) may be prepared independently of, and installed in, the display panel 110, and be located under, or in a lower portion of, the display panel 110 (an opposite side of a viewing surface thereof).

Light can enter the front surface (the viewing surface) of the display panel 110, pass through the display panel 110, reach one or more optical electronic devices (11 and/or 12) located under, or in the lower portion of, the display panel 110 (the opposite side of the viewing surface). Light transmitting through the display panel 110 may include, for example, visible light, infrared light, or ultraviolet light.

The one or more optical electronic devices (11 and/or 12) may be devices capable of receiving or detecting light transmitting through the display panel 110 and perform a predefined function based on the received light. For example, the one or more optical electronic devices (11 and/or 12) may include one or more of the following: an image capture device such as a camera (an image sensor), and/or the like; or a sensor such as a proximity sensor, an illuminance sensor, and/or the like. Such a sensor may be, for example, an infrared sensor capable of detecting infrared light.

Referring to FIGS. 1A, 1B, and 1C, in one or more embodiments, the display area DA of the display panel 110 according to aspects of the present disclosure may include one or more optical areas (OA1 and/or OA2) and a normal area NA. Herein, the term "normal area" NA is an area that while being present in the display area DA, does not overlap with one or more optical electronic devices (11 and/or 12) and may also be referred to as a non-optical area. The one or more optical areas (OA1 and/or OA2) may be one or more areas respectively overlapping the one or more optical electronic devices (11 and/or 12) in a cross-sectional view of the display panel 110.

According to an example of FIG. 1A, the display area DA may include a first optical area OA1 (also referred to herein as simply 'first area') and a normal area NA. In this example, at least a portion of the first optical area OA1 may overlap a first optical electronic device 11.

According to an example of FIG. 1B, the display area DA may include a first optical area OA1, a second optical area OA2 (also referred to herein as simply 'third area'), and a normal area NA. In this example, a portion of the normal area NA may be present between the first optical area OA1 and the second optical area OA2. At least a portion of the first optical area OA1 may overlap the first optical electronic device 11, and at least a portion of the second optical area OA2 may overlap a second optical electronic device 12.

According to an example of FIG. 1C, the display area DA may include a first optical area OA1, a second optical area OA2, and a normal area NA. In this example, the normal area NA may not be present between the first optical area OA1 and the second optical area OA2. For example, the first optical area OA1 and the second optical area OA2 may contact each other (e.g., directly contact each other). In this example, at least a portion of the first optical area OA1 may overlap the first optical electronic device 11, and at least a portion of the second optical area OA2 may overlap the second optical electronic device 12.

In the display panel 110 or the display device 100 according to aspects of the present disclosure, it may be desirable that both an image display structure and a light transmission structure are implemented in the one or more optical areas (OA1 and/or OA2). For example, since the one or more optical areas (OA1 and/or OA2) are portions of the display area DA, it may be therefore desirable that light emitting areas of subpixels for displaying one or more images are disposed in the one or more optical areas (OA1 and/or OA2). Further, to enable light to be transmitted through the one or more optical electronic devices (11 and/or 12), it may be desirable that a light transmission structure is implemented in the one or more optical areas (OA1 and/or OA2).

It should be noted that even though the one or more optical electronic devices (11 and/or 12) are devices that need to receive light, the one or more optical electronic devices (11 and/or 12) may be located on the back of the display panel 110 (e.g., on an opposite side of the viewing surface thereof), and thereby, can receive light that has passed through the display panel 110. For example, the one or more optical electronic devices (11 and/or 12) may not be exposed in the front surface (viewing surface) of the display panel 110 or the display device 100. Accordingly, when a user faces the front surface of the display device 110, the one or more optical electronic devices (11 and/or 12) are located so that they cannot be visible to the user.

The first optical electronic device 11 may be, for example, a camera, and the second optical electronic device 12 may be, for example, a sensor. The sensor may be a proximity sensor, an illuminance sensor, an infrared sensor, and/or the like. In one or more embodiments, the camera may be a camera lens, an image sensor, or a unit including at least one of the camera lens and the image sensor, and the sensor may be an infrared sensor capable of detecting infrared light. In another embodiment, the first optical electronic device 11 may be a sensor, and the second optical electronic device 12 may be a camera.

Hereinafter, for convenience of descriptions related to the optical electronic devices (11 and 12), the first optical electronic device 11 is considered to be a camera, and the second optical electronic device 12 is considered to be an infrared sensor. It should be, however, understood that the scope of the present disclosure includes examples where the first optical electronic device 11 is an infrared sensor, and the second optical electronic device 12 is a camera. The camera may be, for example, a camera lens, an image sensor, or a unit including at least one of the camera lens and the image sensor.

In an example where the first optical electronic device 11 is a camera, this camera may be located on the back of (e.g., under, or in a lower portion of) the display panel 110, and be a front camera capable of capturing objects or images in a front direction of the display panel 110. Accordingly, the user can capture an image or object through the camera that is invisible on the viewing surface while looking at the viewing surface of the display panel 110.

Although the normal area NA and the one or more optical areas (OA1 and/or OA2) included in the display area DA in each of FIGS. 1A, 1B, and 1C are areas where images are allowed to be displayed, the normal area NA is an area where a light transmission structure need not be implemented, but the one or more optical areas (OA1 and/or OA2) are areas where a light transmission structure need be implemented. Thus, in one or more embodiments, the normal area NA is an area where a light transmission structure is not implemented or included, and the one or more optical areas (OA1 and/or OA2) are areas in which a light transmission structure is implemented or included.

Accordingly, the one or more optical areas (OA1 and/or OA2) can have a transmittance (total or per unit area) greater than or equal to a predetermined level, i.e., a relatively high transmittance, and the normal area NA can have a transmittance (total or per unit area) less than the predetermined level or not have light transmittance.

For example, the one or more optical areas (OA1 and/or OA2) may have a resolution, a subpixel arrangement structure, a number of subpixels per unit area, an electrode structure, a line structure, an electrode arrangement structure, a line arrangement structure, and/or the like different from that/those of the normal area NA.

In one embodiment, the number of subpixels per unit area in the one or more optical areas (OA1 and/or OA2) may be less than the number of subpixels per unit area in the normal area NA. For example, the resolution of the one or more optical areas (OA1 and/or OA2) may be lower than that of the normal area NA. In this example, the number of subpixels per unit area may have the same meaning as a resolution, a pixel density, or a degree of integration of pixels. For example, the unit of the number of subpixels per unit area may be pixels per inch (PPI), which represents the number of pixels within 1 inch.

In the examples of FIGS. 1A, 1B, and 1C, the number of subpixels per unit area in the first optical areas OA1 may be less than the number of subpixels per unit area in the normal area NA. In the examples of FIGS. 1B and 1C, the number of subpixels per unit area in the second optical areas OA2 may be greater than or equal to the number of subpixels per unit area in the first optical areas OA1, and be less than the number of subpixels per unit area in the normal area NA.

In one or more embodiments, as a method for increasing respective transmittance of at least one of the first optical area OA1 and the second optical area OA2, a pixel density differentiation design scheme as described above may be applied in which a difference in densities of pixels (or subpixels) or in degrees of integration of pixels (or subpixels) between the first optical area OA1, the second optical area OA2, and the normal area NA can be produced. According to the pixel density differentiation design scheme, in an embodiment, the display panel 110 may be configured or designed such that the number of subpixels per unit area of at least one of the first optical area OA1 and the second optical area OA2 is smaller than the number of subpixels per unit area of the normal area NA.

In one or more embodiments, as another method for increasing respective transmittance of at least one of the first optical area OA1 and the second optical area OA2, a pixel size differentiation design scheme may be applied in which a difference in sizes of pixels (or subpixels) between the first optical area OA1, the second optical area OA2, and the normal area NA can be produced. According to the pixel size differentiation design scheme, the display panel PNL may be configured or designed such that while the number of subpixels per unit area of at least one of the first optical area OA1 and the second optical area OA2 is equal to or similar to the number of subpixels per unit area of the normal area NA, a size of each subpixel (i.e., a size of a corresponding light emitting area) disposed in at least one of the first optical area OA1 and the second optical area OA2 is smaller than a size of each subpixel (i.e., a size of a corresponding light emitting area) disposed in the normal area NA.

In one or more aspects, for convenience of description, discussions that follow are provided based on the pixel density differentiation design scheme of the two schemes (i.e., the pixel density differentiation design scheme and the pixel size differentiation design scheme) for increasing respective transmittance of at least one of the first optical area OA1 and the second optical area OA2, unless explicitly stated otherwise. It should be therefore understood that in descriptions that follow, a small number of subpixels per unit area may be considered as corresponding to a small size of subpixel, and a large number of subpixels per unit area may be considered as corresponding to a large size of subpixel.

In the examples of FIGS. 1A, 1B, and 1C, the first optical area OA1 may have various shapes, such as a circle, an ellipse, a quadrangle, a hexagon, an octagon or the like. In the examples of FIGS. 1B and 1C, the second optical area OA2 may have various shapes, such as a circle, an ellipse, a quadrangle, a hexagon, an octagon or the like. The first optical area OA1 and the second optical area OA2 may have the same or substantially or nearly the same shape, or different shapes.

Referring to FIG. 1C, in the example where the first optical area OA1 and the second optical area OA2 contact each other (e.g., directly contact each other), the entire optical area including the first optical area OA1 and the second optical area OA2 may also have various shapes, such as a circle, an ellipse, a quadrangle, a hexagon, an octagon or the like. Hereinafter, for convenience of descriptions related to shapes of the optical areas (OA1 and OA2), each of the first optical area OA1 and the second optical area OA2 is considered to have a circular shape. It should be, however, understood that the scope of the present disclosure includes examples where at least one of the first optical area OA1 and the second optical area OA2 have a shape other than a circular shape.

According to one or more aspects of the present disclosure, when the display device 100 has a structure in which the first optical electronic device 11 such as a camera, and the like is located under, or in a lower portion of, the display panel 100 without being exposed to the outside, such a display device may be referred to as a display to which an under-display camera (UDC) technology is applied.

The display device 100 to which such an under-display camera (UDC) technology is applied can provide an advantage of preventing a reduction of an area or size of the display area DA because a notch or a camera hole for exposing a camera need not be formed in the display panel 110. Indeed, since a notch or a camera hole for camera exposure need not be formed in the display panel 110, the display device 100 can provide further advantages of reducing the size of a bezel area, and improving the degree of freedom in design because such limitations to the design are removed.

Although the one or more optical electronic devices (11 and/or 12) are located on the back of (e.g., under, or in a lower portion of) the display panel 110 of the display device 100 (e.g., hidden or not exposed to the outside), the one or more optical electronic devices (11 and/or 12) are required to perform their normal predefined functionalities by receiving or detecting light.

Further, although one or more optical electronic devices (11 and/or 12) are located on the back of (e.g., under, or in a lower portion of) the display panel 110 to be hidden and located to be overlap the display area DA, it is desirable that the display device 100 is configured to normally display one or more images in the one or more optical areas (OA1 and/or OA2) overlapping the one or more optical electronic devices (11 and/or 12) in the display area DA. Thus, even though one or more optical electronic devices (11 and/or 12) are located on the back of the display panel, the display device 100 according to aspects of the present disclosure can be configured to display images in a normal manner (e.g., without reduction in image quality) in the one or more optical areas (OA1 and/or OA2) overlapping the one or more optical electronic devices (11 and/or 12) in the display area DA.

Since the foregoing first optical area OA1 is configured or designed as a transmittable area, the quality of image display in the first optical area OA1 may be different from the quality of image display in the normal area NA.

Further, when designing the first optical area OA1 for the purpose of improving the quality of image display, there may be caused a situation that the transmittance of the first optical area OA1 is reduced.

To address these issues, as described below, one or more embodiments may provide a structure of the first optical area OA1 that is capable of preventing the occurrence of a difference (e.g., non-uniformity) in image quality between the first optical area OA1 and the normal area NA, and improving the transmittance of the first optical area OA1.

Further, one or more embodiments may provide not only the structure of the first optical area OA1, but a structure of the second optical area OA2 that is capable of improving the image quality of the second optical area OA2, and improving the transmittance of the second optical area OA2.

It should be also noted that the first optical area OA1 and the second optical area OA2 included in the display device 100 or the display panel 110 according to aspects of the present disclosure may be differently implemented or have different utilization examples while having a similarity in terms of light transmittable areas. Taking account of such a distinction, the structure of the first optical area OA1 and the structure of the second optical area OA2 in the display device 100 according to aspects of the present disclosure may be configured or designed differently from each other.

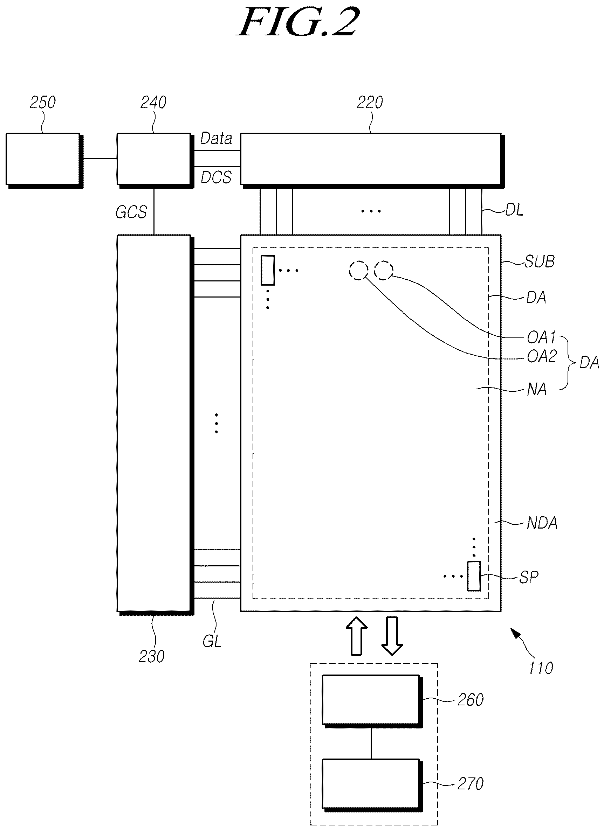

FIG. 2 illustrates an example system configuration of the display device 100 according to aspects of the present disclosure.

Referring to FIG. 2, the display device 100 may include the display panel 110 and a display driving circuit as components for displaying one or more images.

The display driving circuit may be a circuit for driving the display panel 110, and include a data driving circuit 220, a gate driving circuit 230, a display controller 240, and other circuit components.

The display panel 110 may include a display area DA in which one or more images can be displayed and a non-display area NDA in which an image is not displayed. The non-display area NDA may be an area outside of the display area DA, and may also be referred to as an edge area or a bezel area. All or a portion of the non-display area NDA may be an area visible from the front surface of the display device 100, or an area that is bent and invisible from the front surface of the display device 100.

The display panel 110 may include a substrate SUB and a plurality of subpixels SP disposed on the substrate SUB. The display panel 110 may further include various types of signal lines to drive the plurality of subpixels SP.

In one or more embodiments, the display device 100 according to aspects of the present disclosure may be a liquid crystal display device, or the like, or a self-emission display device in which light is emitted from the display panel 110 itself. In the example where the display device 100 according to aspects of the present disclosure is implemented as a self-emission display device, each of the plurality of subpixels SP may include a light emitting element. For example, the display device 100 according to aspects of the present disclosure may be an organic light emitting display device implemented with one or more organic light emitting diodes (OLED). In another example, the display device 100 according to aspects of the present disclosure may be an inorganic light emitting display device implemented with one or more inorganic material-based light emitting diodes. In further another example, the display device 100 according to aspects of the present disclosure may be a quantum dot display device implemented with quantum dots, which are self-emission semiconductor crystals.

The structure of each of the plurality of subpixels SP may be differently configured or designed according to types of the display devices 100. For example, in an example where the display device 100 is a self-emission display device including self-emission subpixels SP, each subpixel SP may include a self-emission light emitting element, one or more transistors, and one or more capacitors.

In one or more embodiments, various types of signal lines arranged in the display device 100 may include, for example, a plurality of data lines DL for carrying data signals (which may be referred to as data voltages or image signals), a plurality of gate lines GL for carrying gate signals (which may be referred to as scan signals), and the like.

The plurality of data lines DL and the plurality of gate lines GL may intersect each other. Each of the plurality of data lines DL may extend in a first direction. Each of the plurality of gate lines GL may extend in a second direction different from the first direction. For example, the first direction may be a column or vertical direction, and the second direction may be a row or horizontal direction. In another example, the first direction may be the row or horizontal direction, and the second direction may be the column or vertical direction.

The data driving circuit 220 may be a circuit for driving the plurality of data lines DL, and can supply data signals to the plurality of data lines DL. The gate driving circuit 230 may be a circuit for driving the plurality of gate lines GL, and can supply gate signals to the plurality of gate lines GL.

The display controller 240 may be a device for controlling the data driving circuit 220 and the gate driving circuit 230, and can control driving times for the plurality of data lines DL and driving times for the plurality of gate lines GL.

The display controller 240 can supply a data driving control signal DCS to the data driving circuit 220 to control the data driving circuit 220, and supply a gate driving control signal GCS to the gate driving circuit 230 to control the gate driving circuit 230.

The display controller 240 can receive input image data from a host system 250 and supply image data Data to the data driving circuit 220 based on the input image data.

The data driving circuit 220 can receive digital image data Data from the display controller 240, convert the received image data Data into analog data signals, and supply the resulting analog data signals to the plurality of data lines DL.

The gate driving circuit 230 can receive a first gate voltage corresponding to a turn-on level voltage and a second gate voltage corresponding to a turn-off level voltage along with various gate driving control signals GCS, generate gate signals, and supply the generated gate signals to the plurality of gate lines GL.

In one or more embodiments, the data driving circuit 220 may be connected to the display panel 110 in a tape automated bonding (TAB) type, or connected to a conductive pad such as a bonding pad of the display panel 110 in a chip on glass (COG) type or a chip on panel (COP) type, or connected to the display panel 110 in a chip on film (COF) type.

In one or more embodiments, the gate driving circuit 230 may be connected to the display panel 110 in the tape automated bonding (TAB) type, or connected to a conductive pad such as a bonding pad of the display panel 110 in the chip on glass (COG) type or the chip on panel (COP) type, or connected to the display panel 110 in the chip on film (COF) type. In another embodiment, the gate driving circuit 230 may be disposed in the non-display area NDA of the display panel 110 in a gate in panel (GIP) type. The gate driving circuit 230 may be disposed on the substrate, or connected to the substrate. That is, in the case of the GIP type, the gate driving circuit 230 may be disposed in the non-display area NDA of the substrate. In the case of the chip on glass (COG) type, the chip on film (COF) type, or the like, the gate driving circuit 230 may be connected to the substrate.

In one or more embodiments, at least one of the data driving circuit 220 and the gate driving circuit 230 may be disposed in the display area DA of the display panel 110. For example, at least one of the data driving circuit 220 and the gate driving circuit 230 may be disposed such that it does not overlap subpixels SP, or disposed such that it overlaps one or more, or all, of the subpixels SP, or at least respective one or more portions of one or more subpixels.

The data driving circuit 220 may be located in, and/or electrically connected to, but not limited to, only one side or portion (e.g., an upper edge or a lower edge) of the display panel 110. In one or more embodiments, the data driving circuit 220 may be located in, and/or electrically connected to, but not limited to, two sides or portions (e.g., an upper edge and a lower edge) of the display panel 110 or at least two of four sides or portions (e.g., the upper edge, the lower edge, a left edge, and a right edge) of the display panel 110 according to driving schemes, panel design schemes, or the like.

The gate driving circuit 230 may be located in, and/or electrically connected to, but not limited to, only one side or portion (e.g., a left edge or a right edge) of the display panel 110. In one or more embodiments, the gate driving circuit 230 may be located in, and/or electrically connected to, but not limited to, two sides or portions (e.g., a left edge and a right edge) of the panel 110 or at least two of four sides or portions (e.g., an upper edge, a lower edge, the left edge, and the right edge) of the panel 110 according to driving schemes, panel design schemes, or the like.

The display controller 240 may be implemented in a separate component from the data driving circuit 220, or incorporated in the data driving circuit 220 and thus implemented in an integrated circuit.

The display controller 240 may be a timing controller used in the typical display technology or a controller or a control device capable of performing other control functions in addition to the function of the typical timing controller. In one or more embodiments, the display controller 140 may be a controller or a control device different from the timing controller, or a circuitry or a component included in the controller or the control device. The display controller 240 may be implemented with various circuits or electronic components such as an integrated circuit (IC), a field programmable gate array (FPGA), an application specific integrated circuit (ASIC), a processor, and/or the like.

The display controller 240 may be mounted on a printed circuit board, a flexible printed circuit, and/or the like and be electrically connected to the gate driving circuit 220 and the data driving circuit 230 through the printed circuit board, flexible printed circuit, and/or the like.

The display controller 240 may transmit signals to, and receive signals from, the data driving circuit 220 via one or more predefined interfaces. For example, such interfaces may include a low voltage differential signaling (LVDS) interface, an embedded clock point-point interface (EPI), a serial peripheral interface (SPI), and the like.

In one or more embodiments, in order to further provide a touch sensing function, as well as an image display function, the display device 100 according to aspects of the present disclosure may include at least one touch sensor, and a touch sensing circuit capable of detecting the occurrence of a touch event by a touch object such as a finger, a pen, or the like, or of detecting a corresponding touch position (or touch coordinates), by sensing the touch sensor.

The touch sensing circuit may include: a touch driving circuit 260 capable of generating and providing touch sensing data by driving and sensing the touch sensor; a touch controller 270 capable of detecting the occurrence of a touch event or detecting a touch position (or touch coordinates) using the touch sensing data; and one or more other components.

The touch sensor may include a plurality of touch electrodes. The touch sensor may further include a plurality of touch lines for electrically connecting the plurality of touch electrodes to the touch driving circuit 260.

The touch sensor may be implemented in the form of a touch panel outside of the display panel 110 or be integrated inside of the display panel 110. In the example where the touch sensor is implemented in the form of the touch panel outside of the display panel 110, such a touch sensor may be referred to as an add-on type. In the example where the add-on type of touch sensor is disposed in the display device 100, the touch panel and the display panel 110 may be separately manufactured and combined in an assembly process. The add-on type of touch panel may include a touch panel substrate and a plurality of touch electrodes on the touch panel substrate.

In the example where the touch sensor is integrated inside of the display panel 110, the touch sensor may be formed on the substrate SUB together with signal lines and electrodes related to display driving during a process of manufacturing the display panel 110.

The touch driving circuit 260 can supply a touch driving signal to at least one of a plurality of touch electrodes, and sense at least one of the plurality of touch electrodes to generate touch sensing data.

The touch sensing circuit can perform touch sensing using a self-capacitance sensing technique or a mutual-capacitance sensing technique.

In the example where the touch sensing circuit performs touch sensing using the self-capacitance sensing technique, the touch sensing circuit can perform touch sensing based on capacitance between each touch electrode and a touch object (e.g., a finger, a pen, and the like). According to the self-capacitance sensing technique, each of the plurality of touch electrodes can serve as both a driving touch electrode and a sensing touch electrode. The touch driving circuit 260 can drive all, or one or more, of the plurality of touch electrodes and sense all, or one or more, of the plurality of touch electrodes.

In the example where the touch sensing circuit performs touch sensing using the mutual-capacitance sensing technique, the touch sensing circuit can perform touch sensing based on capacitance between touch electrodes. According to the mutual-capacitance sensing technique, the plurality of touch electrodes are divided into driving touch electrodes and sensing touch electrodes. The touch driving circuit 260 can drive the driving touch electrodes and sense the sensing touch electrodes.

The touch driving circuit 260 and the touch controller 270 included in the touch sensing circuit may be implemented in separate devices or in a single device. Further, the touch driving circuit 260 and the data driving circuit 220 may be implemented in separate devices or in a single device.

The display device 100 may further include a power supply circuit for supplying various types of power to the display driving circuit and/or the touch sensing circuit.

In one or more embodiments, the display device 100 according to aspects of the present disclosure may represent, but not limited to, a mobile terminal, such as a smart phone, a tablet, or the like, a monitor, a television (TV), or the like. Embodiments of the present disclosure are not limited thereto. In one or more embodiments, the display device 100 may be display devices, or include displays, of various types, sizes, and shapes for displaying information or images.

As described above, the display area DA of the display panel 110 may include the normal area NA and the one or more optical areas (OA1 and/or OA2) as illustrated in FIGS. 1A, 1B, and 1C. The normal area NA and the one or more optical areas (OA1 and/or OA2) may be areas where images can be displayed. It should be noted here that the normal NA may be an area in which a light transmission structure need not be implemented, and the one or more optical areas (OA1 and/or OA2) may be areas in which a light transmission structure need be implemented.

As discussed above with respect to the examples of FIGS. 1A, 1B, and 1C, even though the display area DA of the display panel 110 may include the one or more optical areas (OA1 and/or OA2) together with the normal area NA, for convenience of description, discussions that follow will be provided based on examples where the display area DA includes both the first and second optical areas OA1 and OA2 (i.e., the first optical area OA1 of FIGS. 1A, 1B, and 1C, and the second optical area OA2 of FIGS. 1B and 1C) and the normal area NA (i.e., the normal area NA of FIGS. 1A, 1B, and 1C).

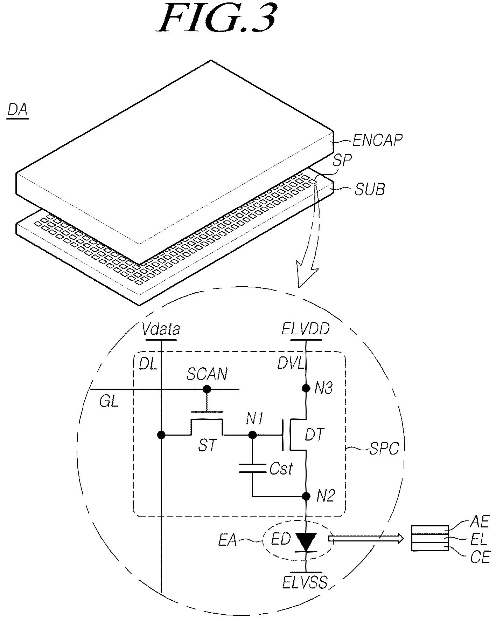

FIG. 3 illustrates an example configuration of the display panel 110 according to aspects of the present disclosure.

Referring to FIG. 3, a plurality of subpixels SP may be disposed in the display area DA of the display panel 110. The plurality of subpixels SP may be disposed in a normal area (e.g., the normal area of FIGS. 1A, 1B, and 1C), a first optical area (e.g., the first optical area OA1 of FIGS. 1A, 1B, and 1C), and a second optical area (e.g., the second optical area OA2 of FIGS. 1B and 1C) included in the display area DA of the display panel 110.

Referring to FIG. 3, each of the plurality of subpixels SP may include a light emitting element ED and a pixel circuit SPC configured to drive the light emitting element ED.

Referring to FIG. 3, the pixel circuit SPC may include a driving transistor DT for driving the light emitting element ED, a scan transistor ST for transferring a data voltage Vdata to a first node N1 of the driving transistor DT, a storage capacitor Cst for maintaining a voltage at an approximate constant level during one frame, and the like.

The driving transistor DT may include the first node N1 to which a data voltage is applied, a second node N2 electrically connected to the light emitting element ED, and a third node N3 to which a driving voltage ELVDD through a driving voltage line DVL is applied. In the driving transistor DT, the first node N1 may be a gate node, the second node N2 may be a source node or a drain node, and the third node N3 may be the drain node or the source node. For convenience of description, descriptions that follow will be provided based on examples where the first, second and third nodes (N1, N2 and N3) of the driving transistor DT are gate, source and drain nodes, respectively, unless explicitly stated otherwise. However, it should be understood that the scope of the present disclosure includes examples where the first, second and third nodes (N1, N2 and N3) of the driving transistor DT are gate, drain and source nodes, respectively.

The light emitting element ED may include an anode electrode AE, an emission layer EL, and a cathode electrode CE. The anode electrode AE may represent a pixel electrode disposed in each subpixel SP, and may be electrically connected to the second node N2 of the driving transistor DT of each subpixel SP. The cathode electrode CE may represent a common electrode being disposed in the plurality of subpixels SP in common, and a base voltage ELVSS such as a low-level voltage, a ground voltage, or the like may be applied to the cathode electrode CE.

For example, the anode electrode AE may be a pixel electrode, and the cathode electrode CE may be a common electrode. In another example, the anode electrode AE may be a common electrode, and the cathode electrode CE may be a pixel electrode. For convenience of description, discussions that follow will be provided based on examples where the anode electrode AE is a pixel electrode, and the cathode electrode CE is a common electrode unless explicitly stated otherwise. However, it should be understood that the scope of the present disclosure includes examples where the anode electrode AE is a common electrode, and the cathode electrode CE is a pixel electrode.

The light emitting element ED may include a light emitting area EA having a predetermined size or area. The light emitting area EA of the light emitting element ED may be defined as, for example, an area in which the anode electrode AE, the emission layer EL, and the cathode electrode CE overlap one another.

The light emitting element ED may be, for example, an organic light emitting diode (OLED), an inorganic light emitting diode, a quantum dot light emitting element, or the like. In the example where an organic light emitting diode (OLED) is used as the light emitting element ED, the emission layer EL thereof may include an organic emission layer including an organic material.

The scan transistor ST can be turned on and off by a scan signal SCAN, which is a gate signal applied through a gate line GL, and be electrically connected between the first node N1 of the driving transistor DT and a data line DL.

The storage capacitor Cst may be electrically connected between the first node N1 and the second node N2 of the driving transistor DT.

The pixel circuit SPC may be configured with two transistors (2T: DRT and SCT) and one capacitor (1C: Cst) (which may be referred to as a "2T1C structure") as shown in FIG. 3, and in one or more implementations, may further include one or more transistors, and/or further include one or more capacitors.

In one or more embodiments, the storage capacitor Cst, which may be present between the first node N1 and the second node N2 of the driving transistor DT, may be an external capacitor intentionally configured or designed to be located outside of the driving transistor DT, other than internal capacitors, such as parasitic capacitors (e.g., a gate-to-source capacitance Cgs, a gate-to-drain capacitance Cgd, and the like). Each of the driving transistor DT and the scan transistor ST may be an n-type transistor or a p-type transistor.

Since circuit elements (in particular, a light emitting element ED implemented with an organic light emitting diode including an organic material) included in each subpixel SP are vulnerable to external moisture or oxygen, an encapsulation layer ENCAP may be disposed in the display panel 110 in order to prevent external moisture or oxygen from penetrating into such circuit elements. The encapsulation layer ENCAP may be disposed such that it covers the light emitting element ED.

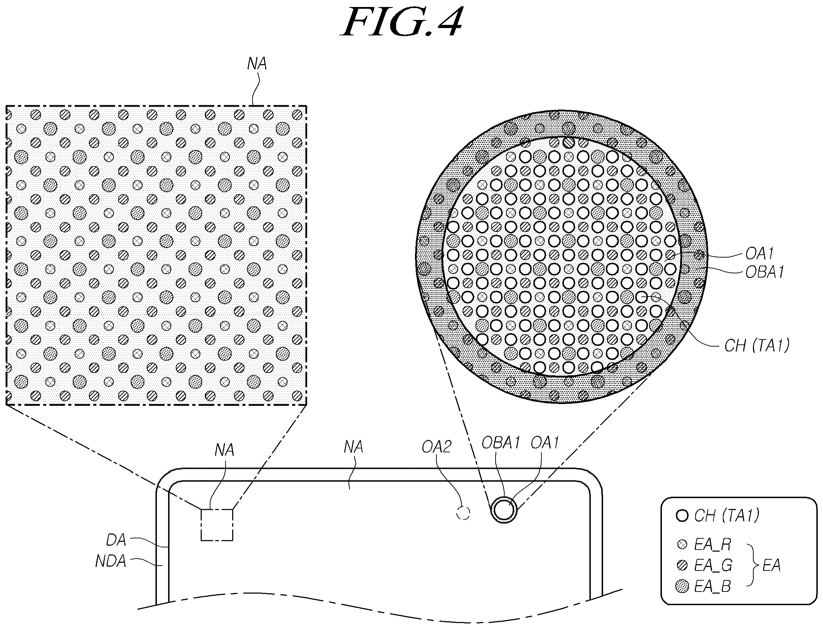

FIG. 4 schematically illustrates an example first type of second optical area OA1 and an example normal area NAaround the first type of second optical area OA1 in the display panel 110 according to aspects of the present disclosure.

Referring to FIG. 4, in one or more embodiments, the display panel 110 according to aspects of the present disclosure may include a display area (e.g., the display area DA of figures described above) where one or more images can be displayed and a non-display area (e.g., the non-display area NDA of figures described above) where an image is not displayed.

Referring to FIG. 4, the display area DA may include a first optical area OA1 through which light can be transmitted, and a normal area NA around the optical area OA1.

The first optical area OA1 may have the structure of a first type. Thus, in an example where the optical area OA1 is implemented in the first type, a first optical bezel area OBA1 (also referred to herein as simply 'second area') may be disposed outside of the first optical area OA1. In one or more embodiments, the first optical bezel area OBA1 may represent a part of the normal area NA.

In other words, when the first optical area OA1 is implemented in the first type, the display area DA may include the first optical area OA1, the normal area NA located outside of the first optical area OA1, and the first optical bezel area OBA1 between the first optical area OA1 and the normal area NA.

Referring to FIG. 4, the first optical area OA1 may represent an area overlapping the first optical electronic device 11, and may be, for example, a transmittable area through which light needed for the operation of the first optical electronic device 11 can be transmitted.

In this example, light transmitting the first optical area OA1 may include light of a single wavelength band or light of various wavelength bands. For example, the first optical area OA1 may be configured to allow, but not limited to, at least one of visible light, infrared light, ultraviolet light, and the like to transmit.

The first optical electronic device 11 can receive light transmitting through the first optical area OA1 and perform a predefined operation by using the received light. The light received by the first optical electronic device 11 through the first optical area OA1 may include at least one of visible light, infrared light, and ultraviolet light.

In an embodiment when the first optical electronic device 11 is a camera, the first optical area OA1 may be at least configured to allow visible light to transmit for the operation of the camera. In another embodiment when the first optical electronic device 11 is an infrared sensor, the first optical area OA1 may be at least configured to allow infrared light to transmit for the operation of the infrared sensor.

Referring to FIG. 4, the first optical bezel area OBA1 may represent an area located outside of the first optical area OA1. The normal area NA may represent an area located outside of the first optical bezel area OBA1. The first optical bezel area OBA1 may be disposed between the first optical area OA1 and the normal area NA.

For example, the first optical bezel area OBA1 may be disposed outside of only a portion of an edge of the first optical area OA1, or disposed outside of the entire edge of the first optical area OA1.

In the example where the first optical bezel area OBA1 is disposed outside of the entire edge of the first optical area OA1, the first optical bezel area OBA1 may have a ring shape surrounding the first optical area OA1.

For example, the first optical area OA1 may have various shapes such as a circular shape, an elliptical shape, a polygonal shape, an irregular shape, or the like. The first optical bezel area OBA1 may have various ring shapes (e.g., a circular ring shape, an elliptical ring shape, a polygonal ring shape, an irregular ring shape, or the like) surrounding the first optical area OA1 having various shapes.

Referring to FIG. 4, the display area DA may include a plurality of light emitting areas EA. As the first optical area OA1, the first optical bezel area OBA1, and the normal area NA are areas included in the display area DA, each of the first optical area OA1, the first optical bezel area OBA1, and the normal area NA may include a plurality of light emitting areas EA.

For example, the plurality of light emitting areas EA may include a first color light emitting area emitting light of a first color, a second color light emitting area emitting light of a second color, and a third color light emitting area emitting light of a third color.

At least one of the first color light emitting area, the second color light emitting area, and the third color light emitting area may have a different area or size from the remaining one or more light emitting areas.

The first color, the second color, and the third color may be different colors from one another, and may be various colors. For example, the first color, second color, and third color may be or include red, green, and blue, respectively.

Hereinafter, for convenience of description, the first color, the second color, and the third color are considered to be red, green, and blue, respectively. However, embodiments of the present disclosure are not limited thereto.

In the example where the first color, the second color, and the third color are red, green, and blue, respectively, an area of a blue light emitting area EA_B may be greater than an area of a red light emitting area EA_R and an area of a green light emitting area EA_G.

A light emitting element ED disposed in the red light emitting area EA_R may include an emission layer EL emitting red light. A light emitting element ED disposed in the green light emitting area EA_G may include an emission layer EL emitting green light. A light emitting element ED disposed in the blue light emitting area EA_B may include an emission layer EL emitting blue light.

An organic material included in the emission layer EL emitting blue light may be more easily degraded in terms of material than respective organic materials included in the emission layer EL emitting red light and the emission layer EL emitting green light.

In one or more embodiments, as the blue light emitting area EA_B is configured or designed to have the largest area or size, current density supplied to the light emitting element ED disposed in the blue light emitting area EA_B may be the least. Therefore, a degradation degree of a light emitting element ED disposed in the blue light emitting area EA_B may be similar to a degradation degree of a light emitting element ED disposed in the red light emitting area EA_R and a degradation degree of a light emitting element ED disposed in the green light emitting area EA_G.

In consequence, a difference in degradation between the light emitting element ED disposed in the red light emitting area EA_R, the light emitting elements ED disposed in the green light emitting area EA_G, and the light emitting elements ED disposed in the blue light emitting area EA_B cannot be produced or can be reduced, and therefore, the display device 100 or the display panel 110 according to aspects of the present disclosure can provide an advantage of improving image quality. In addition, as a difference in degradation between the light emitting element ED disposed in the red light emitting area EA_R, the light emitting elements ED disposed in the green light emitting area EA_G, and the light emitting elements ED disposed in the blue light emitting area EA_B is eliminated or reduced, the display device 100 or the display panel 110 according to aspects of the present disclosure can therefore provide an advantage of reducing a difference in lifespan between the light emitting element ED disposed in the red light emitting area EA_R, the light emitting elements ED disposed in the green light emitting area EA_G, and the light emitting elements ED disposed in the blue light emitting area EA_B.

Referring to FIG. 4, the first optical area OA1 may be a transmittable area, and therefore, be desirable to have high transmittance. To achieve this requirement, in one or more embodiments, a cathode electrode CE disposed in the first optical area OA1, or a portion corresponding the first optical area OA1 of a cathode electrode CE disposed across the first optical area OA1, the normal area NA and/or the first optical bezel area OBA1 may include a plurality of cathode holes CH. In one or more embodiments, a portion corresponding the first optical area OA1 of the cathode electrode CE disposed across the first optical area OA1 and the normal area NA or a cathode electrode CE disposed in the first optical area OA1 may include a plurality of cathode holes CH. The cathode holes are positioned in areas other than (e.g. between) the emission areas of subpixels.

Referring to FIG. 4, in one or more embodiments, the cathode electrode CE may not include a cathode hole CH in the normal area NA. That is, in the normal area NA, the cathode electrode CE may not include a cathode hole CH.

In one or more embodiments, a cathode electrode CE disposed in the first optical bezel area OBA1, or a portion corresponding the first optical bezel area OBA1 of the cathode electrode CE disposed across the first optical area OA1, the normal area NA and/or the first optical bezel area OBA1 may not include a cathode hole CH. That is, in the first optical bezel area OBA1, the cathode electrode CE or the portion of the cathode electrode CE may not include a cathode hole CH.

In the first optical area OA1, the plurality of cathode holes CH formed in the cathode electrode CE or the portion of the cathode electrode CE may also be referred to as a plurality of first transmission areas TA1 or a plurality of openings. Although FIG. 4 illustrates that each cathode hole CH has a respective circular shape, one or more cathode holes CH may have various shapes other than the circular shape, such as an elliptical shape, a polygonal shape, an irregular shape or the like.

Referring to FIG. 4, a second optical area (e.g., the second optical area OA2 in figures described above) may be disposed adjacent to the first optical area OA1. An arrangement of light emitting areas EA in the second optical area OA2 will be described in more detail later.

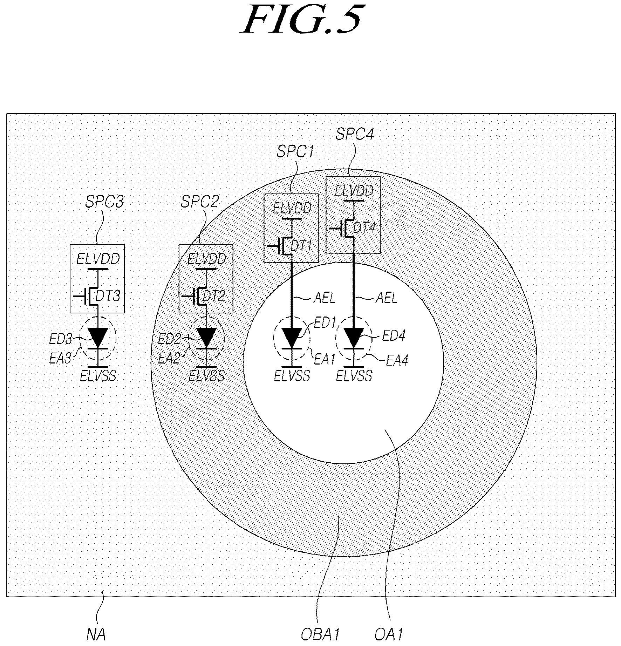

FIG. 5 illustrates an example configuration of light emitting elements and pixel circuits for driving the light emitting elements in the display panel 110 according to aspects of the present disclosure. As illustrated in FIG. 5, the display panel 110 may include light emitting elements (ED1, ED2, ED3, and ED4) disposed in the normal area NA, the first optical bezel area OBA1, and the first optical area OA1, and pixel circuits (SPC1, SPC2, SPC3, and SPC4) for driving the light emitting elements (ED1, ED2, ED3, and ED4).

It should be understood here that each of the pixel circuits (SPC1, SPC2, SPC3, and SPC4) may include transistors (DT and ST), a storage capacitor Cst, and the like as shown in FIG. 3. However, it should be noted that for convenience of explanation, each of the pixel circuits (SPC1, SPC2, SPC3, and SPC4) is simply expressed as only a respective driving transistor (DT1, DT2, DT3, and DT4).

Referring to FIG. 5, the normal area NA, the first optical area OA1, and the first optical bezel area OBA1 may have structural differences as well as positional differences.

As one example of such structural differences, one or more pixel circuits (SPC1, SPC2, SPC3, and/or SPC4) may be disposed in the first optical bezel area OBA1 and the normal area NA, but a pixel circuit may not be disposed in the first optical area OA1. For example, the first optical bezel area OBA1 and the normal area NA may be configured to allow one or more transistors (DT1, DT2, DT3, and/or DT4) to be disposed therein, and the first optical area OA1 may be configured not to allow a transistor to be present therein.

Transistors and storage capacitors included in the pixel circuits (SPC1, SPC2, SPC3, and SPC4) may be components causing transmittance to be reduced. Thus, since a pixel circuit (e.g., SPC1, SPC2, SPC3, or SPC4) is not disposed in the first optical area OA1, the transmittance of the first optical area OA1 can be more improved.

In one or more embodiments, although the pixel circuits (SPC1, SPC2, SPC3, and SPC4) may be disposed only in the normal area NA and the first optical bezel area OBA1, the light emitting elements (ED1, ED2, ED3, and ED4) may be disposed in the normal area NA, the first optical bezel area OBA1, and the first optical area OA1.

Referring to FIG. 5, although a first light emitting element ED1 may be disposed in the first optical area OA1, a first pixel circuit SPC1 for driving the first light emitting element ED1 may not be located in the first optical area OA1.

Referring to FIG. 5, the first pixel circuit SPC1 for driving the first light emitting element ED1 disposed in the first optical area OA1 may be disposed in the first optical bezel area OBA1, not in the first optical area OA1.

Hereinafter, the normal area NA, the first optical area OA1, and the first optical bezel area OBA1 will be described in more detail.

Referring to FIG. 5, in one or more embodiments, a plurality of light emitting areas EA included in the display panel 110 according to aspects of the present disclosure may include a first light emitting area EA1, a second light emitting area EA2, and a third light emitting area EA3. In these embodiments, the first light emitting area EA1, the second light emitting area EA2, and the third light emitting area EA3 may be included in the first optical area OA1, the first optical bezel area OBA1, and the normal area NA, respectively. Hereinafter, it is assumed that the first light emitting area EA1, the second light emitting area EA2, and the third light emitting area EA3 are areas emitting light of a same color.

Referring to FIG. 5, in one or more embodiments, the display panel 110 according to aspects of the present disclosure may include: a first light emitting element ED1 disposed in the first optical area OA1 and having the first light emitting area EA1; a second light emitting element ED2 disposed in the first optical bezel area OBA1 and having the second light emitting area EA2; and a third light emitting element ED3 disposed in the normal area NA and having the third light emitting area EA3.

Referring to FIG. 5, in one or more embodiments, the display panel 110 according to aspects of the present disclosure may further include a first pixel circuit SPC1 configured to drive the first light emitting element ED1, a second pixel circuit SPC2 configured to drive the second light emitting element ED2, and a third pixel circuit SPC3 configured to drive the third light emitting element ED3.

Referring to FIG. 5, the first pixel circuit SPC1 may include a first driving transistor DT1. The second pixel circuit SPC2 may include a second driving transistor DT2. The third pixel circuit SPC3 may include a third driving transistor DT3.

Referring to FIG. 5, in one or more embodiments, in the display panel 110 according to aspects of the present disclosure, the second pixel circuit SPC2 may be located in the first optical bezel area OBA1 where the second light emitting element ED2 corresponding to the second pixel circuit SPC2 is disposed, and the third pixel circuit SPC3 may be located in the normal area NA where the third light emitting element ED3 corresponding to the third pixel circuit SPC3 is disposed.

Referring to FIG. 5, in one or more embodiments, in the display panel 110 according to aspects of the present disclosure, the first pixel circuit SPC1 may not be located in the first optical area OA1 where the first light emitting element ED1 corresponding to the first pixel circuit SPC1 is disposed. Instead, the first pixel circuit SPC1 may be located in the first optical bezel area OBA1 located outside of the first optical area OA1. As a result, the transmittance of the first optical area OA1 can be improved.

Referring to FIG. 5, in one or more embodiments, the display panel 110 according to aspects of the present disclosure may further include an anode extension line AEL electrically connecting the first light emitting element ED1 disposed in the first optical area OA1 to the first pixel circuit SPC1 disposed in the first optical bezel area OBA1.

The anode extension line AEL may electrically extend or connect an anode electrode AE of the first light emitting element ED1 to a second node N2 of the first driving transistor DT1 in the first pixel circuit SPC1.

As described above, in the display panel 110 according to aspects of the present disclosure, the first pixel circuit SPC1 for driving the first light emitting element ED1 disposed in the first optical area OA1 may be disposed in the first optical bezel area OBA1, not in the first optical area OA1. Such a structure may be referred to as an anode extension structure. Likewise, the first type of the first optical area OA may be also referred to as an anode extension type.

In an embodiment where the display panel 110 according to aspects of the present disclosure has such an anode extension structure, all or a portion of the anode extension line AEL may be disposed in the first optical area OA1, and the anode extension line AEL may include a transparent material, or be or include a transparent line. Accordingly, even when the anode extension line AEL for connecting the first pixel circuit SPC1 to the first light emitting element ED1 is disposed in the first optical area OA1, the display device or the display panel 110 according to aspects of the present disclosure can prevent the transmittance of the first optical area OA1 from being reduced.

Referring to FIG. 5, a plurality of light emitting areas EA may further include a fourth light emitting area EA4 emitting light of the same color as the first light emitting area EA1 and included in the first optical area OA1

Referring to FIG. 5, the fourth light emitting area EA4 may be disposed adjacent to the first light emitting area EA1 in a row direction or a column direction.

Referring to FIG. 5, in one or more embodiments, the display panel 110 according to aspects of the present disclosure may further include a fourth light emitting element ED4 disposed in the first optical area OA1 and having the fourth light emitting area EA4, and a fourth pixel circuit SPC4 configured to drive the fourth light emitting element ED4.

Referring to FIG. 5, the fourth pixel circuit SPC4 may include a fourth driving transistor DT4. For convenience of description, a scan transistor ST and a storage capacitor Cst included in the fourth pixel circuit SPC4 are omitted from FIG. 5.

Referring to FIG. 5, although the fourth pixel circuit SPC4 is a circuit for driving the fourth light emitting element ED4 disposed in the first optical area OA1, the fourth pixel circuit SPC4 may be disposed in the first optical bezel area OBA1.

Referring to FIG. 5, in one or more embodiments, the display panel 110 according to aspects of the present disclosure may further include an anode extension line AEL for electrically connecting the fourth light emitting element ED4 to the fourth pixel circuit SPC4.

All or a portion of the anode extension line AEL may be disposed in the first optical area OA1, and the anode extension line AEL may include a transparent material, or be or include a transparent line.

As described above, the first pixel circuit SPC1 disposed in the first optical bezel area OBA1 may be configured to drive one light emitting element ED1 disposed in the first optical area OA1. Such a circuit connection scheme may be referred to as a one-to-one (1:1) circuit connection scheme.

As a result, the number of pixel circuits SPC disposed in the first optical bezel area OBA1 may be increased significantly. Further, the structure of the first optical bezel area OBA1 may become complicated, and an open area (which may be referred to as an aperture ratio, an open ratio, or a light emitting area) of the first optical bezel area OBA1 may be reduced.

In order to increase an open area (or an aperture ratio, or an open ratio, or a light emitting area) of the first optical bezel area OBA1 while having an anode extension structure, in one or more embodiments, the display device 100 according to aspects of the present disclosure may be configured in an 1:N (where N is 2 or more) circuit connection scheme.

According to the 1:N circuit connection scheme, the first pixel circuit SPC1 disposed in the first optical bezel area OBA1 may be configured to drive two light emitting elements ED disposed in the first optical area OA1 concurrently or together.

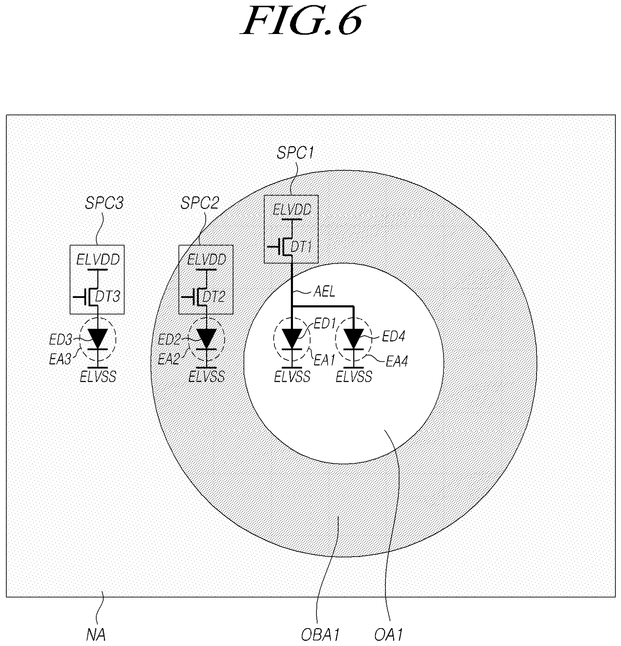

FIG. 6 illustrates a 1:2 circuit connection scheme as an example for convenience of description. In this example, a first pixel circuit SPC1 disposed in the first optical bezel area OBA1 may be configured to drive two or more light emitting elements (ED1 and ED4) disposed in the first optical area OA1 concurrently or together.

In one or more embodiments, referring to FIG. 6, light emitting elements (ED1, ED2, ED3, and ED4) disposed in the normal area NA, the first optical bezel area OBA1, and the first optical area OA1, and pixel circuits (SPC1, SPC2, and SPC3) for driving the light emitting elements (ED1, ED2, ED3, and ED4) may be disposed in the display panel 110.

Referring to FIG. 6, a fourth light emitting element ED4 disposed in the first optical area OA1 can be driven by the first pixel circuit SPC1 for driving a first light emitting element ED1 located in the first optical area OA1. That is, the first pixel circuit SPC1 disposed in the first optical bezel area OBA1 may be configured to drive the first light emitting element ED1 and the fourth light emitting element ED4 disposed in the first optical area OA1 together or substantially concurrently.

Accordingly, even when the display panel 110 has an anode extension structure, the number of pixel circuits SPC disposed in the first optical bezel area OBA1 can be significantly reduced, and thereby, an open area and a light emitting area of the first optical bezel area OBA1 can be increased.

In the example of FIG. 6, the first light emitting element ED1 and the fourth light emitting element ED4 driven together by the first pixel circuit SPC1 disposed in the first optical bezel area OBA1 may be light emitting elements that emit light of a same color, and are adjacent to each other in a row direction or a column direction.

Referring to FIG. 6, an anode extension line AEL may connect the first light emitting element ED1 and the fourth light emitting element ED4 disposed in the first optical area OA1 to the first pixel circuit SPC1 disposed in the first optical bezel area OBA1.

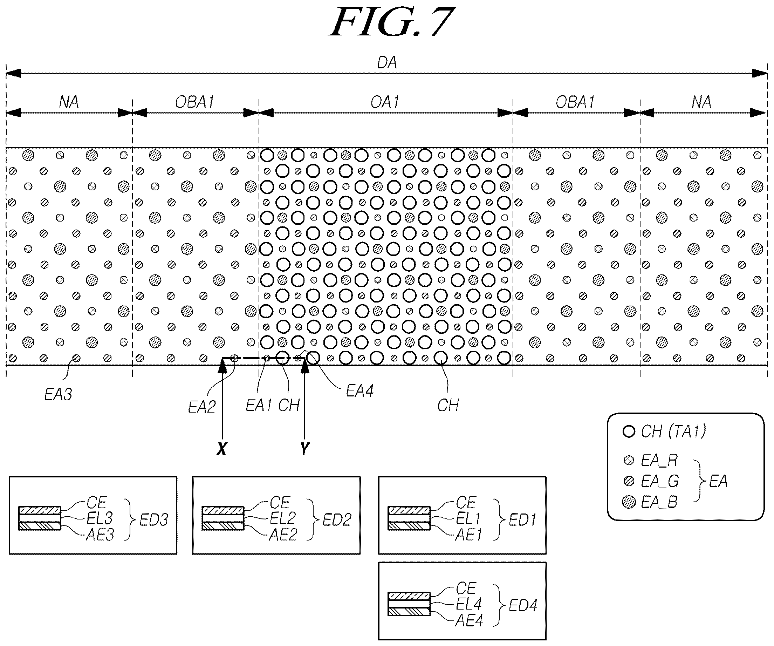

FIG. 7 is an example plan view of the normal area NA, the first optical bezel area OBA1, and the first optical area OA1 in the display panel 110 according to aspects of the present disclosure.

Referring to FIG. 7, in one or more embodiments, in the display panel 110 according to aspects of the present disclosure, a plurality of light emitting areas EA disposed in each of the normal area NA, the first optical bezel area OBA1, and the first optical area OA1 may include a red light emitting area EA_R, a green light emitting area EA_G, and a blue light emitting area EA_B.

Referring to FIG. 7, in one or more embodiments, in the display panel 110 according to aspects of the present disclosure, a cathode electrode (e.g., the cathode electrode CE of FIG. 3) may be commonly disposed in the normal area NA, the first optical bezel area OBA1, and the first optical area OA1.

The cathode electrode CE may include a plurality of cathode holes CH, and the plurality of cathode holes CH of the cathode electrode CE may be disposed in the first optical area OA1.

The normal area NA and the first optical bezel area OBA1 may be areas through which light cannot be transmitted, and the first optical area OA1 may be an area through which light can be transmitted. As a result, the transmittance of the first optical area OA1 may become higher than the respective transmittance of the first optical bezel area OBA1 and the normal area NA.

All of the first optical area OA1 may be an area through which light can be transmitted, and the plurality of cathode holes CH of the optical area OA may be transmittable areas TA through which light can be transmitted more effectively. For example, the remaining area except for the plurality of cathode holes CH in the first optical area OA1 may be an area through which light can be transmitted, and respective transmittance of the plurality of cathode holes CH in the first optical area OA1 may be higher than the transmittance of the remaining area except for the plurality of cathode holes (CH) in the first optical area OA1.

In another example, the plurality of cathode holes CH in the first optical area OA1 may be transmission areas TA through which light can be transmitted, and the remaining area except for the plurality of cathode holes CH in the first optical area OA1 may be an area through which light cannot be transmitted.

Referring to FIG. 7, the arrangement of light emitting areas EA in the first optical area OA1, the (positional) arrangement of light emitting areas EA in the first optical bezel area OBA1, and the (positional) arrangement of light emitting areas EA in the normal area NA may be the same as one another.

Referring to FIG. 7, a plurality of light emitting areas EA may include a first light emitting area EA1 included in the first optical area OA1, a second light emitting area EA2 included in the first optical bezel area OBA1 and emitting light of the same color as the first light emitting area EA1, and a third light emitting area EA3 included in the normal area NA and emitting light of the same color as the first light emitting area EA1.

Referring to FIG. 7, the plurality of light emitting areas EA may further include a fourth light emitting area EA4 included in the first optical area OA1 and emitting light of the same color as the first light emitting area EA1.

Referring to FIG. 7, in one or more embodiments, the display panel 110 according to aspects of the present disclosure may include a first anode electrode AE1 disposed in the first optical area OA1, a second anode electrode AE2 disposed in the first optical bezel area OBA1, a third anode electrode AE3 disposed in the normal area NA, and a fourth anode electrode AE4 disposed in the first optical area OA1.

In one or more embodiments, the display panel 110 according to aspects of the present disclosure may further include a cathode electrode CE commonly disposed in the normal area NA, the first optical bezel area OBA1, and the first optical area OA1.

In one or more embodiments, the display panel 110 according to aspects of the present disclosure may include a first emission layer EL1 disposed in the first optical area OA1, a second emission layer EL2 disposed in the first optical bezel area OBA1, a third emission layer EL3 disposed in the normal area NA, and a fourth emission layer EL4 disposed in the first optical area OA1.

The first to fourth emission layers EL4 may be emission layers emitting light of a same color. In these embodiments, the first to fourth emission layers EL1 to EL4 may be disposed as separate emission layers or be integrated into a single emission layer.

Referring to FIG. 7, light emitting elements of the display panel 110 according to aspects of the present disclosure may be configured such that: the first light emitting element ED1 is configured with the first anode electrode AE1, the first emission layer EL1, and the cathode electrode CE; the second light emitting element ED2 is configured with the second anode electrode AE2, the second emission layer EL2, and the cathode electrode CE; the third light emitting element ED3 is configured with the third anode electrode AE3, the third emission layer EL3, and the cathode electrode CE; and the fourth light emitting element ED4 is configured with the fourth anode electrode AE4, the fourth emission layer EL4, and the cathode electrode CE.

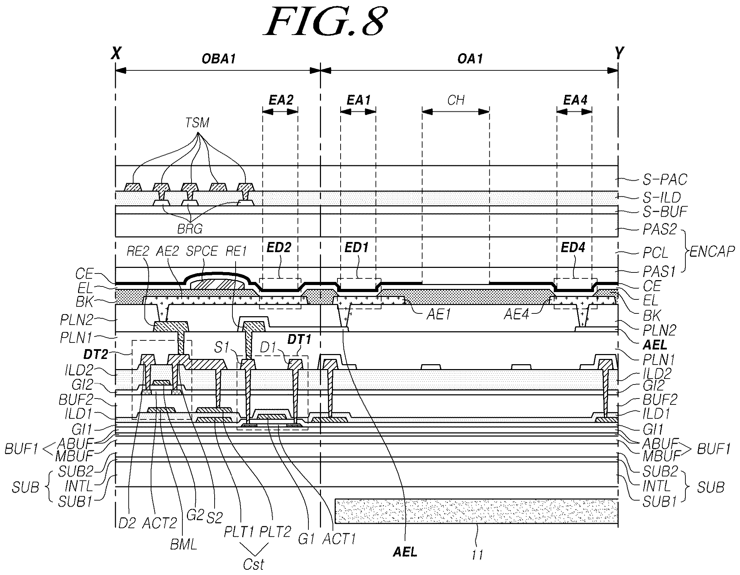

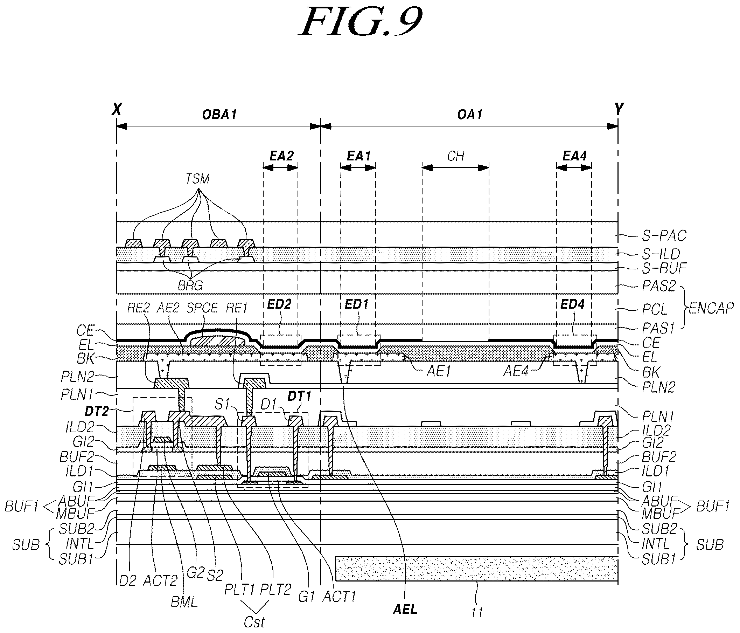

Hereinafter, a cross-sectional structure taken along line X-Y of FIG. 7 will be discussed in more detail with reference to FIGS. 8 and 9.

A portion indicated by line X-Y in FIG. 7 includes a portion of the first optical bezel area OBA1 and a portion of the first optical area OA1 with respect to the boundary between the first optical bezel area OBA1 and the first optical area OA1.

The portion indicated by line X-Y in FIG. 7 may include the first light emitting area EA1 and the fourth light emitting area EA4 included in the first optical area OA1, and the second light emitting area EA2 included in the first optical bezel area OBA1. The first light emitting area EA1, the fourth light emitting area EA4, and the second light emitting area EA2 may represent light emitting areas EA emitting light of a same color.

FIG. 8 illustrates an example cross-sectional view of the display panel 110 according to aspects of the present disclosure, and more specifically, illustrates example cross-sectional views in the first optical bezel area OBA1 and the first optical area OA1 of the display panel 110. It should be noted here that FIG. 8 illustrates cross-sectional views based on the application of a 1:1 circuit connection scheme, as in FIG. 5.

Referring to FIG. 8, in terms of stackup configuration, the display panel 110 may include a transistor forming part, a light emitting element forming part, and an encapsulation part.

The transistor forming part may include a substrate SUB, a first buffer layer BUF1 on the substrate SUB, various types of transistors DT1 and DT2 formed on the first buffer layer BUF, a storage capacitor Cst, and various electrodes and signal lines.

The substrate SUB may include, for example, a first substrate SUB1 and a second substrate SUB2, and may include an intermediate layer INTL interposed between the first substrate SUB1 and the second substrate SUB2. In this example, the intermediate layer INTL may be an inorganic layer and can serve to prevent moisture permeation.

The first buffer layer BUF1 may include a stack of a single layer or a stack of multiple layers. In an example where the first buffer layer BUF1 includes a stack of multilayer, the first buffer layer BUF1 may include a multi-buffer layer MBUF and an active buffer layer ABUF.

Various types of transistors (DT1, DT2, and the like), at least one storage capacitor Cst, and various electrodes or signal lines may be disposed on the first buffer layer BUF1.

For example, the transistors DT1 and DT2 formed on the first buffer layer BUF1 may include a same material, and be located in one or more same layers. In another example, as shown in FIG. 8, the first driving transistor DT1 and a second driving transistor DT2 among the transistors (DT1, DT2, and the like) may include different materials and be located in different layers.

Referring to FIG. 8, the first driving transistor DT1 may represent a driving transistor DT for driving the first light emitting element ED1 included in the first optical area OA1, and the second driving transistor DT2 may represent a driving transistor DT for driving the second light emitting element ED2 included in the first optical bezel area OBA1.

For example, the first driving transistor DT1 may represent a driving transistor included in the first pixel circuit SPC1 for driving the first light emitting element ED1 included in the first optical area OA1, and the second driving transistor DT2 may represent a driving transistor included in the second pixel circuit SPC2 for driving the second light emitting element ED2 included in the first optical bezel area OBA1.

Stackup configurations of the first driving transistor DT1 and the second driving transistor DT2 will be described below.

The first driving transistor DT1 may include the first active layer ACT1, a first gate electrode G1, a first source electrode S1, and a first drain electrode D1.

The second driving transistor DT2 may include a second active layer ACT2, a second gate electrode G2, a second source electrode S2, and a second drain electrode D2.

The second active layer ACT2 of the second driving transistor DT2 may be located in a higher location in the stackup configuration than the first active layer ACT1 of the first driving transistor DT1.

The first buffer layer BUF1 may be disposed under the first active layer ACT1 of the first driving transistor DT1, and the second buffer layer BUF2 may be disposed under the second active layer ACT2 of the second driving transistor DT2.

For example, the first active layer ACT1 of the first driving transistor DT1 may be located on the first buffer layer BUF1, and the second active layer ACT2 of the second driving transistor DT2 may be located on the second buffer layer BUF2. In this case, the second buffer layer BUF2 may be placed in a higher location than the first buffer layer BUF.

The first active layer ACT1 of the first driving transistor DT1 may be disposed on the first buffer layer BUF1, and a first gate insulating layer GI1 may be disposed on the first active layer ACT1 of the first driving transistor DT1. The first gate electrode G1 of the first driving transistor DT1 may be disposed on the first gate insulating layer GI1, and a first interlayer insulating layer ILD1 may be disposed on the first gate electrode G1 of the first driving transistor DT1.

In this implementation, the first active layer ACT1 of the first driving transistor DT1 may include a first channel region overlapping the first gate electrode G1, a first source connection region located on one side of the first channel region, and a first drain connection region located on the other side of the first channel region.

The second buffer layer BUF2 may be disposed on the first interlayer insulating layer ILD1.

The second active layer ACT2 of the second driving transistor DT2 may be disposed on the second buffer layer BUF2, and a second gate insulating layer GI2 may be disposed on the second active layer ACT2. The second gate electrode G2 of the second driving transistor DT2 may be disposed on the second gate insulating layer GI2, and a second interlayer insulating layer ILD2 may be disposed on the second gate electrode G2.

In this implementation, the second active layer ACT2 of the second driving transistor DT2 may include a second channel region overlapping the second gate electrode G2, a second source connection region located on one side of the second channel region, and a second drain connection region located on the other side of the second channel region.

The first source electrode S1 and the first drain electrode D1 of the first driving transistor DT1 may be disposed on the second interlayer insulating layer ILD2. The second source electrode S2 and the second drain electrode D2 of the second driving transistor DT2 may be also disposed on the second interlayer insulating layer ILD2.

The first source electrode S1 and the first drain electrode D1 of the first driving transistor DT1 may be respectively connected to the first source connection region and the first drain connection region of the first active layer ACT1 through through-holes formed in the second interlayer insulating layer ILD2, the second gate insulating layer GI2, the second buffer layer BUF2, the first interlayer insulating layer ILD1, and the first gate insulating layer GI1.

The second source electrode S2 and the second drain electrode D21 of the second driving transistor DT2 may be respectively connected to the second source connection region and the second drain connection region of the second active layer ACT2 through through-holes formed in the second interlayer insulating layer ILD2 and the second gate insulating layer GI2.

It should be understood that FIG. 8 illustrates only the second driving transistor DT2 and a storage capacitor Cst among circuit components included in the second pixel circuit SPC2, and other components such as one or more transistors, and the like are omitted. It should be also understood that FIG. 8 illustrates only the first driving transistor DT1 among circuit components included in the first pixel circuit SPC1, and other components such as one or more transistors, a storage capacitor, and the like are omitted.

Referring to FIG. 8, the storage capacitor Cst included in the second pixel circuit SPC2 may include a first capacitor electrode PLT1 and a second capacitor electrode PLT2.

The first capacitor electrode PLT1 may be electrically connected to the second gate electrode G2 of the second driving transistor DT2, and the second capacitor electrode PLT2 may be electrically connected to the second source electrode S2 of the second driving transistor DT2.

In one or more embodiments, referring to FIG. 8, a lower metal BML may be disposed under the second active layer ACT2 of the second driving transistor DT2. This lower metal BML may overlap all or a portion of the second active layer ACT2.

The lower metal BML may be electrically connected to, for example, the second gate electrode G2. In another example, the lower metal BML can serve as a light shield for shielding light traveling from a lower location than the lower metal BML. In this implementation, the lower metal BML may be electrically connected to the second source electrode S2.

Even though the first driving transistor DT1 is a transistor for driving the first light emitting element ED1 disposed in the first optical area OA1, the first driving transistor DT1 may be disposed in the first optical bezel area OBA1.

As the second driving transistor DT2 is a transistor for driving the second light emitting element ED2 disposed in the first optical bezel area OBA1, the second driving transistor DT2 may be disposed in the first optical bezel area OBA1.

Referring to FIG. 8, the first planarization layer PLN1 may be disposed on the first driving transistor DT1 and the second driving transistor DT2. For example, the first planarization layer PLN1 may be disposed on the first source electrode S1 and the first drain electrode D1 of the first driving transistor DT1 and the second source electrode S2 and the second drain electrode D2 of the second driving transistor DT2.

Referring to FIG. 8, a first relay electrode RE1 and a second relay electrode RE2 may be disposed on the first planarization layer PLN1.

The first relay electrode RE1 may represent an electrode for relaying an electrical interconnection between the first source electrode S1 of the first driving transistor DT1 and a first anode electrode AE1 of the first light emitting element ED1. The second relay electrode RE2 may represent an electrode for relaying an electrical interconnection between the second source electrode S2 of the second driving transistor DT2 and a second anode electrode AE2 of the second light emitting element ED2.

The first relay electrode RE1 may be electrically connected to the first source electrode S1 of the first driving transistor DT1 through a hole formed in the first planarization layer PLN1. The second relay electrode RE2 may be electrically connected to the second source electrode S2 of the second driving transistor DT2 through another hole formed in the first planarization layer PLN1.

Referring to FIG. 8, the first relay electrode RE2 and the second relay electrode RE2 may be disposed in the first optical bezel area OBA1.

Referring to FIG. 8, an anode extension line AEL may be connected to the first relay electrode RE1 and extend from the first optical bezel area OBA1 to the first optical area OA1.

In one or more embodiments, referring to FIG. 8, the anode extension line AEL may be a metal layer disposed on the first relay electrode RE1 and include a transparent material.

Referring to FIG. 8, the second planarization layer PLN2 may be disposed on the first relay electrode RE1, the second relay electrode RE2, and the anode extension line AEL such that it covers them.

Referring to FIG. 8, the light emitting element forming part may be located on the second planarization layer PNL2.

Referring to FIG. 8, the light emitting element forming part may include the first light emitting element ED1, the second light emitting element ED2, and the fourth light emitting element ED4, which are disposed on the second planarization layer PNL2.

Referring to FIG. 8, the first light emitting element ED1 and the fourth light emitting element ED4 may be disposed in the first optical area OA1, and the second light emitting element ED2 may be disposed in the first optical bezel area OBA1.

In the example of FIG. 8, the first light emitting element ED1, the second light emitting element ED2, and the fourth light emitting element ED4 may be light emitting elements emitting light of a same color. Respective emission layers EL of the first light emitting element ED1, the second light emitting element ED2, and the fourth light emitting element ED4 may be formed independently of one another. However, in discussions that follow, for convenience of explanation, it is assumed that respective emission layers EL of the first light emitting element ED1, the second light emitting element ED2, and the fourth light emitting element ED4 are commonly formed as one common emission layer.

Referring to FIG. 8, the first light emitting element ED1 may be configured (i.e., made up) in an area where the first anode electrode AE1, the emission layer EL, and the cathode electrode CE overlap one another. The second light emitting element ED2 may be configured (i.e., made up) in an area where the second anode electrode AE2, the emission layer EL, and the cathode electrode CE overlap one another. The fourth light emitting element ED4 may be configured (i.e., made up) in an area where the fourth anode electrode AE4, the emission layer EL, and the cathode electrode CE overlap one another.

Referring to FIG. 8, the first anode electrode AE1, the second anode electrode AE2, and the fourth anode electrode AE4 may be disposed on the second planarization layer PLN2.

The second anode electrode AE2 may be connected to the second relay electrode RE2 through a hole formed in the second planarization layer PLN2.

The first anode electrode AE1 may be connected to an anode extension line AEL extending from the first optical bezel area OBA1 to the first optical area OA1 through another hole formed in the second planarization layer PLN2.

The fourth anode electrode AE4 may be connected to another anode extension line AEL extending from the first optical bezel area OBA1 to the first optical area OA1 through further another hole formed in the second planarization layer PLN2.

Referring to FIG. 8, a bank BK may be disposed on the first anode electrode AE1, the second anode electrode AE2, and the fourth anode electrode AE4.

The bank BK may include a plurality of bank holes, and respective portions of the first anode electrode AE1, the second anode electrode AE2, and the fourth anode electrode AE4 may be exposed through respective bank holes. That is, the plurality of bank holes formed in the bank BK may respectively overlap the respective portions of the first anode electrode AE1, the second anode electrode AE2, and the fourth anode electrode AE4.

Referring to FIG. 8, the emission layer EL may be disposed on the bank BK. The emission layer EL may contact the respective portions of the first anode electrode AE1, the second anode electrode AE2, and the fourth anode electrode AE4 through the plurality of bank holes.

Referring to FIG. 8, at least one spacer SPC may be present between the emission layer EL and the bank BK.

Referring to FIG. 8, the cathode electrode CE may be disposed on the emission layer EL. The cathode electrode CE may include a plurality of cathode holes CH. The plurality of cathode holes CH formed in the cathode electrode CE may be disposed in the first optical area OA1.

One cathode hole CH illustrated in FIG. 8 may represent a cathode hole located between the first light emitting area EA1 and the fourth light emitting area EA4.

Referring to FIG. 8, the encapsulation part may be located on the cathode electrode CE. The encapsulation part may include an encapsulation layer ENCAP disposed on the cathode electrode CE.

Referring to FIG. 8, the encapsulation layer ENCAP can serve to prevent penetration of moisture or oxygen into the light emitting elements (ED1, ED2, and ED4) disposed under the encapsulation layer ENCAP. In particular, the encapsulation layer ENCAP may include an organic material or film and can serve to prevent penetration of moisture or oxygen into the emission layer EL. In one or more embodiments, the encapsulation layer ENCAP may include a stack of a single layer or a stack of a multilayer.

Referring to FIG. 8, the encapsulation layer ENCAP may include a first encapsulation layer PAS1, a second encapsulation layer PCL, and a third encapsulation layer PAS2. First encapsulation layer PAS1 and the third encapsulation layer PAS2 may be, for example, inorganic material layers, and the second encapsulation layer PCL may be, for example, an organic material layer.

Since the second encapsulation layer PCL is implemented using an organic material, the second encapsulation layer PCL can serve as a planarization layer.

In one or more embodiments, a touch sensor may be integrated into the display panel 110 according to aspects of the present disclosure. In these embodiments, the display panel 110 according to aspects of the present disclosure may include a touch sensor part configured with such a touch sensor and disposed on the encapsulation layer ENCAP.

Referring to FIG. 8, the touch sensor part may include touch sensor metals TSM and bridge metals BRG, and may further include one or more insulating layers such as a sensor buffer layer S-BUF, a sensor interlayer insulating layer S-ILD, a sensor protective layer S-PAC, and the like.

The sensor buffer layer S-BUF may be disposed on the encapsulation layer ENCAP. The bridge metals BRG may be disposed on the sensor buffer layer S-BUF, and the sensor interlayer insulating layer S-ILD may be disposed on the bridge metals BRG.

The touch sensor metals TSM may be disposed on the sensor interlayer insulating layer S-ILD. One or more of the touch sensor metals TSM may be connected to one or more respective bridge metals BRG among the bridge metals BRG through one or more respective holes formed in the sensor interlayer insulating layer S-ILD.

Referring to FIG. 8, the touch sensor metals TSM and the bridge metals BRG may be disposed in the first optical bezel area OBA1. The touch sensor metals TSM and the bridge metals BRG may be disposed not to overlap the second light emitting area EA2 of the first optical bezel area OBA1.

A plurality of touch sensor metals TSM may be configured as one touch electrode (or one touch electrode line). For example, the plurality of touch sensor metals TSM may be arranged in a mesh pattern and therefore electrically connected to one another. One or more of the touch sensor metals TSM and the remaining one or more touch sensor metals TSM may be electrically connected through one or more respective bridge metals BRG, and thereby, be configured as one touch electrode (or one touch electrode line).

The sensor protective layer S-PAC may be disposed such that it covers the touch sensor metals TSM and the bridge metals BRG.

In an embodiment where a touch sensor is integrated into the display panel 110, at least one of the touch sensor metals TSM, or at least a portion of at least one of the touch sensor metals TSM, located on the encapsulation layer ENCAP may extend along an inclined surface formed in an edge of the encapsulation layer ENCAP, and be electrically connected to a pad located in an edge of the display panel 110 that is further away from the inclined surface of the edge of the encapsulation layer ENCAP. The pad may be disposed in the non-display area NDA and may be a metal pattern to which the touch driving circuit 260 is electrically connected.

In one or more embodiments, the display panel 110 according to aspects of the present disclosure may include a bank (e.g., the bank BK) disposed on a first anode electrode (e.g., the first anode electrode AE1) and having a bank hole exposing a portion of the first anode electrode AE1, and an emission layer (e.g., the emission layer EL) disposed on the bank BK and contacting the portion of the first anode electrode AE1 exposed through the bank hole.

The bank hole formed in the bank BK may not overlap a plurality of cathode holes CH. For example, the bank BK may not be depressed or perforated (i.e., remained in a flat state) at places where the plurality of cathode holes CH are present. Thus, at places where the plurality of cathode holes CH are present, the second planarization layer PLN and the first planarization layer PLN1 located under the bank BK may not be depressed or perforated as well (i.e., remained in a flat state).

The flat state of the respective portion of the upper surface of the bank BK located under any one of the plurality of cathode holes CH may mean that one or more insulating layers or one or more metal patterns (e.g., one or more electrode, one or more lines, and/or the like), or the emission layers EL located under any one of the plurality of cathode holes CH have not been damaged by the process of forming the plurality of cathode holes CH in the cathode electrode CE.

A brief description for the process of forming cathode holes CH in the cathode electrode CE is as follows. A specific mask pattern can be deposited at respective locations where the cathode holes CH are to be formed, and then, a cathode electrode material can be deposited thereon. Accordingly, the cathode electrode material can be deposited only in an area where the specific mask pattern is not located, and thereby, the cathode electrode CE including the cathode holes CH can be formed. The specific mask pattern may include, for example, an organic material. The cathode electrode material may include a magnesium-silver (Mg-Ag) alloy.

In one or more embodiments, after the cathode electrode CE having the cathode holes CH is formed, the display panel 110 may be in a situation in which the specific mask pattern is completely removed, partially removed (where a portion of the specific mask pattern remains), or not removed (where all of the specific mask pattern remains without being removed).

The display panel 110 according to aspects of the present disclosure may include a first driving transistor (e.g., the first driving transistor DT1) disposed in the first optical bezel area OBA1 to drive a first light emitting element (e.g., the first light emitting element ED1) disposed in the first optical area OA1, and a second driving transistor (e.g., the second driving transistor DT2) disposed in the first optical bezel area OBA1 to drive a second light emitting element (e.g., the second light emitting element ED2) disposed in the first optical bezel area OBA1.

In one or more embodiments, the display panel 110 according to aspects of the present disclosure may further include the first planarization layer PLN1 disposed on the first driving transistor DT1 and the second driving transistor DT2, a first relay electrode (e.g., the first relay electrode RE1) disposed on the first planarization layer PLN1 and electrically connected to the first source electrode S1 of the first driving transistor DT1 through a hole formed in the first planarization layer PLN1, a second relay electrode (e.g., the second relay electrode RE2) disposed on the first planarization layer PLN1 and electrically connected to the second source electrode S2 of the second driving transistor DT2 through another hole formed in the first planarization layer PLN1, and the second planarization layer PLN2 disposed on the first relay electrode RE1 and the second relay electrode RE2.

In one or more embodiments, the display panel 110 according to aspects of the present disclosure may further include an anode extension line (e.g., the anode extension line AEL) interconnecting the first relay electrode RE1 and the first anode electrode AE1, and located on the first planarization layer PLN1.

The second anode electrode AE2 may be electrically connected to the second relay electrode RE2 through a hole formed in the second planarization layer PLN2, and the first anode electrode AE1 may be electrically connected to the anode extension line AEL through another hole formed in the second planarization layer PLN2.

All or a portion of the anode extension line AEL may be disposed in the first optical area OA1, and the anode extension line AEL may include a transparent material, or be or include a transparent line.

The first pixel circuit SPC1 may include the first driving transistor DT1 for driving the first light emitting element ED1, and the second pixel circuit SPC2 may include the second driving transistor DT2 for driving the second light emitting element ED2.

The first active layer ACT1 of the first driving transistor DT1 may be located in a different layer from the second active layer ACT2 of the second driving transistor DT2.

In one or more embodiments, the display panel 110 according to aspects of the present disclosure may further include the substrate SUB, the first buffer layer BUF1 disposed between the substrate SUB and the first driving transistor DT1, and the second buffer layer BUF2 disposed between the first driving transistor DT1 and the second driving transistors DT2.

The first active layer ACT1 of the first driving transistor DT1 may include a different semiconductor material from the second active layer ACT2 of the second driving transistor DT2.

For example, the second active layer ACT2 of the second driving transistor DT2 may include an oxide semiconductor material. For example, such an oxide semiconductor material may include indium gallium zinc oxide (IGZO), indium gallium zinc tin oxide (IGZTO), zinc oxide (ZnO), cadmium oxide (CdO), indium oxide (InO), zinc tin oxide (ZTO), zinc indium tin oxide (ZITO), and/or the like.

For example, the first active layer ACT1 of the first driving transistor DT1 may include a different semiconductor material from the second active layer ACT2 of the second driving transistor DT2.

For example, the first active layer ACT1 of the first driving transistor DT1 may include a silicon-based semiconductor material. For example, the silicon-based semiconductor material may include low-temperature polycrystalline silicon (LTPS) or the like.

In one or more embodiments, the display panel 110 according to aspects of the present disclosure may further include an encapsulation layer (e.g., the encapsulation layer ENCAP) located on the first light emitting element ED1, the second light emitting element ED2, and the third light emitting element ED3, and one or more touch sensor metals TSM located on the encapsulation layer ENCAP.

The touch sensor metal TSM may be disposed in the normal area NA and the first optical bezel area OBA1.

Referring to FIG. 8, the first optical area OA1 may overlap the first optical electronic device 11. The first optical bezel area OBA1 may not overlap the first optical electronic device 11. One or more embodiments, a portion of the first optical bezel area OBA1 may overlap the first optical electronic device 11.

Referring to FIG. 8, a cross-sectional structure of the normal area NA may be substantially or nearly the same as that of the first optical bezel area OBA1. It should be noted here that the first pixel circuit SPC1 disposed in the first optical bezel area OBA1 to drive the first light emitting element ED1 disposed in the first optical area OA1 may not be disposed in the normal area NA.

FIG. 9 illustrates an example cross-sectional view of the display panel 110 according to aspects of the present disclosure, and more specifically, illustrates example cross-sectional views in the first optical bezel area OBA1 and the first optical area OA1 of the display panel 110. It should be noted here that FIG. 9 illustrates an example cross-sectional view based on the application of a 1:2 circuit connection scheme, as in FIG. 6.

The cross-sectional view of FIG. 9 is basically the same as the cross-sectional view of FIG. 8. It should be noted here that one difference between the cross-sectional views of FIGS. 8 and 9 is that while FIG. 8 employs the 1:1 circuit connection scheme as in FIG. 5, FIG. 9 employs the 1:2 circuit connection scheme as in FIG. 6. Taking account of the similarity between them, hereinafter, descriptions on the cross-sectional structure of FIG. 9 will be provided by focusing on features different from the cross-sectional structure of FIG. 8.

Referring to FIG. 9, the first light emitting element ED1 and the fourth light emitting element ED4 disposed in the first optical area OA1 may be driven the first driving transistor DT1 disposed in the first optical bezel area OBA1 together or substantially concurrently.

Accordingly, as illustrated in FIG. 9, an anode extension line AEL (e.g., the anode extension line AEL of FIG. 8) may be further electrically connected to the fourth anode electrode AE4 different from the first anode electrode AE1, as well as the first anode electrode AE1. Thus, the anode extension line AEL may be electrically connected to both the first anode electrode AE1 of the first light emitting element ED1 and the fourth anode electrode AE4 of the fourth light emitting element ED4.

Referring to FIG. 9, the anode extension line AEL may overlap a cathode hole CH located between the first light emitting element ED1 and the fourth light emitting element ED4 among a plurality of cathode holes CH.

Referring to FIG. 9, the first light emitting area EA1 configured by the first light emitting element ED1 and the fourth light emitting area EA4 configured by the fourth light emitting element ED4 may be light emitting areas emitting light of a same color.

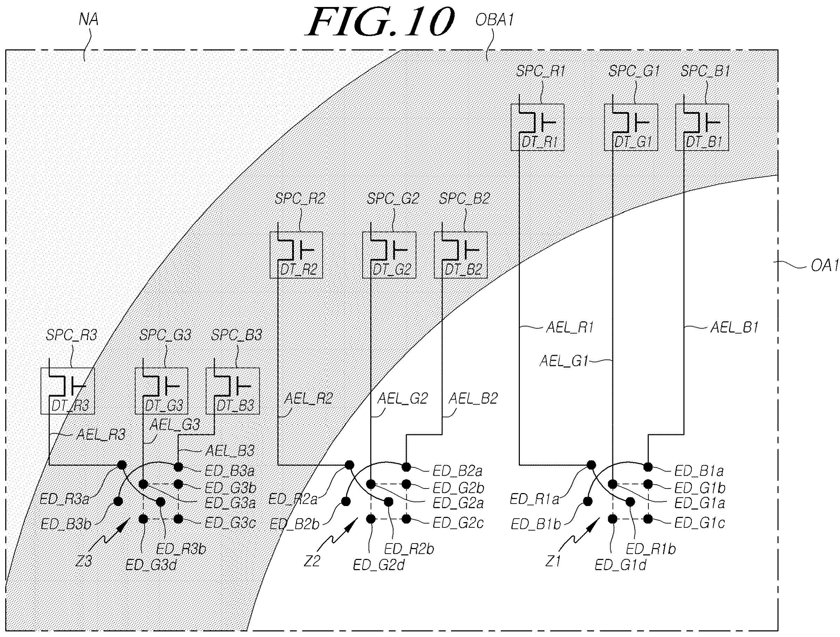

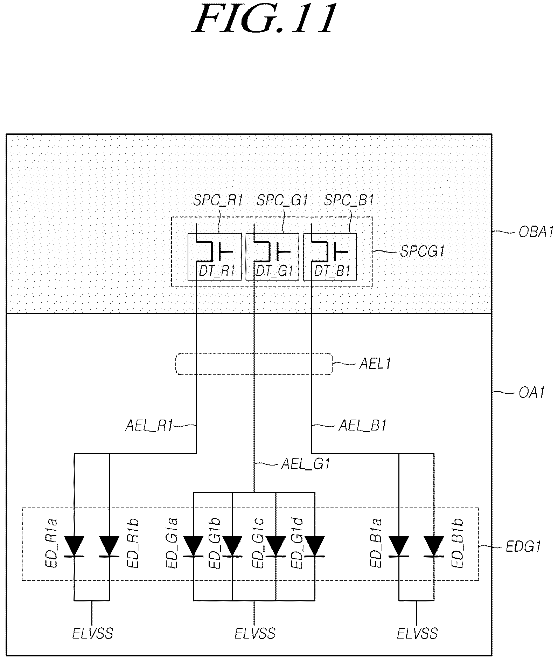

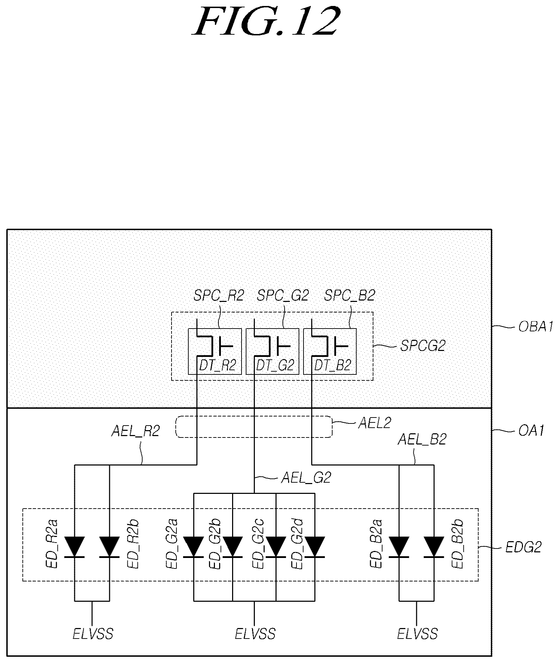

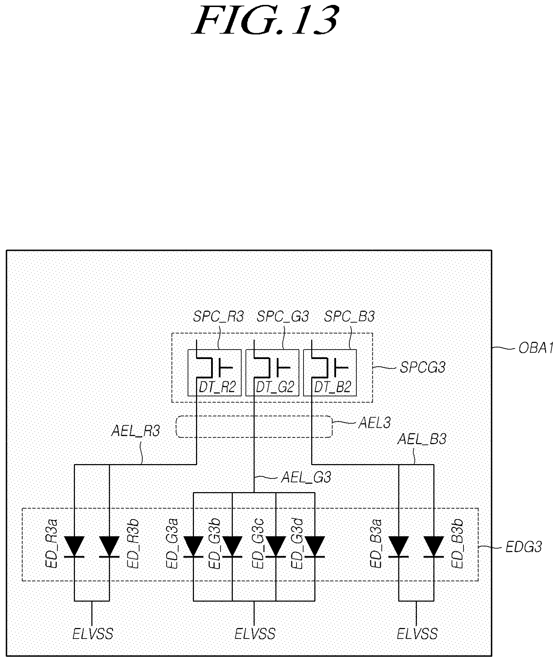

FIG. 10 illustrates an example connection structure between light emitting elements ED and pixel circuits SPC in the display panel 110 according to aspects of the present disclosure. FIG. 11 illustrates an example connection structure related to light emitting elements ED disposed in a first area Z1 in the first optical area OA1 of FIG. 10. FIG. 12 illustrates an example connection structure related to light emitting elements ED disposed in a second area Z2 in the first optical area OA1 of FIG. 10. FIG. 13 illustrates an example connection structure related to light emitting elements ED disposed in a third area Z3 in the first optical bezel area OBA1 of FIG. 10.

Referring to FIG. 10, a plurality of light emitting elements ED may be disposed in the first optical area OA1. A plurality of light emitting elements ED may be disposed in the first optical bezel area OBA1.

Referring to FIG. 10, the first optical area OA1 may include a first area Z1 and a second area Z2, which are different from each other. The first optical bezel area OBA1 may include a third area Z3 different from the first and second areas Z1 and Z2.

Referring to FIGS. 10 and 11, a first light emitting element group EDG1 may be disposed in the first area Z1 of the first optical area OA1. The first light emitting element group EDG1 may include N light emitting elements (ED_R1a, ED_R1b, ED_G1a, ED_G1b, ED_G1c, ED_G1d, ED_B1a, and ED_B1b), where N is a natural number greater than or equal to 2.

A first pixel circuit group SPCG1 for driving the first light emitting element group EDG1 disposed in the first area Z1 may be disposed in the first optical bezel area OBA1.

The first pixel circuit group SPCG1 may include M first pixel circuits (SPC_R1, SPC_G1, and SPC_B1), where M is a natural number greater than or equal to 1 and less than or equal to N.

Referring to FIGS. 10 and 12, a second light emitting element group EDG2 may be disposed in the second area Z2 of the first optical area OA1. The second light emitting element group EDG2 may include N light emitting elements (ED_R2a, ED_R2b, ED_G2a, ED_G2b, ED_G2c, ED_G2d, ED_B2a, and ED_B2b).

A second pixel circuit group SPCG2 for driving the second light emitting element group EDG2 disposed in the second area Z2 may be disposed in the first optical bezel area OBA1.

The second pixel circuit group SPCG2 may include M second pixel circuits (SPC_R2, SPC_G2, and SPC_B2).

Referring to FIGS. 10 and 13, a third light emitting element group EDG3 may be disposed in the third area Z3 of the first optical bezel area OBA1. The third light emitting element group EDG3 may include N light emitting elements (ED_R3a, ED_R3b, ED_G3a, ED_G3b, ED_G3c, ED_G3d, ED_B3a, and ED_B3b).

A third pixel circuit group SPCG3 for driving the third light emitting element group EDG3 disposed in the third area Z3 may be disposed in the first optical bezel area OBA1.

The third pixel circuit group SPCG3 may include M third pixel circuits (SPC_R3, SPC_G3, and SPC_B3).

The N light emitting elements ED disposed in each of the first to third areas (Z1, Z2, and Z3) may be driven by M pixel circuits SPC, where M is a natural number greater than or equal to 1 and less than or equal to N.

The first area Z1, the second area Z2, and the third area Z3 may be respective unit areas in terms of a correspondence relationship between a respective light emitting element ED and a respective pixel circuit SPC, which are associated with, or electrically connected to, each other. Here, N may represent the number of light emitting elements ED disposed in a unit area, and M may represent the number of pixel circuits SPC for driving the light emitting elements ED disposed in the unit area.

For example, in the example of FIG. 10, N is 8 and M is 3. That is, eight light emitting elements ED may be disposed in each of the first to third areas Z1, Z2, and Z3, and the eight light emitting elements ED disposed in each of the first to third areas Z1, Z2, and Z3 may be driven by three pixel circuits SPC.

For example, the eight light emitting elements ED may include two red light emitting elements respectively disposed in two red light emitting areas, four green light emitting elements respectively disposed in four green light emitting areas, and two blue light emitting elements disposed respectively disposed in two blue light emitting areas. For example, the three pixel circuits SPC may include one pixel circuit for driving the two red light emitting elements, one pixel circuit for driving the four green light emitting elements, and one pixel circuit for driving the two blue light emitting elements.

Referring to FIGS. 10 and 11, the first pixel circuit group SPCG1 may include a first red pixel circuit SPC_R1, a first green pixel circuit SPC_G1, and a first blue pixel circuit SPC_B1.

Referring to FIGS. 10 and 11, the first red pixel circuit SPC_R1 can drive two first red light emitting elements (ED_R1a and ED_R1b) included in the first light emitting element group EDG1 disposed in the first area Z1 through a driving transistor DT_R1.

The first red pixel circuit SPC_R1 may be electrically connected to the two first red light emitting elements (ED_R1a and ED_R1b) included in the first light emitting element group EDG1 disposed in the first area Z1 of the first optical area OA1 through a first red anode extension line AEL_R1.

Referring to FIGS. 10 and 11, the first green pixel circuit SPC_G1 can drive four first green light emitting elements (ED_G1a, ED_G1b, ED_G1c, and ED_G1d) included in the first light emitting element group EDG1 disposed in the first area Z1 through a driving transistor DT_G1.

The first green pixel circuit SPC_G1 may be electrically connected to the four first green light emitting elements (ED_G1a, ED_G1b, ED_G1c, and ED_G1d) included in the first light emitting element group EDG1 disposed in the first area Z1 of the first optical area OA1 through a first green anode extension line AEL_G1.

Referring to FIGS. 10 and 11, the first blue pixel circuit SPC_B1 can drive two first blue light emitting elements (ED_B1a and ED_B1b) included in the first light emitting element group EDG1 disposed in the first area Z1 through a driving transistor DT_B1.

The first blue pixel circuit SPC_B1 may be electrically connected to the two first blue light emitting elements (ED_B1a and ED_B1b) included in the first light emitting element group EDG1 disposed in the first area Z1 of the first optical area OA1 through a first blue anode extension line AEL_B1.

Referring to FIGS. 10 and 12, the second pixel circuit group SPCG2 may include a second red pixel circuit SPC_R2, a second green pixel circuit SPC_G2, and a second blue pixel circuit SPC_B2.

Referring to FIGS. 10 and 12, the second red pixel circuit SPC_R2 can drive two second red light emitting elements (ED_R2a and ED_R2b) included in the second light emitting element group EDG2 disposed in the second area Z2 through a driving transistor DT_R2.

The second red pixel circuit SPC_R2 may be electrically connected to the two second red light emitting elements (ED_R2a and ED_R2b) included in the second light emitting element group EDG2 disposed in the second area Z2 of the first optical area OA1 through a second red anode extension line AEL_R2.

Referring to FIGS. 10 and 12, the second green pixel circuit SPC_G2 can drive four second green light emitting elements (ED_G2a, ED_G2b, ED_G2c, and ED_G2d) included in the second light emitting element group EDG2 disposed in the second area Z2 through a driving transistor DT_G2.

The second green pixel circuit SPC_G2 may be electrically connected to the four second green light emitting elements (ED_G2a, ED_G2b, ED_G2c, and ED_G2d) included in the second light emitting element group EDG2 disposed in the second area Z2 of the first optical area OA1 through a second green anode extension line AEL_G2.

Referring to FIGS. 10 and 12, the second blue pixel circuit SPC_B2 can drive two second blue light emitting elements (ED_B2a and ED_B2b) included in the second light emitting element group EDG2 disposed in the second area Z2 through a driving transistor DT_B2.

The second blue pixel circuit SPC_B2 may be electrically connected to the two second blue light emitting elements (ED_B2a and ED_B2b) included in the second light emitting element group EDG2 disposed in the second area Z2 of the first optical area OA1 through a second blue anode extension line AEL_B2.

Referring to FIGS. 10 and 13, the third pixel circuit group SPCG3 may include a third red pixel circuit SPC_R3, a third green pixel circuit SPC_G3, and a third blue pixel circuit SPC_B3.

Referring to FIGS. 10 and 13, the third red pixel circuit SPC_R3 can drive two third red light emitting elements (ED_R3a and ED_R3b) included in the third light emitting element group EDG3 disposed in the third area Z3 through a driving transistor DT_R3.

The third red pixel circuit SPC_R3 may be electrically connected to the two third red light emitting elements (ED_R3a and ED_R3b) included in the third light emitting element group EDG3 disposed in the third area Z3 of the first optical bezel area OBA1 through a third red anode extension line AEL_R3.

Referring to FIGS. 10 and 13, the third green pixel circuit SPC_G3 can drive four third green light emitting elements (ED_G3a, ED_G3b, ED_G3c, and ED_G3d) included in the third light emitting element group EDG3 disposed in the third area Z3 through a driving transistor DT_G3.

The third green pixel circuit SPC_G3 may be electrically connected to the four third green light emitting elements (ED_G3a, ED_G3b, ED_G3c, and ED_G3d) included in the third light emitting element group EDG3 disposed in the third area Z3 of the first optical bezel area OBA1 through a third green anode extension line AEL_G3.

Referring to FIGS. 10 and 13, the third blue pixel circuit SPC_B3 can drive two third blue light emitting elements (ED_B3a and ED_B3b) included in the third light emitting element group EDG3 disposed in the third area Z3 through a driving transistor DT_B3.

The third blue pixel circuit SPC_B3 may be electrically connected to the two third blue light emitting elements (ED_B3a and ED_B3b) included in the third light emitting element group EDG1 disposed in the third area Z3 of the first optical bezel area OBA1 through a third blue anode extension line AEL_B3.

Referring to FIG. 10, a first anode extension line AEL1 (i.e., AEL_R1, EL_G1, and EL_B1) for a connection between the first light emitting element group EDG1 and the first pixel circuit group SPCG1, a second anode extension line AEL2 (i.e., AEL_R2, EL_G2, and EL_B2) for a connection between the second light emitting element group EDG2 and the second pixel circuit group SPCG2, and a third anode extension line AEL3 (i.e., AEL_R3, EL_G3, and EL_B3) for a connection between the third light emitting element group EDG3 and the third pixel circuit group SPCG3 may have different lengths according to a respective location of each of the first light emitting element group EDG1, the second light emitting element group EDG2, the third light emitting element group EDG3, the first pixel circuit group SPCG1, and the second pixel circuit group SPCG2, and the third pixel circuit groups SPCG3.

A difference in length between the first to third anode extension lines (AEL1, AEL2, and AEL3) may cause a difference in resistance between the first to third anode extension lines (AEL1, AEL2, and AEL3). In turn, this may cause a difference in luminance between the first light emitting element group EDG1, the second light emitting element group EDG2, and the third light emitting element group EDG3. Such a difference in luminance may lead image quality to be degraded.

To address these issues, in one or more embodiments, the display panel 110 according to aspects of the present disclosure may be configured to have a structure of compensating for a difference in resistance between anode extension lines even when a difference in length between anode extension lines is produced. Accordingly, respective resistance between light emitting elements ED and pixel circuits SPC may become the same or substantially the same.

Hereinafter, in the display panel 110 according to aspects of the present disclosure, a structure of compensating for a difference in resistance between anode extension lines will be described with reference to figures.

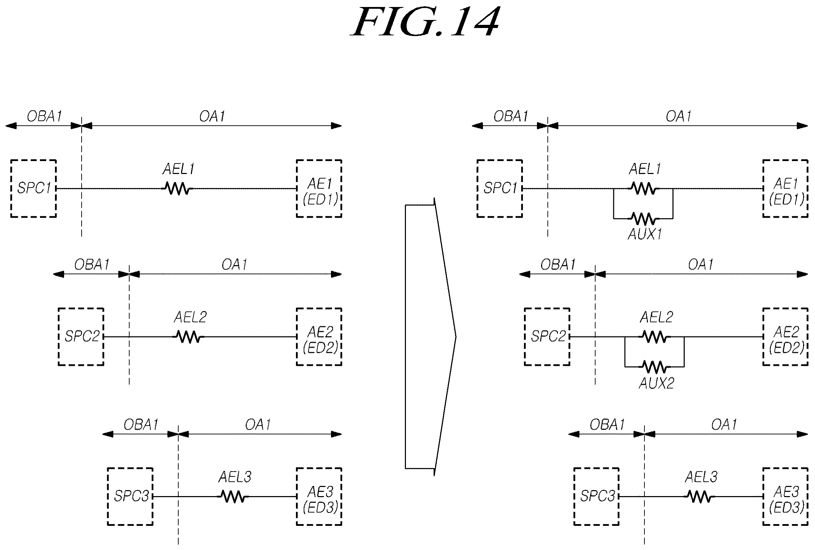

FIG. 14 is an example diagram for explaining a resistance difference compensation structure for compensating for a difference in resistance between anode extension lines (AEL1, AEL2, and AEL3) in the display panel 110 according to aspects of the present disclosure.

Referring to FIG. 14, description of a resistance difference compensation structure will be provided based on, for example, a first light emitting element ED1 disposed in the first optical area OA1, a second light emitting element ED2 disposed in the first optical region OA1, and a third light emitting element ED3 disposed in the first optical area OA1 or the first optical bezel area OBA1.

The first light emitting element ED1 may be driven by a first pixel circuit SPC1, the second light emitting element ED2 may be driven by a second pixel circuit SPC2 , and the third light emitting element ED3 may be driven by a third pixel circuit SPC3. For example, all of the first pixel circuit SPC1, the second pixel circuit SPC2, and the third pixel circuit SPC3 may be disposed in the first optical bezel area OBA1.

The first pixel circuit SPC1 and the first light emitting element ED1 may be electrically connected by a first anode extension line AEL1. The second pixel circuit SPC2 and the second light emitting element ED2 may be electrically connected by a second anode extension line AEL2. The third pixel circuit SPC3 and the third light emitting element ED3 may be electrically connected by a third anode extension line AEL3.

That is, the first anode extension line AEL1 may connect a first anode electrode AE1 of the first light emitting element ED1 to the first pixel circuit SPC1. The second anode extension line AEL2 may connect a second anode electrode AE2 of the second light emitting element ED2 to the second pixel circuit SPC2. The third anode extension line AEL3 may electrically connect a third anode electrode AE3 of the third light emitting element ED3 to the third pixel circuit SPC3.

Referring to FIG. 14, the first anode electrode AE1 of the first light emitting element ED1 may be disposed in the first optical area OA1, the second anode electrode AE2 of the second light emitting element ED2 may be disposed in the first optical area OA1, and the third anode electrode AE3 of the third light emitting element ED3 may be disposed in the first optical area OA1 or the first optical bezel area OBA1.

Referring to FIG. 14, due to a location relationship between the first light emitting element ED1 and the first pixel circuit SPC1, a location relation between the second light emitting element ED2 and the second pixel circuit SPC2, and a location relation between the third light emitting element ED3 and the third pixel circuit SPC3, the first anode extension line AEL1 may have the longest length, and the third anode extension line AEL3 may have the shortest length, among the first anode extension line AEL1, the second anode extension line AEL2, and the third anode extension line AEL3. For example, the length of the second anode extension line AEL2 may be less than that of the first anode extension line AEL1 and greater than that of the third anode extension line AEL3. The first anode extension line AEL1, the second anode extension line AEL2, and the third anode extension line AEL3 may be made of the same material and have the same line width. The resistivity of the first anode extension line AEL1, the second anode extension line AEL2, and the third anode extension line AEL3 may be equal or at least similar to each other. Alternatively, or in addition, the resistance per unit length of the first anode extension line AEL1, the second anode extension line AEL2, and the third anode extension line AEL3 may be equal or at least similar to each other. Resistivity is a unique property of the materials of AEL (AEL1, AEL2, AEL3). Therefore, if the material and line width of the first, second and third anode extension lines AEL1, AEL2 and AEL3 are the same, the resistivity and resistance per unit length of the first, second and third anode extension lines AEL1, AEL2 and AEL3 are the same or substantially the same. That is, in the present disclosure, under the condition that the first, second and third anode extension lines AEL1, AEL2, and AEL3 are all of the same material (anode electrode material or anode metal) and have the same line width, the difference in resistance between the first, second and third anode extension lines AEL1, AEL2, and AEL3 is considered to be due to the difference in length of the first, second and third anode extension lines AEL1, AEL2, and AEL3.

As a result, among the first anode extension line AEL1, the second anode extension line AEL2, and the third anode extension line AEL3, the resistance of the first anode extension line AEL1 may be the greatest, and the resistance of the third anode extension line AEL3 may be the smallest. Further, the resistance of the second anode extension line AEL2 may be less than that of the first anode extension line AEL1 and greater than that of the third anode extension line AEL3.

In some embodiments, this problem is addressed by adjusting one or more of the following properties of one or more (anode) extension lines depending on their lengths: the resistance per unit length, the cross-sectional area (taken through the line in a plane perpendicular to the length direction), and/or the width.

In other words, there is provided a display panel including: a display area arranged to display images, the display area including a first area arranged to transmit light; a first light emitting element disposed in the first area; a second light emitting element disposed in the first area; a first pixel circuit disposed outside of the first area; and a second pixel circuit disposed outside of the first area. The display panel may further include: a first extension line electrically interconnecting the first light emitting element and the first pixel circuit, and a second extension line electrically interconnecting the second light emitting element and the second pixel circuit. A total length of the first extension line is greater than a total length of the second extension line, and the average resistance per unit length (i.e. taking into account the whole line) of the first extension line is lower than the average resistance per unit length of the second extension line. The resistance per unit length may be chosen such that a total resistance (i.e. of the whole length) of the first extension line is equal to a total resistance of the second extension line. The difference in resistance per unit length may be achieved by designing the extension lines such that a cross-sectional area of the first extension line is greater than a cross-sectional area of the second extension line. For example, a width of the first extension line may be greater than a width of the second extension line.

Referring to FIG. 14, in one or more embodiments, the display panel 110 according to aspects of the present disclosure may further include at least one first compensation line AUX1 connected in parallel with at least a portion of the first anode extension line AEL1 having the greatest resistance to compensate for a difference in resistance. The compensation line may be provided in addition, or as an alternative, to varying the resistance per unit length of the extension line itself as described above.

The total resistance of a connection path between the first pixel circuit SPC1 and the first anode electrode AE1 becomes equal to a combined resistance of the first anode extension line AEL1 and the at least one first compensation line AUX1, which are connected in parallel. The total resistance of the connection path between the first pixel circuit SPC1 and the first anode electrode AE1 may be less than the resistance of the first anode extension line AEL1 to which the at least one first compensation line AUX1 is not connected in parallel.

Referring to FIG. 14, the first anode electrode AE1 may be disposed in the first optical area OA1 and may be included in the first light emitting element ED1 disposed in the first optical area OA1.

Referring to FIG. 14, in one or more embodiments, the display panel 110 according to aspects of the present disclosure may further include at least one second compensation line AUX2 connected in parallel with at least a portion of the second anode extension line AEL2 to compensate for a difference in resistance.

Referring to FIG. 14, the length of the second anode extension line AEL2 may be less than that of the first anode extension line AEL1, and the resistance of the second anode extension line AEL2 may be also less than that of the first anode extension line AEL1.

Accordingly, the at least one second compensation line AUX2 may have a different resistance from the at least one first compensation line AUX1.

A combined resistance of the second anode extension line AEL2 and the at least one second compensation line AUX2 may be the same, or substantially the same, as that of the first anode extension line AEL1 and the at least one first compensation line AUX1.

Referring to FIG. 14, in one or more embodiments, in the display panel 110 according to aspects of the present disclosure, a compensation line may not be connected in parallel to the third anode extension line AEL3 to compensate for a difference in resistance. For example, in an example where the third anode electrode AE3 is disposed in the first optical bezel area OBA1, a compensation line may not be connected in parallel to the third anode extension line AEL3.

The resistance of the third anode extension line AEL3 may be the same, or substantially the same, as the combined (parallel) resistance of the second anode extension line AEL2 and the at least one second compensation line AUX2, or the combined (parallel) resistance of the first anode extension line AEL1 and the at least one first compensation line AUX1.

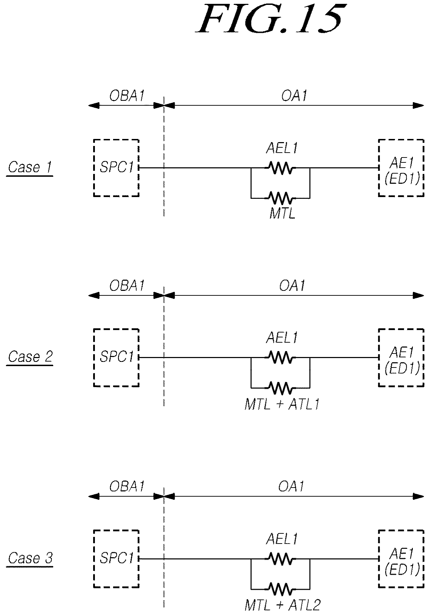

FIG. 15 illustrates example resistance difference compensation structures for compensating for a difference in resistance between anode extension lines in the display panel 110 according to aspects of the present disclosure.

Referring to FIG. 15, at least one first compensation line AUX1 may include a metal line MTL or may include a metal line MTL and a semiconductor material line (ATL1 or ATL2). For example, the semiconductor material line may include a conductivity-enabled semiconductor material. The conductivity-enabled semiconductor material may be a semiconductor material doped with a specific dopant through an ion implantation process. For example, the specific dopant may include a group-III element (e.g., boron (B)) or a group-V element (e.g., Phosphorus (P)). The first semiconductor material included in the first semiconductor material line ATL1 may include an oxide semiconductor material, and the second semiconductor material included in the second semiconductor material line ATL2 may include a silicon-based semiconductor material (e.g., LTPS). Alternatively, the first semiconductor material included in the first semiconductor material line ATL1 may include a silicon-based semiconductor material (e.g., LTPS), and the second semiconductor material included in the second semiconductor material line ATL2 may include an oxide semiconductor material. A dopant used when conducting a silicon-based semiconductor material (e.g., LTPS) may be different from a dopant used when conducting an oxide semiconductor material. For example, a dopant used when conducting a silicon-based semiconductor material may include a group-V element (e.g., Phosphorus (P)), and a dopant used when conducting an oxide semiconductor material may include a group-III element (e.g., boron (B)).

For example, as shown in FIG. 15, the configuration of the first compensation line AUX1 may include three cases (Case 1, Case 2, and Case 3).

Referring to FIG. 15, in Case 1, the first compensation line AUX1 may be a metal line MTL.

Referring to FIG. 15, in Case 2, the first compensation line AUX1 may include a metal line MTL and a first semiconductor material line ATL1.

For example, the metal line MTL and the first semiconductor material line ATL1 may be connected in series or in parallel.

In an example where the metal line MTL and the first semiconductor material line ATL1 are connected in series, a first line part of the first anode extension line AEL1 may be connected in parallel to the metal line MTL and the first semiconductor material line ATL1, which are connected in series.

In an example where the metal line MTL and the first semiconductor material line ATL1 are connected in parallel, the first line part of the first anode extension line AEL1 and the metal line MTL may be connected in parallel, and the first line part of the first anode extension line AEL1 and the first semiconductor material line ATL1 may be connected in parallel.

In another example, the metal line MTL and the first semiconductor material line ATL1 may be connected in parallel to respective parts of the first anode extension line AEL1. In this example, a first line part of the first anode extension line AEL1 and the metal line MTL may be connected in parallel, and a second line part of the first anode extension line AEL1 and the first semiconductor material line ATL1 may be connected in parallel. In this example, the first line part and the second line part may be different parts of the first anode extension line AEL1.

Referring to FIG. 15, in Case 3, the first compensation line AUX1 may include a metal line MTL and a second semiconductor material line ATL2.

For example, the metal line MTL and the second semiconductor material line ATL2 may be connected in series or in parallel.

In an example where the metal line MTL and the second semiconductor material line ATL2 are connected in series, a first line part of the first anode extension line AEL1 may be connected in parallel to the metal line MTL and the second semiconductor material line ATL2, which are connected in series.

In an example where the metal line MTL and the second semiconductor material line ATL2 are connected in parallel, the first line part of the first anode extension line AEL1 and the metal line MTL may be connected in parallel, and the first line part of the first anode extension line AEL1 and the second semiconductor material line ATL2 may be connected in parallel.

In another example, the metal line MTL and the second semiconductor material line ATL2 may be connected in parallel to respective parts of the first anode extension line AEL1. In this example, a first line part of the first anode extension line AEL1 and the metal line MTL may be connected in parallel, and a second line part of the first anode extension line AEL1 and the second semiconductor material line ATL2 may be connected in parallel. In this example, the first line part and the second line part may be different parts of the first anode extension line AEL1.

Referring to FIG. 15, all or a portion of the first anode extension line AEL1 may be disposed in the first optical area OA1.

Referring to FIG. 15, all or part of the at least one first compensation line AUX1 may be disposed in the first optical area OA1. In one or more embodiments, a portion of the at least one first compensation line AUX1 may be disposed in the first optical bezel area OBA1.

Referring to FIG. 15, a first semiconductor material included in the first semiconductor material line ATL1 and a second semiconductor material included in the second semiconductor material line ATL2 may be different from each other. For example, the first semiconductor material may include an oxide semiconductor material, and the second semiconductor material may include a silicon-based semiconductor material (e.g., low-temperature polycrystalline silicon (LTPS)). In another example, the first semiconductor material may include a silicon-based semiconductor material (e.g., low-temperature polycrystalline silicon (LTPS)), and the second semiconductor material may include an oxide semiconductor material.

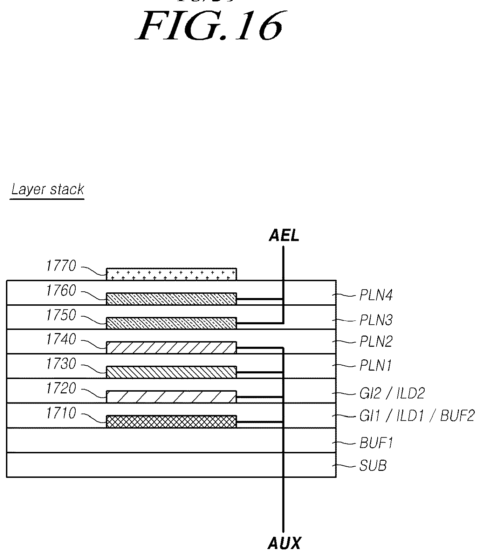

Hereinafter, to describe an example stackup configuration for the resistance difference compensation structure briefly described above with reference to FIG. 15, a layer stack related to forming such a resistance difference compensation structure will be briefly described first with reference to FIG. 16.

FIG. 16 illustrates an example layer stack for a resistance difference compensation structure for compensating for a difference in resistance between anode extension lines in the display panel 110 according to aspects of the present disclosure.

Referring to FIG. 16, in one or more embodiments, the display panel 110 according to aspects of the present disclosure may include a plurality of insulating layers. For example, in one or more embodiments, the display panel 110 may include a substrate SUB, a first buffer layer BUF1 on the substrate SUB, a first gate insulating layer GI1 on the first buffer layer BUF1, a first interlayer insulating layer ILD1 on the first gate insulating layer GI1, a second buffer layer BUF2 on the first interlayer insulating layer ILD1, a second gate insulating layer GI2 on the second buffer layer BUF2, a second interlayer insulating layer ILD2 on the second gate insulating layer GI2, a first planarization layer PLN1 on the second interlayer insulating layer ILD2, and a second planarization layer PLN2 on the first planarization layer PLN1, a third planarization layer PLN3 on the second planarization layer PLN2, and a fourth planarization layer PLN4 on the third planarization layer PLN3.

It should be noted that although the third planarization layer PLN3 and the fourth planarization layer PLN4 are not shown in FIGS. 8 and 9, the third planarization layer PLN3 and the fourth planarization layer PLN4 may be additionally disposed on the second planarization layer PLN2.

Referring to FIG. 16, in one or more embodiments, the display panel 110 according to aspects of the present disclosure may include a first active layer 1710, a second active layer 1720, a first metal layer 1730, a second metal layer 1740, a first transparent conductive material layer 1750, a second transparent conductive material layer 1760, and an anode electrode material layer 1770.

The first active layer 1710 may be disposed between the first buffer layer BUF1 and the first gate insulating layer GI1 and include a first semiconductor material. The first active layer 1710 may be a layer in which a first semiconductor material line ATL1 included in a compensation line AUX is formed.

The second active layer 1720 may be disposed between the second buffer layer BUF2 and the second gate insulating layer GI2 and include a second semiconductor material. The second active layer 1720 may be a layer in which a second semiconductor material line ATL2 included in the compensation line AUX is formed.

The first metal layer 1730 may be disposed between the second interlayer insulating layer ILD2 and the first planarization layer PLN1. The first metal layer 1730 may be a layer in which a metal line MTL included in the compensation line AUX is formed. For example, the first metal layer 1730 may be a first source-drain material layer in which source and drain electrodes of a transistor are formed.

The second metal layer 1740 may be disposed between the first planarization layer PLN1 and the second planarization layer PLN2. The first metal layer 1730 may be a layer in which a metal line MTL included in the compensation line AUX is formed. For example, the second metal layer 1740 may be a second source-drain material layer in which source and drain electrodes of a transistor are formed.

The first transparent conductive material layer 1750 may be disposed between the second planarization layer PLN2 and the third planarization layer PLN3. The first transparent conductive material layer 1750 may be a layer in which an anode extension line AEL is formed. For example, the first transparent conductive material layer 1750 may include a transparent conductive oxide. The transparent conductive oxide may include, for example, one or more of indium zinc oxide (IZO), indium tin oxide (ITO), indium-gallium-zinc oxide (IGZO), zinc oxide (ZnO), aluminum-doped zinc oxide (AZO), gallium-doped zinc oxide (GZO), antimony tin oxide (ATO), fluorine-doped transparent oxide (FTO), and the like.

The second transparent conductive material layer 1760 may be disposed between the third planarization layer PLN3 and the fourth planarization layer PLN4. The second transparent conductive material layer 1760 may be a layer in which the anode extension line AEL is formed.

For example, the second transparent conductive material layer 1760 may include a transparent conductive oxide. The transparent conductive oxide may include, for example, one or more of indium zinc oxide (IZO), indium tin oxide (ITO), indium-gallium-zinc oxide (IGZO), zinc oxide (ZnO), aluminum-doped zinc oxide (AZO), gallium-doped zinc oxide (GZO), antimony tin oxide (ATO), fluorine-doped transparent oxide (FTO), and the like.

The anode electrode material layer 1770 may be disposed on the fourth planarization layer PLN4.

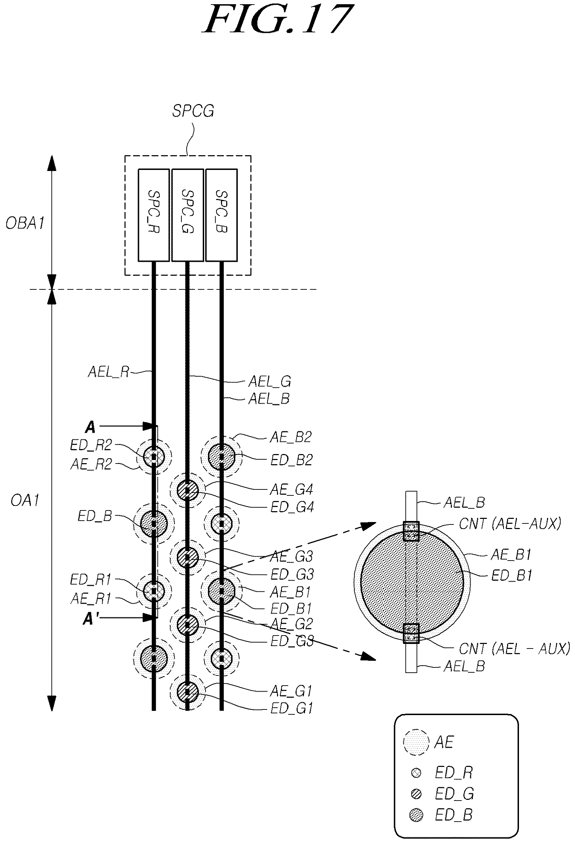

Hereinafter, to describe example stackup configurations for the resistance difference compensation structure, a planar structure corresponding to a stackup configuration will be described with reference to FIG. 17.

FIG. 17 is an example plan view for explaining a resistance difference compensation structure for compensating for a difference in resistance between anode extension lines in the display panel 110 according to aspects of the present disclosure.

Referring to FIG. 17, a pixel circuit group SPCG may be disposed in the first optical bezel area OBA1, and the pixel circuit group SPCG may include a red pixel circuit SPC_R, a green pixel circuit SPC_G, and a blue pixel circuit SPC_B. Here, the terms "red", "green", and "blue" in the "red pixel circuit", the "green pixel circuit", and the "blue pixel circuit" refer to indications for distinguishing the pixel circuits from each other.

Referring to FIG. 17, a plurality of red light emitting elements ED_R, a plurality of green light emitting elements ED_G, and a plurality of blue light emitting elements ED_B may be disposed in the first optical area OA1. Here, the terms "red", "green", and "blue" in the "red light emitting elements", the "green light emitting elements", and the "blue light emitting elements" refer to indications for distinguishing the light emitting elements from each other.

Referring to FIG. 17, the red pixel circuit SPC_R may be connected to at least one of first and second red light emitting elements (ED_R1 and ED_R2) through a red anode extension line AEL_R. The first and second red light emitting elements (ED_R1 and ED_R2) may be red light emitting elements ED_R adjacent to each other in a column direction (or a row direction) among the red light emitting elements ED_R.

For example, the red pixel circuit SPC_R may be connected to the first red light emitting element ED_R1 or to the first and second red light emitting elements (ED_R1 and ED_R2) through the red anode extension line AEL_R. Here, the term "red" in the "red anode electrode line" refers to an indication for distinguishing from other anode electrode lines.

Accordingly, the red pixel circuit SPC_R may be connected to a first red anode electrode AE_R1 of the first red light emitting element ED_R1, or be connected to first and second red anode electrodes (AE_R1 and AE_R2) of the first and second red light emitting elements (ED_R1 and ED_R2), through the red anode extension line AEL_R. Here, the term "red" in the "red anode electrode" refers to an indication for distinguishing from other anode electrodes.

Referring to FIG. 17, the red anode extension line AEL_R may be disposed under the first red light emitting element ED_R1. The red anode extension line AEL_R may be electrically connected to the first red light emitting element ED_R1 at a first connection point.

Referring to FIG. 17, a compensation line AUX for compensating for a resistance difference may be disposed under the red anode extension line AEL_R. The compensation line AUX may be connected in parallel with the red anode extension line AEL_R through at least two contact holes CNT. For example, the compensation line AUX may overlap the first red light emitting element ED_R1.

Referring to FIG. 17, the green pixel circuit SPC_G may be connected to at least one of first, second, third, and fourth green light emitting elements (ED_G1, ED_G2, ED_G3, and ED_G4) through a green anode extension line AEL_G. The first, second, third, and fourth green light emitting elements (ED_G1, ED_G2, ED_G3, and ED_G4) may be green light emitting elements ED_R adjacent to each other in the column direction (or the row direction) among the green light emitting elements ED_G.

For example, the green pixel circuit SPC_G may be connected to the first green light emitting element ED_G1 or to the first, second, third, and fourth green light emitting elements (ED_G1, ED_G2, ED_G3, and ED_G4) through the green anode extension line AEL_G. Here, the term "green" in the "green anode electrode line" refers to an indication for distinguishing from other anode electrode lines.

Accordingly, the green pixel circuit SPC_G may be connected to a first green anode electrode AE_G1 of the first green light emitting element ED_G1, or to two or more of first, second, third, and fourth anode electrodes (AE_G1, AE_G2, AE_G3, and AE_G4) of the first, second, third, and fourth green light emitting elements (ED_G1, ED_G2, ED_G3, and ED_G4), through the green anode extension line AEL_G. Here, the term "green" in the "green anode electrode" refers to an indication for distinguishing from other anode electrodes.

Referring to FIG. 17, the green anode extension line AEL_G may be disposed under the first green light emitting element ED_G1. The green anode extension line AEL_G may be electrically connected to the first green light emitting element ED_G1 at a first connection point.

Referring to FIG. 17, a compensation line AUX for compensating for a resistance difference may be disposed under the green anode extension line AEL_G. The compensation line AUX may be connected in parallel with the green anode extension line AEL_G through at least two contact holes CNT. For example, the compensation line AUX may overlap the first green light emitting element ED_G1.

Referring to FIG. 17, the blue pixel circuit SPC_B may be connected to at least one of first and second blue light emitting elements (ED_B1 and ED_B2) through a blue anode extension line AEL_B. The first and second blue light emitting elements (ED_B1 and ED_B2) may be blue light emitting elements ED_B adjacent to each other in the column direction (or the row direction) among the blue light emitting elements ED_B.

For example, the blue pixel circuit SPC_B may be connected to the first blue light emitting element ED_B1 or to the first and second blue light emitting elements (ED_B1 and ED_B2) through the blue anode extension line AEL_B. Here, the term "blue" in the "blue anode electrode line" refers to an indication for distinguishing from other anode electrode lines.

Accordingly, the blue pixel circuit SPC_B may be connected to a first blue anode electrode AE_B1 of the first blue light emitting element ED_B1, or be connected to first and second blue anode electrodes (AE_B1 and AE_B2) of the first and second blue light emitting elements (ED_B1 and ED_B2), through the blue anode extension line AEL_B. Here, the term "blue" in the "blue anode electrode" refers to an indication for distinguishing from other anode electrodes.

Referring to FIG. 17, the blue anode extension line AEL_B may be disposed under the first blue light emitting element ED_B1. The blue anode extension line AEL_B may be electrically connected to the first blue light emitting element ED_B1 at a first connection point.

Referring to FIG. 17, a compensation line AUX for compensating for a resistance difference may be disposed under the blue anode extension line AEL_B. The compensation line AUX may be connected in parallel with the blue anode extension line AEL_B through at least two contact holes CNT. For example, the compensation line AUX may overlap the first blue light emitting element ED_B1.

Hereinafter, various examples for a stackup configuration taken along line A-A' of FIG. 17 will be discussed with respect to Cases 1, 2, and 3 of FIG. 15.

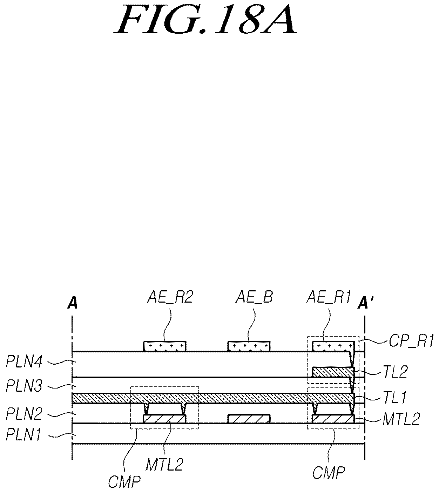

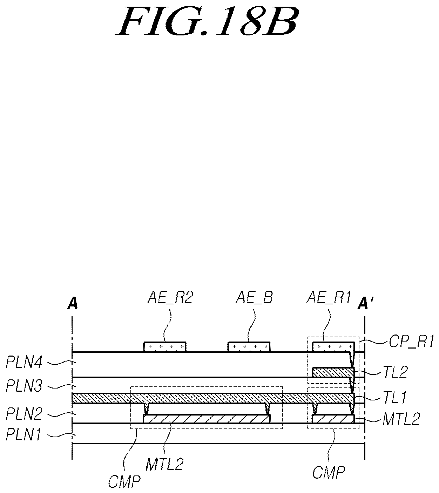

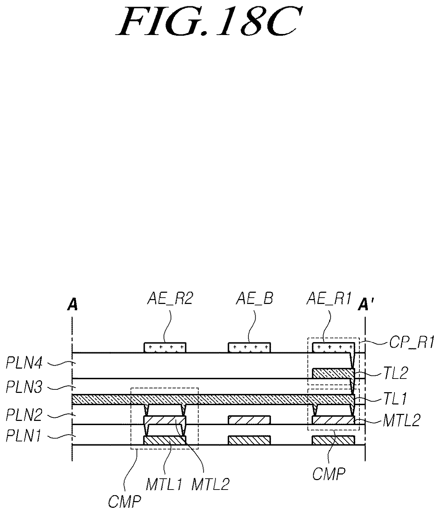

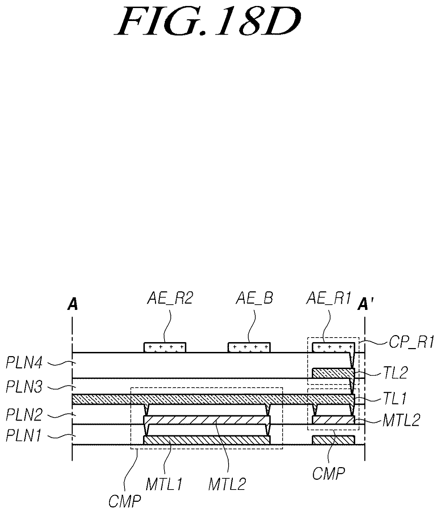

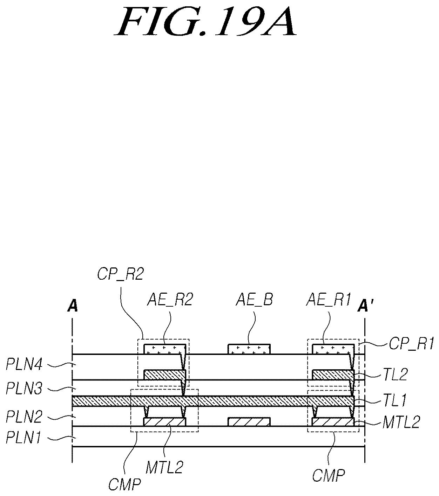

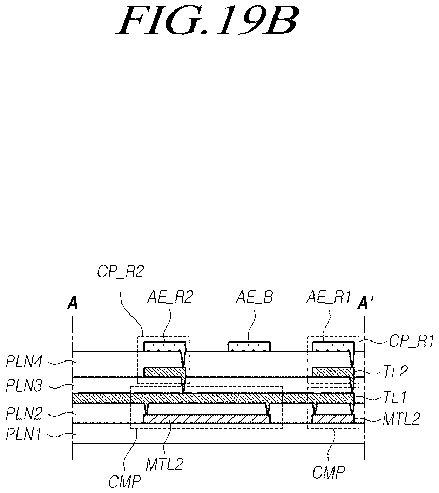

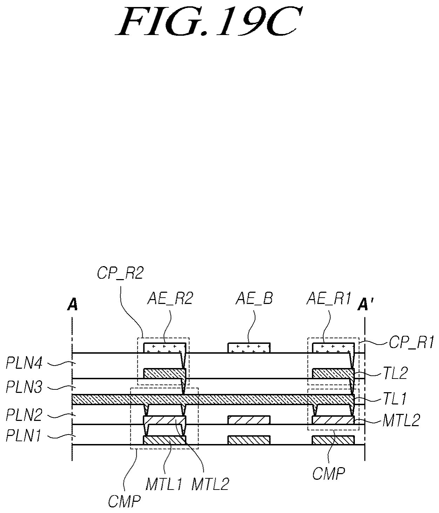

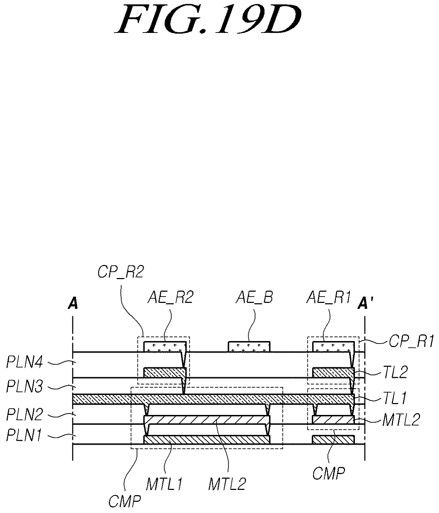

FIGS. 18A, 18B, 18C, and 18D are example cross-sectional views of the resistance difference compensation structures according to Case 1 of FIG. 15. FIGS. 19A, 19B, 19C, and 19D are example other cross-sectional views of the resistance difference compensation structure according to Case 1 of FIG. 15.

FIGS. 18A, 18B, 18C, and 18D are cross-sectional views of a case where the red pixel circuit SPC_R of FIG. 17 drives the first red light emitting element ED_R1, and FIGS. 19A, 19B, 19C, and 19D are cross-sectional views of a case where the red pixel circuit SPC_R of FIG. 17 drives the first red light emitting device ED_R1 and the second red light emitting device ED_R2.

Hereinafter, for convenience of description, the red anode extension line AEL_R of FIG. 17 is simply referred to as an anode extension line AEL_R, and the first and second red anode electrodes (AE_R1 and AE_R2) of FIG. 17 are referred to as first and second anode electrodes (AE_R1 and AE_R2). Another anode electrode AE_B may be disposed between first and second anode electrodes AE_R1 and AE_R2.

Referring to FIGS. 18A, 18B, 18C, and 18D, at least a portion of an anode extension line AEL_R may be disposed in the first optical area OA1. For example, the anode extension line AEL_R may include a first transparent line TL1 disposed in the first transparent conductive material layer 1750.

Referring to FIGS. 18A, 18B, 18C, and 18D, the anode extension line AEL_R may further include a second transparent line TL2 disposed in the second transparent conductive material layer 1760.

Referring to FIGS. 18A, 18B, 18C, and 18D, the second transparent line TL2 may be located closer to the first anode electrode AE_R1 than the first transparent line TL1. That is, , the second transparent line TL2 may be, in cross-sectional view, located closer to the first anode electrode AE_R1 than the first transparent line TL1. That is, the layer having the second transparent line TL2 may be closer to the layer having the first anode electrode AE_R1 than the layer having the first transparent line TL1. When the term "closer to" is used in this disclosure, it may be understood to mean 'closer to in the thickness direction of the layers of the display device'.

Referring to FIGS. 18A, 18B, 18C, and 18D, the second transparent line TL2 may be connected to the first anode electrode AE_R1 through a hole of the fourth planarization layer PLN4 at a first connection point CP_R1.

Referring to FIGS. 18A, 18B, 18C, and 18D, the second transparent line TL2 may be connected to the first transparent line TL1 through a hole of the third planarization layer PLN3. Therefore, the second transparent line TL2 acts as a buffer layer or buffer connection between the anode electrode AE_R1 and the first transparent line TL1, thereby improving the reliability and/or quality of the connection between the anode electrode AE_R1 and the first transparent line TL1.

Referring to FIGS. 18A, 18B, 18C, and 18D, at least one compensation line AUX may include a respective second metal line MTL2 located in the second metal layer 1740. One or more second metal lines MTL2 may be connected in parallel with the first transparent line TL1 at one or more compensation points CMP.

Referring to FIGS. 18C and 18D, the at least one compensation line AUX may further include a respective first metal line MTL1 located in the first metal layer 1730. One or more first metal lines MTL1 may be connected in parallel with the one or more second metal lines MTL2 at one or more compensation points CMP.

Referring to FIG. 18D, at least one metal line among the one or more first metal lines MTL1 and the one or more second metal lines MTL2 may have a different length or width from the remaining one or more metal lines.

As the first metal line MTL1 and the first transparent line TL1, which correspond to each other (e.g., which are parallel to each other), are connected at two points, the first metal line MTL1 and the first transparent line TL1 may be connected in parallel. In this implementation, the two points are spaced apart from each other. A separation distance between the two points may depend on an amount of compensating for a difference in resistance.

As the second metal line MTL2 and the first metal line MTL1, which correspond to each other (e.g., which are parallel to each other), are connected at two points, the second metal line MTL2 and the first metal line MTL2 may be connected in parallel. In this implementation, the two points are spaced apart from each other. A separation distance between the two points may depend on an amount of compensating for a difference in resistance. Thus, the compensation line extending between the two points may have a length which is dependent on the amount of compensation required.

Referring to FIGS. 18A, 18B, 18C, and 18D, the at least one compensation line AUX may overlap the first anode electrode AE_R1 or other anode electrodes (AE_R2 and AE_B) different from the first anode electrode AE_R1.

As described above, FIGS. 18A, 18B, 18C, and 18D are cross-sectional views of a case where the red pixel circuit SPC_R of FIG. 17 drives the first red light emitting element ED_R1, and FIGS. 19A, 19B, 19C, and FIG. 19D are cross-sectional views of a case where the red pixel circuit SPC_R of FIG. 17 drives the first red light emitting device ED_R1 and the second red light emitting device ED_R2.

Accordingly, referring to FIGS. 19A, 19B, 19C, and 19D, one portion of the second transparent line TL2, or the second transparent line TL2, may be connected to the first anode electrode AE_R1 at the first connection point CP_R1, and another portion of the second transparent line TL2, or another second transparent line TL2, may be connected to the second anode electrode AE_R2 at a second connection point CP_R2.

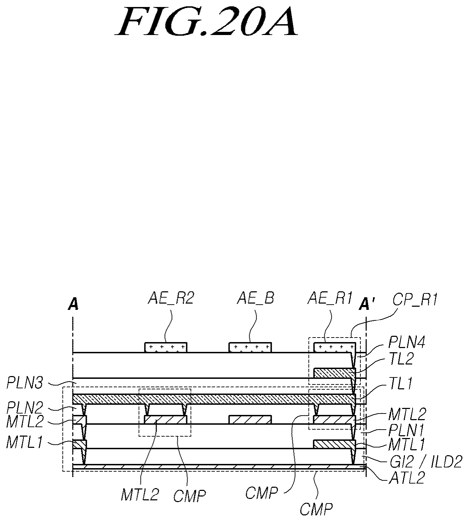

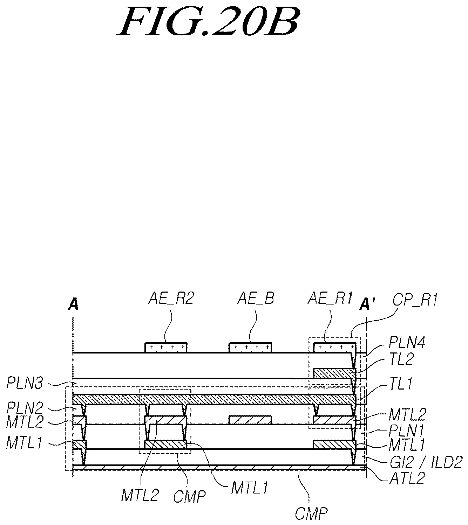

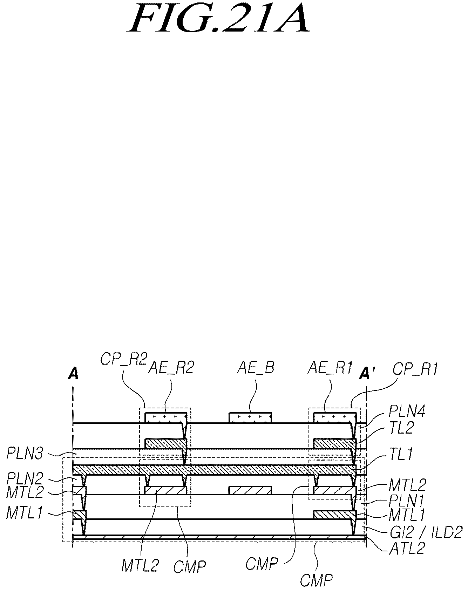

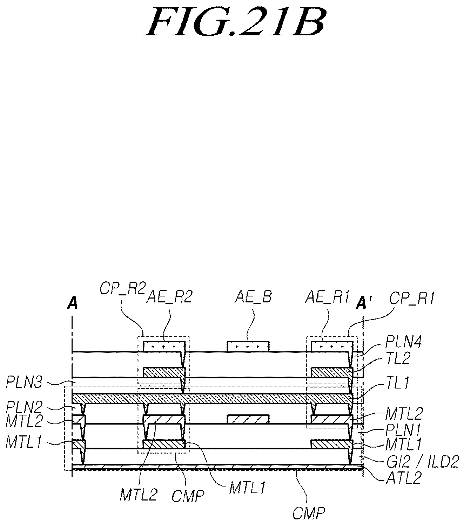

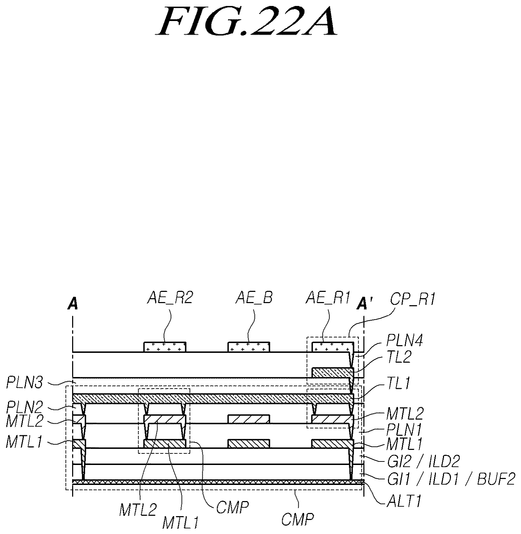

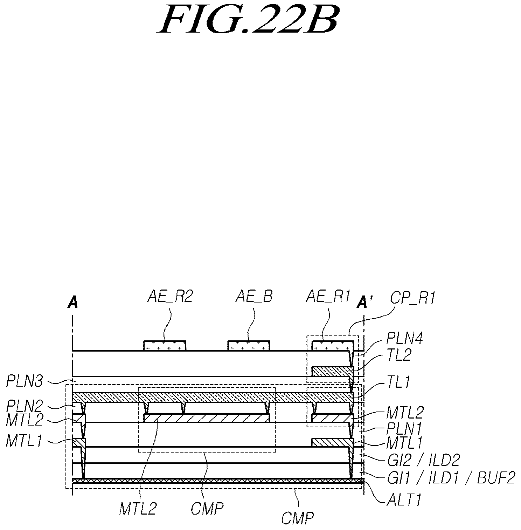

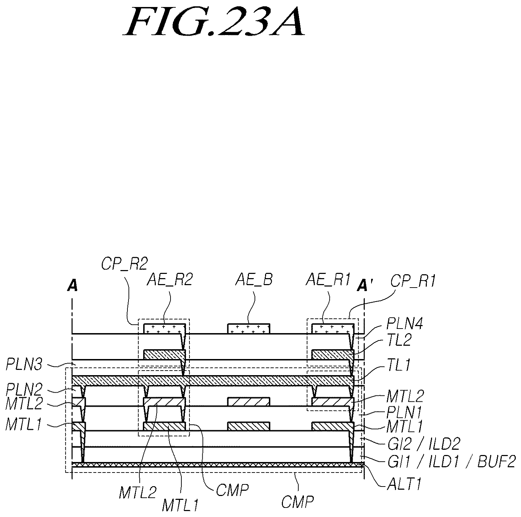

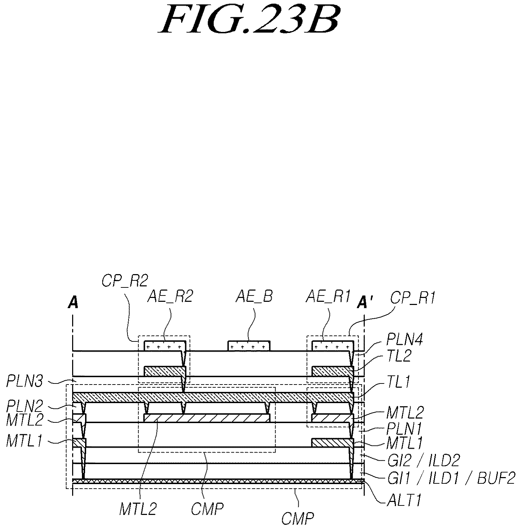

FIGS. 20A and 20B are example cross-sectional views of the resistance difference compensation structure according to Case 2 of FIG. 15. FIGS. 21A and 21B are example other cross-sectional views of the resistance difference compensation structure according to Case 2 of FIG. 15. FIGS. 22A and 22B are example cross-sectional views of the resistance difference compensation structure according to Case 3 of FIG. 15. FIGS. 23Aand 23B are example other cross-sectional views of the resistance difference compensation structure according to Case 3 of FIG. 15.

FIGS. 20A, 20B, 22A, and 22B are cross-sectional views of a case where the red pixel circuit SPC_R of FIG. 17 drives the first red light emitting element ED_R1, and FIGS. 21A, 21B, 23A, and 23B are cross-sectional views of a case where the red pixel circuit SPC_R of FIG. 17 drives the first red light emitting device ED_R1 and the second red light emitting device ED_R2.

Referring to FIGS. 20A, 20B, 21A, 21B, 22A, 22B, 23A, and 23B, at least one compensation line AUX may include one or more semiconductor material lines (ATL1 and/or ATL2) resulting from conductivity-enabling of one or more semiconductor materials, in addition to one or more first metal lines MTL1 and one or more second metal lines MTL2.

Referring to FIGS. 20A, 20B, 21A, 21B, 22A, 22B, 23A, and 23B, the one or more semiconductor material lines (ATL1 and/or ATL2) may be disposed in at least one of the first and second active layers (1710 and/or 1720) located under the first metal layer 1730.

Referring to FIGS. 20A, 20B, 21A, 21B, 22A, 22B, 23A, and 23B, the at least one compensation line AUX may further include at least one of a first semiconductor material ATL1 resulting from conductivity-enabling of a first semiconductor material of the first active layer 1710 and a second semiconductor material line ATL2 resulting from conductivity-enabling of a second semiconductor material of the second active layer 1720.

The first semiconductor material and the second semiconductor material may be different from each other. For example, the first semiconductor material may include an oxide semiconductor material, and the second semiconductor material may include a silicon-based semiconductor material (e.g., low-temperature polycrystalline silicon (LTPS)). In another example, the first semiconductor material may include a silicon-based semiconductor material (e.g., low-temperature polycrystalline silicon (LTPS)), and the second semiconductor material may include an oxide semiconductor material.

Referring to FIGS. 20A and 20B, the second semiconductor material line ATL2 may include a second semiconductor material and may be disposed in the second active layer 1720 located under the first metal layer 1730.

For example, the second semiconductor material included in the second active layer 1720 may include an oxide semiconductor material. The second semiconductor material included in the second active layer 1720 may be included in an active layer of a transistor included in any pixel circuit SPC (e.g., the active layer ACT2 of the driving transistor DT2 of FIG. 8).

Referring to FIGS. 20A and 20B, a second transparent line TL2 may be connected to the first anode electrode AE_R1 at a first connection point CP_R1.

Referring to FIGS. 21Aand 21B, one portion of a second transparent line TL2, or the second transparent line TL2, may be connected to the first anode electrode AE_R1 at the first connection point CP_R1, and another portion of the second transparent line TL2, or another second transparent line TL2, may be connected to the second anode electrode AE_R2 at a second connection point CP_R2.

Referring to FIGS. 22A and 22B, the first semiconductor material line ATL1 may include a first semiconductor material and may be disposed in the first active layer 1710 located under the first metal layer 1730.

For example, the first semiconductor material included in the first active layer 1710 may include a silicon-based semiconductor material other than an oxide semiconductor material. The first semiconductor material included in the first active layer 1710 may be included in an active layer of a transistor included in any pixel circuit SPC (e.g., the active layer ACT1 of the driving transistor DT1 of FIG. 8).

Referring to FIGS. 22A and 22B, a second transparent line TL2 may be connected to the first anode electrode AE_R1 at a first connection point CP_R1.

Referring to FIGS. 23A and 23B, one portion of a second transparent line TL2, or the second transparent line TL2, may be connected to the first anode electrode AE_R1 at the first connection point CP_R1, and another portion of the second transparent line TL2, or another second transparent line TL2, may be connected to the second anode electrode AE_R2 at a second connection point CP_R2.

Referring to FIGS. 20A and 20B, at one or more compensation points CMP, a first transparent line TL1 may be connected in parallel with one or more second metal lines MTL2, and the one or more second metal lines MTL2 may be connected in parallel with one or more first metal lines MTL1, and the one or more first metal lines MTL1 may be connected in parallel with the second semiconductor material line ATL2.

Referring to FIGS. 22A and 22B, at one or more compensation points CMP, a first transparent line TL1 may be connected in parallel with one or more second metal lines MTL2, and the one or more second metal lines MTL2 may be connected in parallel with one or more first metal lines MTL1, and the one or more first metal lines MTL1 may be connected in parallel with the second semiconductor material line ATL2.

Referring to FIGS. 18C and 18D, the at least one compensation line AUX may further include one or more first metal lines MTL1 located in the first metal layer 1730. The one or more first metal lines MTL1 may be connected in parallel with one or more second metal lines MTL2 at one or more compensation points CMP.

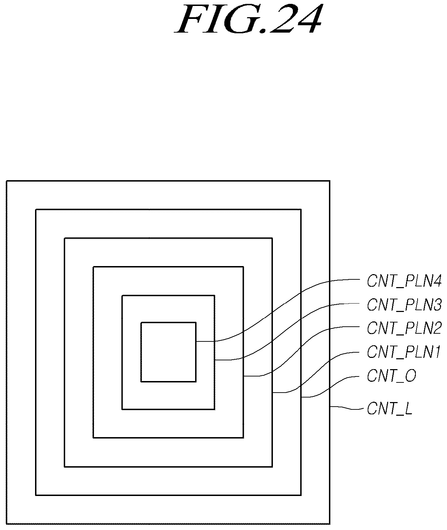

FIG. 24 illustrates an example configuration in which various contact holes used in a resistance difference compensation structure for compensating for a difference in resistance between anode extension lines are overlapped in the display panel 110 according to aspects of the present disclosure.

Referring to FIG. 24, a hole (contact hole) of at least one insulating layer among various insulating layers (PLN1, PLN2, PLN3, PLN4, GI2 and/orILD2, and/or GI1 and/or ILD1 and/or BUF2) can be utilized to form a resistance difference compensation structure based on the stackup configurations of the foregoing figures including FIG. 16.

Referring to FIG. 24, the fourth planarization layer PLN4 may include a contact hole CNT_PLN4 for a connection between a second transparent line TL2 and an anode electrode AE.

Referring to FIG. 24, the third planarization layer PLN3 may include a contact hole CNT_PLN3 for a connection between the second transparent line TL2 and a first transparent line TL1.

Referring to FIG. 24, the second planarization layer PLN2 may include a contact hole CNT_PLN2 for a connection between the first transparent line TL1 and a second metal line MTL2.

Referring to FIG. 24, the first planarization layer PLN1 may include a contact hole CNT_PLN1 for a connection between the second metal line MTL2 and a first metal line MTL1.

Referring to FIG. 24, a contact hole CNT_O penetrating both the second gate insulating layer GI2 and the second interlayer insulating layer ILD2 may be formed for a connection between the first metal line MTL1 and a second semiconductor material line ATL2.

Referring to FIG. 24, a contact hole CNT_L penetrating all of the second gate insulating layer GI2, the second interlayer insulating layer ILD2, the first gate insulating layer GI1, the first interlayer insulating layer ILD1, and the second buffer layer BUF2 may be formed for a connection between the first metal line MTL1 and a first semiconductor material line ATL1.

Referring to FIG. 24, the contact holes may have larger sizes as points connected through the contact holes are closer to the substrate SUB. When one contact hole is formed by penetrating a plurality of insulating layers, that is, when one contact hole is formed by overlapping holes of each of the plurality of insulating layers, the hole diameter of the insulating layer close to the substrate may increase. For example, the plurality of insulating layers may include two or more of the fourth planarization layer PLN4, the third planarization layer PLN3, the second planarization layer PLN2, the first planarization layer PLN1, the second gate insulating layer GI2, the second interlayer insulating layer ILD2, the second gate insulating layer GI2, the second interlayer insulating layer ILD2, the first gate insulating layer GI1, the first interlayer insulating layer ILD1, and the second buffer layer BUF2.

In the foregoing, discussions have been provided on various features by focusing on the first optical area OA1 overlapping the first optical electronic device 11. Hereinafter, discussions will be provided on various features by focusing on the second optical area OA2 overlapping the second optical electronic device 12.

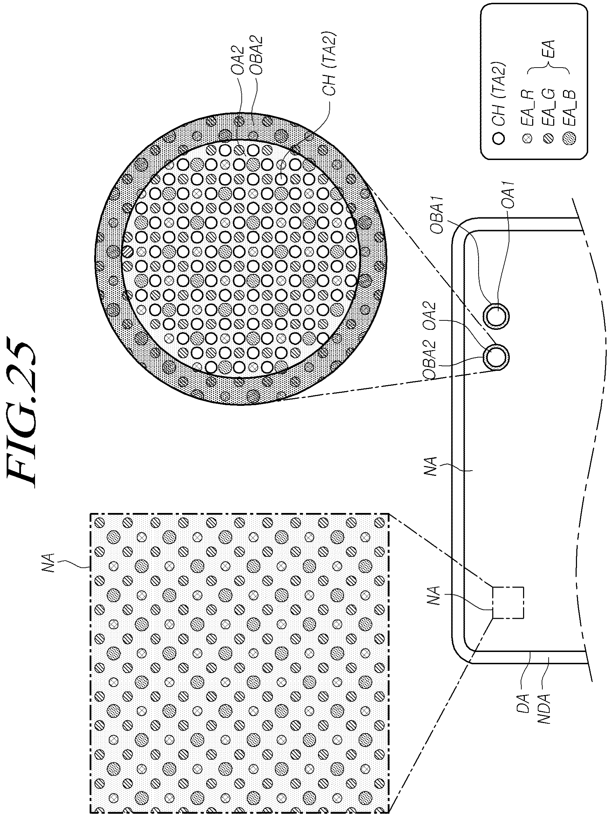

FIG. 25 schematically illustrates an example first type of second optical area OA2 and an example normal area NA around the first type of second optical area OA2 in the display panel 110 according to aspects of the present disclosure.

Referring to FIG. 25, the display area DA may further include a second optical area OA2 (e.g., the second optical area OA2 in the figures discussed above) adjacent to the first optical area OA1. The second optical area OA2 may also be implemented in the first type (anode extension type) as in the first optical area OA1.

In this implementation, the display area DA may further include a second optical bezel area OBA2 between the second optical area OA2 and the normal area NA.

Two or more light emitting elements ED may be disposed in each of the first optical area OA1 and the second optical area OA2.

Transistors may not be disposed in each of the first optical area OA1 and the second optical area OA2. Pixel circuits SPC for driving the two or more light emitting elements ED disposed in the second optical area OA2 may be disposed in the second optical bezel area OBA2.

All discussions described with reference to FIGS. 5 to 24 may be equally applied to the second optical area OA2 and the second optical bezel area OBA2. It should be however noted that transmittance (e.g. a transmittance per unit area) of the second optical area OA2 may be different from that of the first optical area OA1.

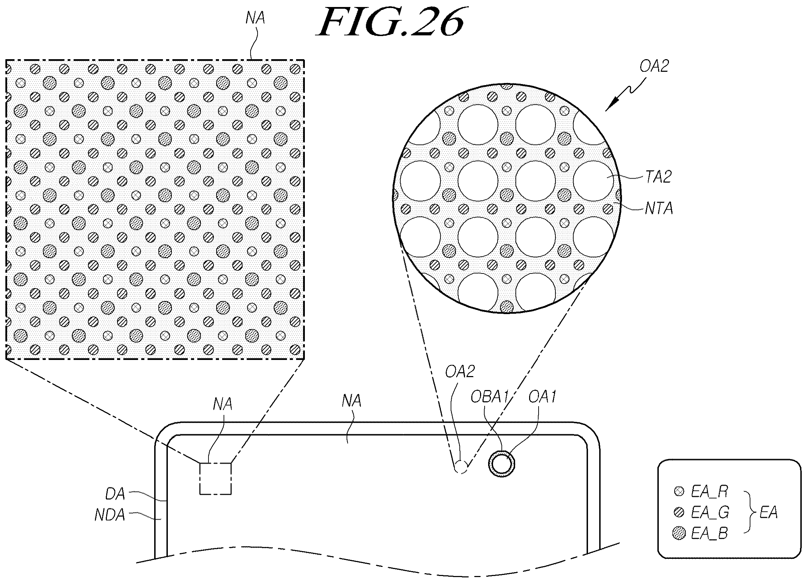

FIG. 26 schematically illustrates an example second type of second optical area OA2 and an example normal area NA around the second type of second optical area OA2 in the display panel 110 according to aspects of the present disclosure.

Referring to FIG. 26, the display area DA may include the second optical area OA2. In an example where the second optical area OA2 is implemented in the second type, the second optical area OA2 may include a plurality of transmission areas TA and a non-transmission area NTA. The second type may be also referred to as a hole type.

In the second optical area OA2, the non-transmission area NTA may represent an area except for the plurality of transmission areas TA.

Referring to FIG. 26, the non-transmission area NTA may include a plurality of light emitting areas EA. A plurality of light emitting elements ED for the plurality of light emitting areas EA may be disposed in the non-transmission area NTA.

Further, a plurality of pixel circuits SPC for driving the plurality of light emitting elements ED may be disposed in the non-transmission area NTA. For example, a plurality of pixel circuits SPC may be disposed in the second optical area OA2. This configuration is different from the configuration of the first optical area OA1 in which a plurality of pixel circuits SPC are not disposed.

Therefore, while a transistor (DT or ST) and a storage capacitor Cst may not be disposed in the first optical area OA1, one or more transistors (DT and ST) and one or more storage capacitors Cst may be disposed in the second optical area OA2.

In other words, two or more light emitting elements ED may be disposed in the first optical area OA1, and two or more light emitting elements ED may be disposed in the non-transmission area NTA of the second optical area OA2. While transistors may not be disposed in the first optical area OA1, transistors may be disposed in the second optical area OA2.

Referring to FIG. 26, an arrangement of light emitting areas EA in the second optical area OA2 may be the same or substantially or nearly the same as an arrangement of light emitting areas EA in the normal area NA, and be also the same or substantially or nearly the same as an arrangement of light emitting areas EA in the first optical area OA1.

One or more embodiments, referring to FIG. 26, an area of each of a plurality of light emitting areas EA included in the second optical area OA2 may be the same or substantially or nearly the same as, or be different within a predetermined range from, an area of each of a plurality of light emitting areas EA included in the normal area NA. The predetermined range may be a range value set in consideration of process variation.

One or more embodiments, the area of each of the plurality of light emitting areas EA included in the second optical area OA2 may be the same or substantially or nearly the same as, or be different within a predetermined range from, an area of each of a plurality of light emitting areas EA included in the first optical area OA1.

In an embodiment, all or at least a portion of the first optical area OA1 may overlap the first optical electronic device 11, and all or at least a portion of the second optical area OA2 may overlap the second optical electronic device 12.

The transmittance of the first optical area OA1 and the transmittance of the second optical area OA2 may be greater than that of the normal area NA.

The first optical electronic device 11 may be for example, a camera, and the second optical electronic device 12 may be, for example, a sensor different from the camera.

For example, the first optical electronic device 11 may be a device configured to receive visible light and perform a predetermined operation, and the second optical electronic device 12 may be a device configured to receive light (e.g., infrared light, and/or ultraviolet light) different from visible light and perform a predetermined operation.

For example, when the first optical electronic device 11 is a device that requires a greater amount of light than the second optical electronic device 12, the transmittance of the first optical area OA1 may be greater than or equal to the transmittance of the second optical area OA2.

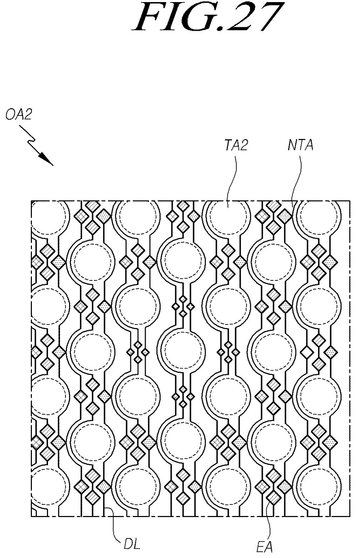

FIG. 27 is an example plan view of the second type of second optical area OA2 in the display panel 110 according to aspects of the present disclosure.

Referring to FIG. 27, in an example where the second optical area OA2 is implemented in the second type, the second optical area OA2 may include a non-transmission area NTA and a second transmission area TA2 except for the non-transmission area NTA.

The non-transmission area NTA may include a plurality of light emitting areas EA.

A respective light emitting element ED may be disposed in each of the plurality of light emitting areas EA.

A plurality of pixel circuits SPC for driving the plurality of light emitting elements ED may be disposed in the non-transmission area NTA.

In the second type of second optical area OA2, the light emitting elements ED and the pixel circuits SPC may partially overlap each other.

In the case of the second type of second optical area OA2, data lines DL and gate lines GL may run across the second optical area OA2. In FIG. 27, the gate lines GL are omitted, and when each of the data lines DL extends in the column direction, each of the gate lines GL may extend in the row direction.

The data lines DL and the gate lines GL may be disposed in the second optical area OA2 while avoiding the second transmission area TA2. That is, the data lines DL and gate lines GL may not cross the second transmission area TA2.

The data lines DL and the gate lines GL may be connected to the pixel circuits SPC disposed in the second optical area OA2.

The embodiments described above will be briefly described as follows.

According to aspects of the present disclosure, the display device 100 can be provided that includes: a first optical area included in a display area in which one or more images can be displayed and allowing light to be transmitted; a normal area included in the display area and located outside of the first optical area; a first optical bezel area included in the display area and located between the first optical area and the normal area; a first anode electrode of a first light emitting element disposed in the first optical area; a first pixel circuit disposed in the first optical bezel area; a first anode extension line electrically interconnecting the first anode electrode and the first pixel circuit; and at least one first compensation line connected in parallel with at least a portion of the first anode extension line.

One or more transistors may be disposed in the first optical bezel area, and a transistor may not be disposed in the first optical area.

At least a portion of the first anode extension line may be disposed in the first optical area, and the first anode extension line may include a first transparent line.

The first anode extension line may further include a second transparent line. The second transparent line may be located closer to the first anode electrode than the first transparent line.

The at least one first compensation line may include a metal line or may include a metal line and a semiconductor material line. The semiconductor material line may include a conductivity-enabled semiconductor material.

The display device 100 may further include a substrate, a first metal layer over the substrate, a first planarization layer on the first metal layer, a second metal layer on the first planarization layer, a second planarization layer on the second metal layer, and a transparent conductive material layer on the second planarization layer.

The first anode extension line may include a first transparent line disposed in the transparent conductive material layer.

The at least one first compensation line may include a metal line located in the second metal layer.

The at least one first compensation line may further include a metal line located in the first metal layer.

The display device 100 may further include an active layer located under the first metal layer.

The at least one first compensation line may include a semiconductor material line resulting from conductivity-enabling of a semiconductor material of the active layer. The at least one first compensation line may further comprise a semiconductor material line disposed in the active layer, and the semiconductor material line may include, in a conductive state, and the same semiconductor material as a semiconductor material for forming a channel of a transistor in the display area.

The display device 100 may further include a first buffer layer on the substrate, a first active layer on the first buffer layer, a second buffer layer on the first active layer, a second active layer on the second buffer layer, and a gate insulating layer on the second active layer.

The first metal layer may be located on the gate insulating layer.

The at least one first compensation line may include at least one of a first semiconductor material line resulting from conductivity-enabling of a first semiconductor material of the first active layer and a second semiconductor material line resulting from conductivity-enabling of a second semiconductor material of the second active layer.

The first semiconductor material and the second semiconductor material may be different from each other.

The at least one first compensation line may overlap the first anode electrode or one or more other anode electrodes different from the first anode electrode.

The display device 100 may further include a second anode electrode disposed in the first optical area, a second pixel circuit disposed in the first optical bezel area, and a second anode extension line electrically interconnecting the second anode electrode and the second pixel circuit.

The second anode extension line may have a shorter length than the first anode extension line.

The display device 100 may further include at least one second compensation line connected in parallel with at least a portion of the second anode extension line. The at least one second compensation line may have a different resistance from the at least one first compensation line.

The display device 100 may further include a third anode electrode disposed in the first optical bezel area, a third pixel circuit disposed in the first optical bezel area, and a third anode extension line electrically interconnecting the third anode electrode and the third pixel circuit. The third anode extension line may have a shorter length than the first anode extension line.

A compensation line may not be connected in parallel to the third anode extension line.

The display device may further include a cathode electrode commonly disposed in the normal area, the first optical bezel area, and the first optical area. The cathode electrode may include a plurality of cathode holes located in the first optical area.

The display device 100 may further include a bank located on the first anode electrode and having a bank hole exposing a portion of the first anode electrode, and an emission layer located on the bank and contacting the portion of the first anode electrode exposed through the bank hole.

The cathode electrode may be disposed on the emission layer.

An upper surface of the bank located under the plurality of cathode holes may be flat without being depressed or etched.

The display device may further include an encapsulation layer on the cathode electrode and touch sensor metals on the encapsulation layer.

The touch sensor metals may be disposed in the normal area and the first optical bezel area.

The display device 100 may further include a first optical electronic device overlapping the first optical area.

The first optical electronic device can receive light transmitting through the first optical area and perform a predefined operation by using the received light. The light received by the first optical electronic device may include at least one of visible light, infrared light, and ultraviolet light.

The display device 100 may further include a second optical area included in the display area. When the second optical area is implemented in a first type, the display device 100 may further include a second optical bezel area between the second optical area and the normal area.

Two or more light emitting elements may be disposed in each of the first optical area and the second optical area. Transistors may not be disposed in each of the first optical area and the second optical area.

The display device 100 may further include a second optical area included in the display area. In an example where the second optical area is implemented in a second type, the second optical area may include two or more transmission areas and a non-transmission area.

Two or more light emitting elements may be disposed in the first optical area. Two or more light emitting elements may be disposed in the non-transmission area of the second optical area.

A transistor may not be disposed in the first optical area. Transistors may be disposed in the second optical area.

According to aspects of the present disclosure, the display panel 110 can be provided that includes: a display area that includes an optical area allowing light to be transmitted and allows one or more images to be displayed; a light emitting element disposed in the optical area (a first optical area or a second optical area different from the first optical area); a pixel circuit disposed outside of the optical area; an extension line electrically interconnecting the light emitting element and the pixel circuit; and at least one compensation line connected with at least a portion of the extension line. The extension line may correspond to the anode extension line described above.

In the display panel, a transistor may not be disposed in the optical area.

The at least a portion of the extension line may be disposed in the optical area, and the extension line may include a transparent line.

The at least one compensation line may include a metal line.

The at least one compensation line may include a metal line and a semiconductor material line. The semiconductor material line may include a conductivity-enabled semiconductor material.

According to the embodiments described herein, the display panel 110 and the display device 100 may be provided that include a light transmission structure for enabling one or more optical electronic devices to normally receive light (e.g., visible light, infrared light, ultraviolet light, or the like) while not being exposed in a front surface of the display device 100.

According to the embodiments described herein, the display panel 110 and the display device 100 may be provided that are capable of more improving transmittance of an optical area by disposing light emitting elements in the optical area allowing light to be transmitted, but disposing pixel circuits for driving the light emitting elements of the optical area in an area outside of the optical area (e.g., an optical bezel area, a normal area).

According to the embodiments described herein, the display panel 110 and the display device 100 may be provided that include a structure of interconnecting, using anode extension lines including a transparent material, light emitting elements disposed in an optical area allowing light to be transmitted and pixel circuits (e.g., transistors included in the pixel circuits) disposed in an area outside of the optical area (e.g., an optical bezel area, a normal area), and thereby, are capable of increasingly improving transmittance of an optical area.

According to the embodiments described herein, the display panel 110 and the display device 100 may be provided that include a structure of connecting a compensation line in parallel to an anode extension line having a large resistance, and thereby, are capable of reducing a difference in resistance between anode extension lines and improving quality of images.

According to the embodiments described herein, the display panel 110 and the display device 100 may be provided that include a cathode electrode with a plurality of cathode holes located in an optical area, and thereby, increasingly improve the transmittance of the optical area, and prevent an area or element adjacent to the cathode holes from being damaged or varied in the process of forming the cathode holes.

Additional features and aspects will be set forth in part in the description which follows and in part will become apparent from the description or may be learned by practice of the inventive concepts provided herein. Other features and aspects of the inventive concepts may be realized and attained by the structure particularly pointed out in, or derivable from, the written description, the claims hereof, and the appended drawings.

Other systems, methods, features and advantages will be, or will become, apparent to one with skill in the art upon examination of the following figures and detailed description. It is intended that all such additional systems, methods, features and advantages be included within this description, be within the scope of the present disclosure, and be protected by the appended claims. Nothing in this section should be taken as a limitation on those claims.

It is to be understood that both the foregoing general description and the following detailed description of the present disclosure are exemplary and explanatory and are intended to provide further explanation of the inventive concepts as claimed.

The above description has been presented to enable any person skilled in the art to make and use the invention, and has been provided in the context of a particular application and its requirements. Various modifications, additions and substitutions to the described embodiments will be readily apparent to those skilled in the art, and the general principles defined herein may be applied to other embodiments and applications without departing from the scope of the invention as claimed. Although the exemplary embodiments have been described for illustrative purposes, a person skilled in the art will appreciate that various modifications and applications are possible without departing from the essential characteristics of the present disclosure. For example, the specific components of the exemplary embodiments may be variously modified. The above description and the accompanying drawings provide an example of the technical idea of the present invention for illustrative purposes only. That is, the disclosed embodiments are intended to illustrate the scope of the technical idea of the present disclosure. Thus, the scope of the present disclosure is not limited to the embodiments shown, but is to be accorded the widest scope consistent with the claims.

Also described herein are the following numbered clauses:
Clause 1. A display panel comprising:
   a display area arranged to display images, wherein the display area includes a first area allowing light to be transmitted;
   a first light emitting element disposed in the first area;
   a first pixel circuit disposed outside of the first area;
   a first extension line electrically interconnecting the first light emitting element and the first pixel circuit; and
   at least one first compensation line connected with at least a portion of the first extension line.
Clause 2. The display device of clause 1, wherein a transistor is not disposed in the first area, and
   wherein the at least a portion of the first extension line is disposed in the first area, and the first extension line comprises a transparent line.
Clause 3. The display device of clause 1, wherein one or more transistors are disposed outside the first area, and no transistor is disposed in the first area.
Clause 4. The display device of clause 1 or 2, wherein at least a portion of the first extension line is disposed in the first area, and the first extension line comprises a first transparent line, optionally wherein the first extension line further comprises a second transparent line, and the second transparent line is located closer to a first anode electrode of the first pixel circuit than the first transparent line.
Clause 5. The display device of any preceding clause, wherein the at least one first compensation line comprises:
   a metal line, and/or
   a semiconductor material line, wherein the semiconductor material line comprises a conductivity-enabled semiconductor material.
Clause 5. The display device of any preceding clause, further comprising:
   a substrate;
   a first metal layer over the substrate;
   a first planarization layer on the first metal layer;
   a second metal layer on the first planarization layer;
   a second planarization layer on the second metal layer; and
   a transparent conductive material layer on the second planarization layer,
   wherein the first extension line comprises a first transparent line disposed in the transparent conductive material layer, and
   wherein the at least one first compensation line comprises a metal line located in the second metal layer, optionally wherein the at least one first compensation line further comprises a metal line located in the first metal layer.
Clause 7. The display device of clause 6, further comprising: an active layer located under the first metal layer,
   wherein the at least one first compensation line further comprises a semiconductor material line disposed in the active layer, and
   wherein the semiconductor material line includes, in a conductive state, the same semiconductor material as a semiconductor material for forming a channel of a transistor in the display area.
Clause 8. The display device of clause 6 or 7, further comprising:
   a first buffer layer on the substrate;
   a first active layer on the first buffer layer;
   a second buffer layer on the first active layer;
   a second active layer on the second buffer layer; and
   a gate insulating layer on the second active layer,
   wherein the first metal layer is located on the gate insulating layer, and
   wherein the at least one first compensation line further comprises at least one of a first semiconductor material line resulting from conductivity-enabling of a first semiconductor material of the first active layer and a second semiconductor material line resulting from conductivity-enabling of a second semiconductor material of the second active layer, optionally wherein the first semiconductor material and the second semiconductor material are different from each other.
Clause 9. The display device of clause 7, wherein the at least one first compensation line overlaps a first anode electrode of the first pixel circuit and/or one or more other anode electrodes different from the first anode electrode.
Clause 10. The display device of any preceding clause, further comprising:
   a second light emitting element disposed in the first area;
   a second pixel circuit disposed outside the first area; and
   a second extension line electrically interconnecting the second light emitting element and the second pixel circuit, wherein the second extension line has a shorter length than the first extension line.
Clause 11. The display device of clause 10, further comprising: at least one second compensation line connected with at least a portion of the second extension line,
   wherein the at least one second compensation line has a different resistance from the at least one first compensation line,
   optionally wherein the at least one second compensation line is electrically connected in parallel with the second anode extension line.
Clause 12. The display device of any preceding clause, further comprising:
   a third anode electrode disposed outside the first area;
   a third pixel circuit disposed outside the first area; and
   a third anode extension line electrically interconnecting the third anode electrode and the third pixel circuit,
   wherein the third anode extension line has a shorter length than the first extension line, and a compensation line is not electrically connected to the third anode extension line.
Clause 12. The display device of any preceding clause, further comprising: a cathode electrode commonly disposed in the first area and outside the first area,
   wherein the cathode electrode comprises a plurality of cathode holes located in the first area.
Clause 13. The display device of any preceding clause, further comprising: a first optical electronic device overlapping the first area,
   wherein the first optical electronic device is arranged to receive light transmitted through the first area and perform a predefined operation by using the received light, and
   wherein the light received by the first optical electronic device is visible light, infrared light, or ultraviolet light.
Clause 14. The display device of any preceding clause, further comprising: a third area included in the display area,
   wherein the third area comprises two or more transmission areas and a non-transmission area,
   wherein two or more light emitting elements are disposed in the first area, and two or more light emitting elements are disposed in the non-transmission area of the third area, and
   wherein a transistor is disposed in the first area, and transistors are disposed in the third area.
Clause 15. The display device of any preceding clause, wherein the at least one first compensation line is electrically connected in parallel with the at least a portion of the first extension line.

Also described herein are the following numbered items;
Item 1. A display panel comprising:
   a display area arranged to display images, the display area including a first area arranged to transmit light;
   a first light emitting element disposed in the first area;
   a second light emitting element disposed in the first area;
   a first pixel circuit disposed outside of the first area;
   a second pixel circuit disposed outside of the first area;
   a first extension line electrically interconnecting the first light emitting element and the first pixel circuit, and
   a second extension line electrically interconnecting the second light emitting element and the second pixel circuit,
   wherein a total length of the first extension line is greater than a total length of the second extension line, and
   wherein the average resistance per unit length of the first extension line is lower than the average resistance per unit length of the second extension line.
Item 2. The display device according to item 1, wherein a total resistance of the first extension line is equal to a total resistance of the second extension line.
Item 3. The display device according to item 1 or 2, wherein a cross-sectional area of the first extension line is greater than a cross-sectional area of the second extension line.
Item 4. The display device according to item 1, 2 or 3, wherein a width of the first extension line is greater than a width of the second extension line.
Item 5. The display device of any preceding item, wherein one or more transistors are disposed outside the first area, and no transistor is disposed in the first area.
Item 6. The display device of any preceding item, further comprising: a cathode electrode commonly disposed in the first area and outside the first area in the display area,
   wherein the cathode electrode comprises a plurality of cathode holes located in the first area.
Item 7. The display device of any preceding item, further comprising: a first optical electronic device overlapping the first area,
   wherein the first optical electronic device is arranged to receive light transmitted through the first area and perform a predefined operation by using the received light, and
   wherein the light received by the first optical electronic device is visible light, infrared light, or ultraviolet light.
Item 8. The display device of any preceding item, further comprising: a third area included in the display area,
   wherein the third area comprises two or more transmission areas and a non-transmission area,
   wherein two or more light emitting elements are disposed in the first area, and two or more light emitting elements are disposed in the non-transmission area of the third area, and
      wherein a transistor is disposed in the first area, and transistors are disposed in the third area.

Also disclosed herein are the following numbered clauses:
1. A display device comprising:
   a first area included in a display area arranged to display images, the first area arranged to allow light to be transmitted;
   a normal area included in the display area and located outside of the first area;
   a second area included in the display area and located between the first area and the normal area;
   a first anode electrode of a first light emitting element disposed in the first area;
   a first pixel circuit disposed in the second area;
   a first anode extension line electrically interconnecting the first anode electrode and the first pixel circuit; and
   at least one first compensation line connected with at least a portion of the first anode extension line.
2. The display device of clause 1, wherein one or more transistors are disposed in the second area, and no transistor is disposed in the first area.
3. The display device of clause 1 or 2, wherein at least a portion of the first anode extension line is disposed in the first area, and the first anode extension line comprises a first transparent line, optionally wherein the first anode extension line further comprises a second transparent line, and the second transparent line is located closer to the first anode electrode than the first transparent line.
4. The display device of any preceding clause, wherein the at least one first compensation line comprises:
   a metal line, and/or
   a semiconductor material line, wherein the semiconductor material line comprises a conductivity-enabled semiconductor material.
5. The display device of any preceding clause, further comprising:
   a substrate;
   a first metal layer over the substrate;
   a first planarization layer on the first metal layer;
   a second metal layer on the first planarization layer;
   a second planarization layer on the second metal layer; and
   a transparent conductive material layer on the second planarization layer,
   wherein the first anode extension line comprises a first transparent line disposed in the transparent conductive material layer, and
   wherein the at least one first compensation line comprises a metal line located in the second metal layer, optionally wherein the at least one first compensation line further comprises a metal line located in the first metal layer.
6. The display device of clause 5, further comprising: an active layer located under the first metal layer,
   wherein the at least one first compensation line further comprises a semiconductor material line disposed in the active layer, and
   wherein the semiconductor material line includes, in a conductive state, the same semiconductor material as a semiconductor material for forming a channel of a transistor in the display area.
7. The display device of clause 5 or 6, further comprising:
   a first buffer layer on the substrate;
   a first active layer on the first buffer layer;
   a second buffer layer on the first active layer;
   a second active layer on the second buffer layer; and
   a gate insulating layer on the second active layer,
   wherein the first metal layer is located on the gate insulating layer, and
   wherein the at least one first compensation line further comprises at least one of a first semiconductor material line resulting from conductivity-enabling of a first semiconductor material of the first active layer and a second semiconductor material line resulting from conductivity-enabling of a second semiconductor material of the second active layer, optionally wherein the first semiconductor material and the second semiconductor material are different from each other.
8. The display device of clause 6, wherein the at least one first compensation line overlaps the first anode electrode and/or one or more other anode electrodes different from the first anode electrode.
9. The display device of any preceding clause, further comprising:
   a second anode electrode disposed in the first area;
   a second pixel circuit disposed in the second area; and
   a second anode extension line electrically interconnecting the second anode electrode and the second pixel circuit,
   wherein the second anode extension line has a shorter length than the first anode extension line.
10. The display device of clause 9, further comprising: at least one second compensation line connected with at least a portion of the second anode extension line,
   wherein the at least one second compensation line has a different resistance from the at least one first compensation line,
   optionally wherein the at least one second compensation line is electrically connected in parallel with the second anode extension line.
11. The display device of any preceding clause, further comprising:
   a third anode electrode disposed in the second area;
   a third pixel circuit disposed in the second area; and
   a third anode extension line electrically interconnecting the third anode electrode and the third pixel circuit,
   wherein the third anode extension line has a shorter length than the first anode extension line,
   optionally wherein a compensation line is not electrically connected in parallel to the third anode extension line.
12. The display device of any preceding clause, further comprising: a cathode electrode commonly disposed in the normal area, the second area, and the first area,
   wherein the cathode electrode comprises a plurality of cathode holes located in the first area.
13. The display device of any preceding clause, further comprising: a first optical electronic device overlapping the first area,
   wherein the first optical electronic device is arranged to receive light transmitted through the first area and perform a predefined operation by using the received light, and
   wherein the light received by the first optical electronic device is visible light, infrared light, or ultraviolet light.
14. The display device of any preceding clause, further comprising: a third area included in the display area,
   wherein the third area comprises two or more transmission areas and a non-transmission area,
   wherein two or more light emitting elements are disposed in the first area, and two or more light emitting elements are disposed in the non-transmission area of the third area, and
   wherein a transistor is disposed in the first area, and transistors are disposed in the third area.
15. The display device of any preceding clause, wherein the at least one first compensation line is electrically connected in parallel with the first anode extension line.

## Claims

1. A display device (100) comprising:
a first area (OA1) included in a display area (DA) arranged to display images, the first area (OA1) arranged to allow light to be transmitted;
a second area (OBA1) included in the display area (DA) and located outside of the first area (OA1);
a first anode electrode (AE1) of a first light emitting element (ED) disposed in the first area (OA1);
a first pixel circuit (SPC1) disposed in the second area (OBA1);
a first anode extension line (AEL1) electrically interconnecting the first anode electrode (AE1) and the first pixel circuit (SPC1); and
at least one first compensation line (AUX1) connected with at least a portion of the first anode extension line (AEL) through at least two contact holes (CNT).

2. The display device (100) of claim 1, wherein at least a portion of the first anode extension line (AEL) is disposed in the first area (OA1), and the first anode extension line (AEL1) comprises a first transparent line (TL1), optionally wherein the first anode extension line (AEL1) further comprises a second transparent line (TL2), and the second transparent line (TL2) is located closer to the first anode electrode (AE1) than the first transparent line (TL1).

3. The display device (100) of any preceding claim, wherein the at least one first compensation line (AUX1) comprises:
a metal line, and/or
a semiconductor material line, wherein the semiconductor material line comprises a conductivity-enabled semiconductor material.

4. The display device (100) of any preceding claim, further comprising:
a substrate (SUB);
a first metal layer (1730) over the substrate (SUB);
a first planarization layer (PLN1) on the first metal layer (1730);
a second metal layer (1740) on the first planarization layer (PLN2);
a second planarization layer (PLN2) on the second metal layer (1740); and
a transparent conductive material layer (1750) on the second planarization layer (PLN2),
wherein the first anode extension line (AEL) comprises a first transparent line disposed in the transparent conductive material layer (1750), and
wherein the at least one first compensation line (AUX1) comprises a metal line located in the second metal layer (1740), optionally wherein the at least one first compensation line further (AUX1) comprises a metal line located in the first metal layer (1730).

5. The display device (100) of claim 4, further comprising: an active layer (1710) located under the first metal layer (1730),
wherein the at least one first compensation line (AUX1) further comprises a semiconductor material line disposed in the active layer (1710), and
wherein the semiconductor material line includes, in a conductive state, the same semiconductor material as a semiconductor material for forming a channel of a transistor in the display area (DA).

6. The display device (100) of claim 4 or 5, further comprising:
a first buffer layer (BUF1) on the substrate (SUB);
a first active layer (1710) on the first buffer layer (BUF1);
a second buffer layer (BUF2) on the first active layer (1710);
a second active layer (1720) on the second buffer layer (BUF2); and
a gate insulating layer (GI2) on the second active layer (1720),
wherein the first metal layer (1730) is located on the gate insulating layer (GI2), and
wherein the at least one first compensation line (AUX1) further comprises at least one of a first semiconductor material line resulting from conductivity-enabling of a first semiconductor material of the first active layer (1710) and a second semiconductor material line resulting from conductivity-enabling of a second semiconductor material of the second active layer (1720), optionally wherein the first semiconductor material and the second semiconductor material are different from each other.

7. The display device (100) of claim 5, wherein the at least one first compensation line (AUX1) overlaps the first anode electrode (AE1) and/or one or more other anode electrodes different from the first anode electrode (AE1).

8. The display device (100) of any preceding claim, further comprising:
a second anode electrode (AE2) disposed in the first area (OA1);
a second pixel circuit (SPC2) disposed in the second area (OBA1); and
a second anode extension line (AEL2) electrically interconnecting the second anode electrode (AE2) and the second pixel circuit (SPC2),
wherein the second anode extension line (AEL2) has a shorter length than the first anode extension line (AEL1).

9. The display device (100) of claim 8, further comprising: at least one second compensation line (AUX2) connected with at least a portion of the second anode extension line (AEL2),
wherein the at least one second compensation line (AUX2) has a different resistance from the at least one first compensation line (AUX),
optionally wherein the at least one second compensation line (AUX2) is electrically connected in parallel with the second anode extension line (AEL2).

10. The display device of any preceding claim, further comprising:
a third anode electrode (AE3) disposed in the second area (OBA1);
a third pixel circuit (SPC3) disposed in the second area (OBA1); and
a third anode extension line (AEL3) electrically interconnecting the third anode electrode (AE3) and the third pixel circuit (SPC3),
wherein the third anode extension line (AEL3) has a shorter length than the first anode extension line (AEL1),
optionally wherein a compensation line is not electrically connected in parallel to the third anode extension line (AEL3).

11. The display device (100) of any preceding claim, further comprising: a cathode electrode (CE) commonly disposed in the second area (OBA1), and the first area (OA1),
wherein the cathode electrode (CE) comprises a plurality of cathode holes (CH) located in the first area (OA1).

12. The display device (100) of any preceding claim, further comprising: a first optical electronic device (11) overlapping the first area (OA1),
wherein the first optical electronic device is (11) arranged to receive light transmitted through the first area (OA1) and perform a predefined operation by using the received light, and
wherein the light received by the first optical electronic device (11) is visible light, infrared light, or ultraviolet light.

13. The display device (100) of any preceding claim, further comprising: a third area (OA2) included in the display area (DA),
wherein the third area (OA2) comprises two or more transmission areas (TA) and a non-transmission area (NTA),
wherein two or more light emitting elements (ED) are disposed in the first area (OA1), and two or more light emitting elements (ED) are disposed in the non-transmission area (NTA) of the third area (OA2), and
wherein transistors (DT, ST) are disposed in the third area (OA2).

14. The display device (100) of any preceding claim#, further comprising:
a second anode electrode (AE2) of a second light emitting element (ED2) disposed in the first area (OA1);
a second pixel circuit (SPC2) disposed in the second area;
a second anode extension line (AEL2) electrically interconnecting the second anode electrode and the second pixel circuit; and
at least one second compensation line (AUX2) connected with at least a portion of the second anode extension line (AEL2),
wherein the second anode extension line (AEL2) has a shorter length than the first anode extension line; and
wherein the at least one second compensation line having a different resistance from the at least one first compensation line.

15. The display device (100) of any preceding claim, wherein the at least one first compensation line (AUX) includes a first metal line (MTL1) and a second metal line (MTL2) having different lengths or widths.
